(19) Europäisches Patentamt
European Patent Office
Office européen des brevets

(11) EP 4 350 794 A1

(12) **EUROPEAN PATENT APPLICATION**
published in accordance with Art. 153(4) EPC

(43) Date of publication:
**10.04.2024 Bulletin 2024/15**

(21) Application number: **22811205.8**

(22) Date of filing: **17.05.2022**

(51) International Patent Classification (IPC):
***H01L 51/50*** *(2006.01)* ***C07D 213/16*** *(2006.01)*
***C07D 221/10*** *(2006.01)* ***C07D 221/18*** *(2006.01)*
***C09K 11/06*** *(2006.01)* ***G02B 5/20*** *(2006.01)*
***G02B 5/22*** *(2006.01)* ***G09F 9/30*** *(2006.01)*
***H01L 27/32*** *(2006.01)* ***H05B 33/02*** *(2006.01)*
***H05B 33/12*** *(2006.01)*

(52) Cooperative Patent Classification (CPC):
**C07D 213/16; C07D 221/10; C07D 221/18; C09K 11/06; G02B 5/20; G02B 5/22; G09F 9/30; H05B 33/02; H05B 33/12; H10K 50/00; H10K 59/00;** Y02E 10/549

(86) International application number:
**PCT/JP2022/020561**

(87) International publication number:
**WO 2022/249932 (01.12.2022 Gazette 2022/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.05.2021 JP 2021086666**

(71) Applicant: **CANON KABUSHIKI KAISHA**
**Tokyo 146-8501 (JP)**

(72) Inventors:
- **NISHIDE, Yosuke**
  **Tokyo 146-8501 (JP)**
- **KAMATANI, Jun**
  **Tokyo 146-8501 (JP)**
- **YAMADA, Naoki**
  **Tokyo 146-8501 (JP)**
- **IWAWAKI, Hironobu**
  **Tokyo 146-8501 (JP)**
- **MIYASHITA, Hirokazu**
  **Tokyo 146-8501 (JP)**

(74) Representative: **TBK**
**Bavariaring 4-6**
**80336 München (DE)**

# (54) ORGANIC LIGHT EMITTING ELEMENT, ORGANIC COMPOUND, DISPLAY DEVICE, PHOTOELECTRIC CONVERSION DEVICE, ELECTRONIC DEVICE, LIGHTING DEVICE, MOVING BODY AND EXPOSURE LIGHT SOURCE

(57) An organic light-emitting element including: a positive electrode; a negative electrode; and a light-emitting layer between the positive electrode and the negative electrode, wherein
the light-emitting layer contains a first compound represented by the following general formula [1] and a second compound represented by the following general formula [2]. In the following general formula [1], L denotes a bidentate ligand with a main backbone of naphtho[2,1-f]isoquinoline or phenanthro[2,1-f]isoquinoline.

$$IrL_mL'_n \quad [1]$$

$$(Ar_1)-(Ar_2)_p-(Ar_3)_q-(Ar_4) \quad [2]$$

EP 4 350 794 A1

# FIG. 1

| | HALF-LIFE [h] | MOLECULAR STRUCTURE | STATE OF INTERACTION |
|---|---|---|---|
| COMPARATIVE EXAMPLE 2 | 300 | 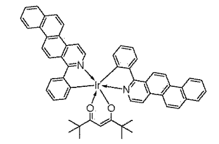 KK-28 (COMPOUND 1-a) 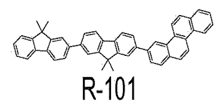 R-101 | 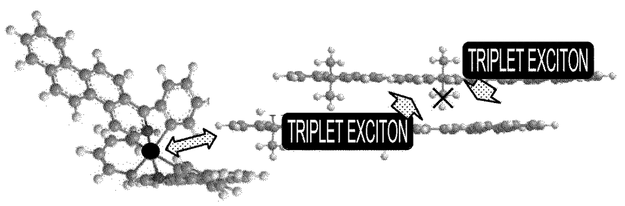 |
| COMPARATIVE EXAMPLE 3 | 300 | 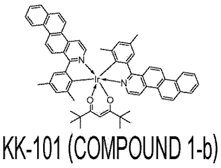 KK-101 (COMPOUND 1-b) 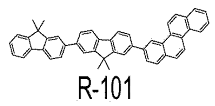 R-101 | 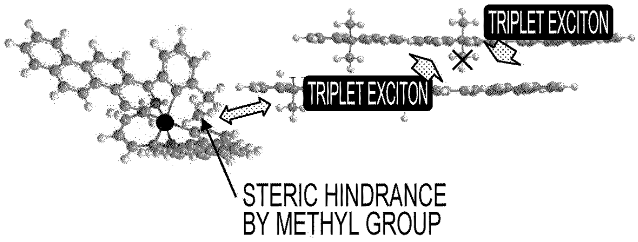 |
| COMPARATIVE EXAMPLE 4 | 700 | 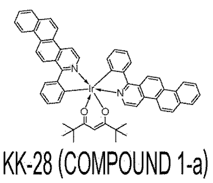 KK-28 (COMPOUND 1-a) 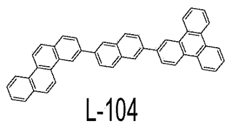 L-104 | 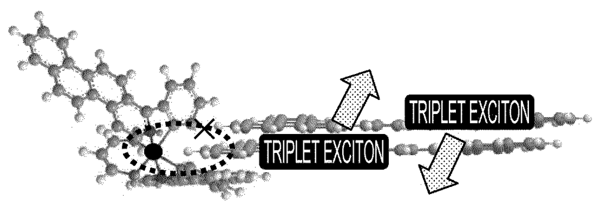 |
| EXEMPLARY EMBODIMENT 2 | 910 | 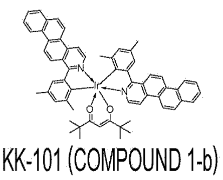 KK-101 (COMPOUND 1-b) 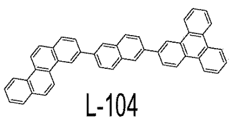 L-104 | 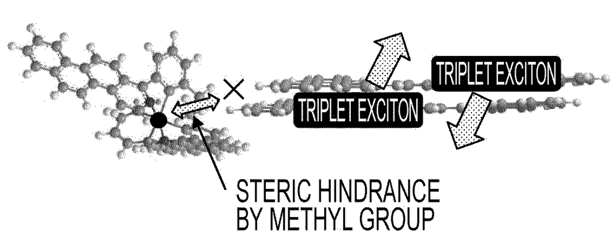 |

## Description

Technical Field

The present invention relates to an organic light-emitting element, an organic compound, a display apparatus, a photoelectric conversion apparatus, electronic equipment, a lighting apparatus, a moving body, and an exposure light source.

Background Art

An organic light-emitting element (hereinafter sometimes referred to as an "organic electroluminescent element" or an "organic EL element") is an electronic element that includes a pair of electrodes and an organic compound layer between the electrodes. Electrons and holes are injected from the pair of electrodes to generate an exciton of a light-emitting organic compound in the organic compound layer. When the exciton returns to its ground state, the organic light-emitting element emits light.

With recent significant advances in organic light-emitting elements, it is characteristically possible to realize low drive voltage, various emission wavelengths, high-speed responsivity, and thin and light light-emitting devices.

Among organic light-emitting elements, phosphorescent elements are light-emitting elements that contain a phosphorescent material in an organic compound layer constituting an organic light-emitting element and that can emit light derived from a triplet exciton thereof. By the way, there is room for further improvement in the light emission efficiency and the durability life of a phosphorescent element, and it is desired to improve the emission quantum yield of a phosphorescent material and to reduce the molecular structure degradation of a light-emitting layer host material molecule.

Patent Literature 1 to Patent Literature 3 disclose, as phosphorescent materials, the following compounds 1-a and 1-b, which are iridium complexes containing aryl-naphtho[2,1-f]isoquinoline as a ligand. Patent Literature 1 to Patent Literature 3 disclose an organic light-emitting element that contains the following compound 1-a as a guest in a light-emitting layer.

[Chem. 1]

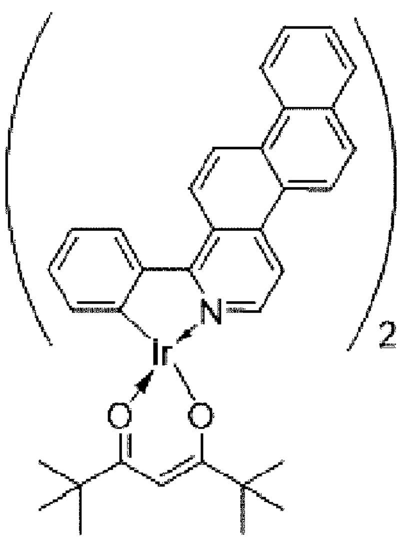

1-a

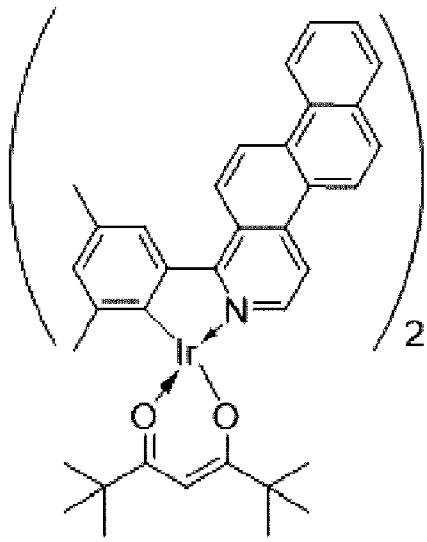

1-b

Citation List

Patent Literature

PTL 1: Japanese Patent Laid-Open No. 2014-141425
PTL 2: Japanese Patent Laid-Open No. 2014-154615
PTL 3: Japanese Patent Laid-Open No. 2014-154614

## Summary of Invention

### Technical Problem

Patent Literature 1 to Patent Literature 3 disclose the organic light-emitting element containing the compound 1-a in the light-emitting layer, but the organic light-emitting element still has problems with operational durability.

### Solution to Problem

The present invention is made to solve these problems and aims to provide an organic light-emitting element with high operational durability.

An organic light-emitting element according to one aspect of the present invention is an organic light-emitting element including: a positive electrode; a negative electrode; and a light-emitting layer between the positive electrode and the negative electrode, wherein

the light-emitting layer contains a first compound represented by the following general formula [1] and a second compound represented by the following general formula [2] .

[Chem. 2]

$$Ir\,L_m\,L'_n \qquad [1]$$

[Chem. 3]

$$(Ar_1)-(Ar_2)_p-(Ar_3)_q-(Ar_4) \qquad [2]$$

(In the general formula [1], Ir denotes iridium. L and L' denote different bidentate ligands. m is any one of 1 to 3, n is any one of 0 to 2, and m + n = 3. The partial structure $Ir(L)_m$ is a partial structure represented by the following general formula [1-1] or [1-2], and L' denotes a bidentate ligand represented by the following general formula [1-3] or [1-4]:

[Chem. 4]

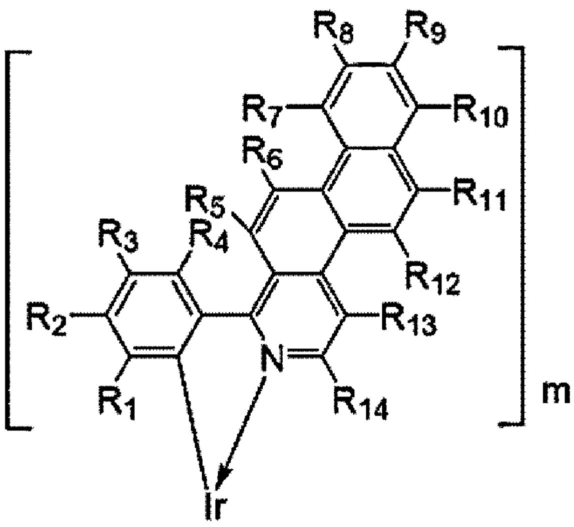

[1-1]

[Chem. 5]

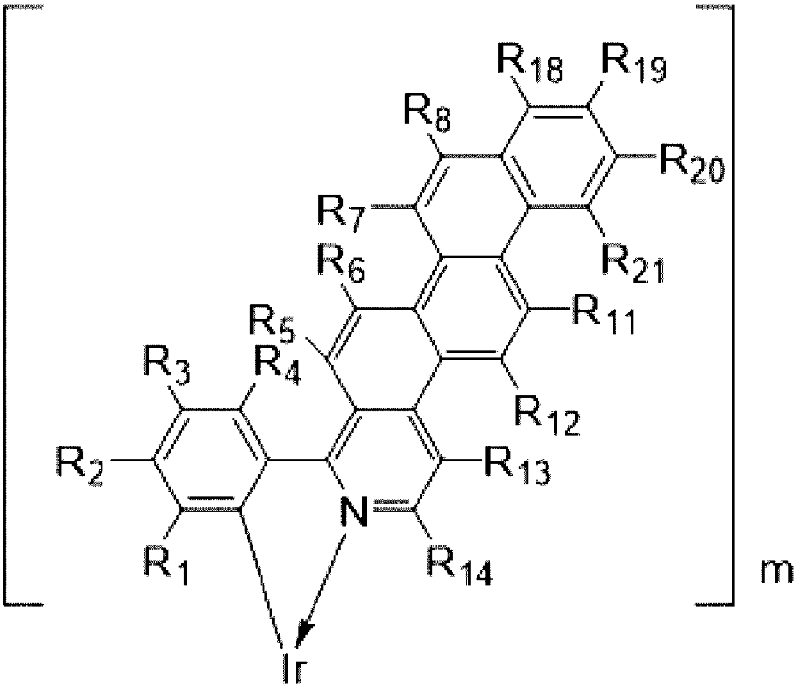

[1-2]

[Chem. 6]

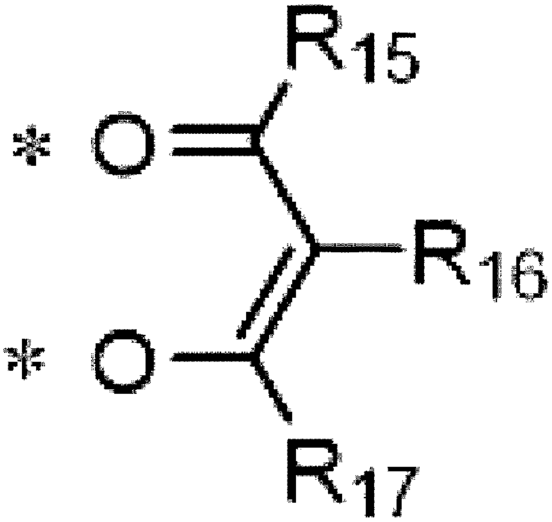

[1-3]

[Chem. 7]

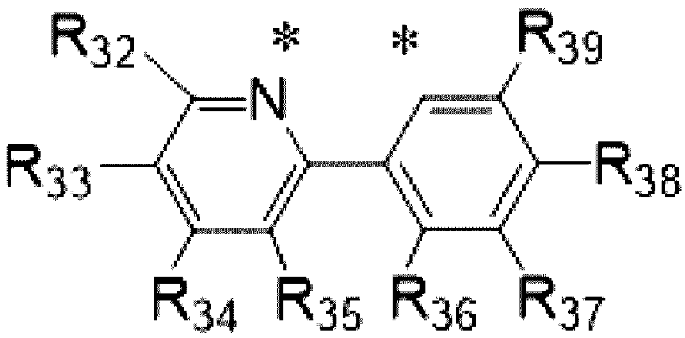

[1-4]

(In the general formula [1-1], $R_1$ denotes any one of a fluorine atom, an alkyl group, a deuterium-substituted alkyl group, an alkoxy group, a silyl group, an aryl group, and a heterocyclic group. In the general formulae [1-1] and [1-2], $R_2$ to $R_{14}$ and $R_{18}$ to $R_{21}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group. Adjacent $R_1$ to $R_4$ may form a ring. In the general formula [1-3], $R_{15}$ to $R_{17}$ are each independently selected from a hydrogen atom, a deuterium atom, a substituted or unsubstituted alkyl group, a deuterium-substituted alkyl group, an alkoxy group, a substituted amino group, a substituted or unsubstituted aryl group, and a substituted or unsubstituted heterocyclic group. In the general formula [1-4], $R_{32}$ to $R_{39}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group. Adjacent $R_{32}$ to $R_{39}$ may form a ring.))

(In the general formula [2], p and q are each independently any one of 0, 1, and 2 and satisfy the following relational expression:

$$0 \leq p + q \leq 4$$

In the general formula [2], $Ar_1$ to $Ar_4$ are each independently selected from benzene, naphthalene, phenanthrene, chrysene, triphenylene, picene, fluoranthene, and a compound represented by the following general formula [2-1], each of which has no alkyl group as a substituent, and at least one of $Ar_1$ to $Ar_4$ denotes any one of phenanthrene, chrysene, triphenylene, picene, fluoranthene, and a compound represented by the general formula [2-1].

[Chem. 8]

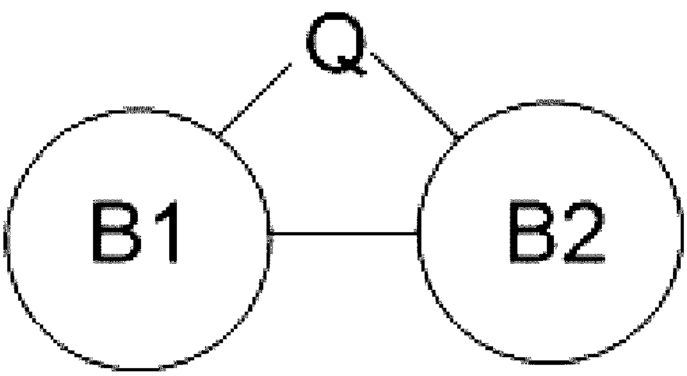

[2-1]

(In the general formula [2-1], Q denotes any one of an oxygen atom, a sulfur atom, and a nitrogen atom, a ring B1 and a ring B2 are each independently selected from a hydrocarbon aromatic ring and a heterocycle. The ring B1 and the ring B2 may have a substituent, and Q may have an aryl group or a heterocyclic group as a substituent when Q denotes a nitrogen atom. Q, the ring B1, and the ring B2 adjacent to each other may form a ring directly or via a substituent.))

## Advantageous Effects of Invention

The present invention can provide an organic light-emitting element with high operational durability.

## Brief Description of Drawings

[Fig. 1] Fig. 1 is a schematic view summarizing the structures of a guest and a host and the interaction between the guest and the host in organic light-emitting elements of exemplary embodiments and comparative examples.
[Fig. 2A] Fig. 2A is a schematic cross-sectional view of an example of a pixel of a display apparatus according to an embodiment of the present invention.
[Fig. 2B] Fig. 2B is a schematic cross-sectional view of an example of a display apparatus including an organic light-emitting element according to an embodiment of the present invention.
[Fig. 3] Fig. 3 is a schematic view of an example of a display apparatus according to an embodiment of the present invention.
[Fig. 4A] Fig. 4A is a schematic view of an example of an imaging apparatus according to an embodiment of the present invention.
[Fig. 4B] Fig. 4B is a schematic view of an example of a mobile device according to an embodiment of the present invention.
[Fig. 5A] Fig. 5A is a schematic view of an example of a display apparatus according to an embodiment of the present invention.
[Fig. 5B] Fig. 5B is a schematic view of an example of a foldable display apparatus.
[Fig. 6A] Fig. 6A is a schematic view of an example of a lighting apparatus according to an embodiment of the present invention.
[Fig. 6B] Fig. 6B is a schematic view of an automobile as an example of a moving body according to an embodiment of the present invention.
[Fig. 7A] Fig. 7A is a schematic view of an example of a wearable device according to an embodiment of the present invention.
[Fig. 7B] Fig. 7B is a schematic view of an example of a wearable device according to an embodiment of the present invention with an imaging apparatus.
[Fig. 8] Fig. 8 is a schematic view of an example of an image-forming apparatus according to an embodiment of the present invention.
[Fig. 9] Fig. 9 is a schematic view of an example of an exposure light source for an image-forming apparatus according to an embodiment of the present invention. Description of Embodiments

<<Organic Light-Emitting Element>>

First, an organic light-emitting element according to the present embodiment is described below. The organic light-emitting element according to the present embodiment includes a positive electrode, a negative electrode, and a light-emitting layer between the positive electrode and the negative electrode. The light-emitting layer contains a first compound represented by the following general formula [1] or [3]. The first compound represented by the general formula [1] or [3] is described later.
[Chem. 9]

$$Ir\ L_m\ L'_n \qquad [1]$$

In the general formula [1], Ir denotes iridium. L and L' denote different bidentate ligands. m is any one of 1 to 3, n is any one of 0 to 2, and m + n = 3. More specifically, n is 2 when m is 1, n is 1 when m is 2, and n is 0 when m is 3.
[Chem. 10]

$$Ir\ L\ L'\ L'' \qquad [3]$$

In the general formula [3], Ir denotes iridium. L, L', and L" denote different bidentate ligands.
A specific element structure of the organic light-emitting element according to the present embodiment may be a multilayer element structure including an electrode layer and an organic compound layer shown in the following (1) to (6) sequentially stacked on a substrate. In any of the element structures, the organic compound layer always includes a light-emitting layer containing a light-emitting material.

(1) Positive electrode/light-emitting layer/negative electrode
(2) Positive electrode/hole-transport layer/light-emitting layer/electron-transport layer/negative electrode
(3) Positive electrode/hole-transport layer/light-emitting layer/electron-transport layer/electron-injection layer/negative electrode
(4) Positive electrode/hole-injection layer/hole-transport layer/light-emitting layer/electron-transport layer/negative electrode
(5) Positive electrode/hole-injection layer/hole-transport layer/light-emitting layer/electron-transport layer/electron-injection layer/negative electrode
(6) Positive electrode/hole-transport layer/electron-blocking layer/light-emitting layer/hole-blocking layer/electron-transport layer/negative electrode

These element structure examples are only very basic element structures, and the element structure of an organic light-emitting element according to the present invention is not limited to these element structures. For example, an insulating layer, an adhesive layer, or an interference layer may be provided at an interface between an electrode and an organic compound layer. An electron-transport layer or a hole-transport layer may have a multilayered structure having two layers with different ionization potentials. A light-emitting layer may have a multilayered structure having two layers each containing a different light-emitting material. In addition to such structures, various other layer structures can be employed.

In the present embodiment, the mode (element form) of extracting light from a light-emitting layer may be a bottom emission mode of extracting light from an electrode on the substrate side or a top emission mode of extracting light from the side opposite to the substrate side. The mode may also be a double-sided extraction mode of extracting light from the substrate side and from the side opposite to the substrate side.

Among the element structures shown in (1) to (6), the structure (6) has both an electron-blocking layer and a hole-blocking layer and is preferred. Thus, the electron-blocking layer and the hole-blocking layer in (6) can securely confine carriers of both holes and electrons in the light-emitting layer. Thus, the organic light-emitting element has no carrier leakage and high light emission efficiency.

In the organic light-emitting element according to the present embodiment, the first compound represented by the general formula [1] or [3] is preferably contained in a light-emitting layer of the organic compound layer. The first compound represented by the general formula [1] is an iridium complex that is a type of organometallic complex.

The organic light-emitting element according to the present embodiment preferably contains, in addition to the first compound, a second compound different from the compound represented by the general formula [1] or [3] in the light-emitting layer. The use of a compound contained in the light-emitting layer depends on the concentration of the compound in the light-emitting layer. More specifically, the compound is divided into a main component and an auxiliary component depending on the concentration of the compound in the light-emitting layer.

A compound serving as a main component is a compound with the maximum weight ratio (concentration) among the compound group contained in the light-emitting layer and is also referred to as a host. The host is a compound that is present as a matrix around the light-emitting material in the light-emitting layer and that is mainly responsible for carrier transport to the light-emitting material and excitation energy supply to the light-emitting material. A host may also be referred to as a host material or a host molecule.

A compound serving as an auxiliary component is a compound other than the main component and can be referred to as a guest (dopant), a light-emitting assist material, or a charge injection material depending on the function of the compound. A guest, which is an auxiliary component, is a compound (light-emitting material) responsible for main light emission in the light-emitting layer. A guest may also be referred to as a guest material or a guest molecule. A light-emitting assist material, which is an auxiliary component, is a compound that assists the light emission of the guest and that has a lower weight ratio (concentration) than the host in the light-emitting layer. The light-emitting assist material is also referred to as a second host because of its function. In the present embodiment, the (light-emitting) assist material is preferably an iridium complex. However, the iridium complex used as the (light-emitting) assist material is an iridium complex other than the iridium complex of the general formula [1]. In other words, the organic light-emitting element according to the present embodiment may have the first compound represented by the general formula [1] or [3] and a second compound and a third compound each different from the compound represented by the general formula [1] or [3]. Furthermore, the third compound may be an iridium complex different from the compound represented by the general formula [1] or [3].

The concentration of the guest is 0.01% by weight or more and 50% by weight or less, preferably 0.1% by weight or more and 20% by weight or less, of the total amount of the constituent materials of a light-emitting layer. The concentration of the guest is particularly preferably 10% by weight or less to prevent concentration quenching.

In the present embodiment, the guest may be uniformly contained or may have a concentration gradient throughout a layer in which the host serves as a matrix. Alternatively, the guest may be partially contained in a specific region in the layer, and a light-emitting layer may have a region containing only the host and no guest.

In the present embodiment, the light-emitting layer preferably contains the first compound represented by the general formula [1] or [3] as a guest and the second compound different from the compound represented by the general formula [1] or [3] as a host. To assist the transfer of an exciton or a carrier, the light-emitting layer may further contain another phosphorescent material in addition to the iridium complex represented by the general formula [1]. In other words, the organic light-emitting element according to the present embodiment may have the first compound represented by the general formula [1] or [3] and a second compound and a third compound each different from the compound represented by the general formula [1] or [3]. Furthermore, the third compound may be a phosphorescent material different from the compound represented by the general formula [1] or [3].

To assist the transfer of an exciton or a carrier, the light-emitting layer may further contain a compound (fourth compound) other than the compounds represented by the first to third compounds as a second host.

The second compound may be a compound represented by the following general formula [2]. The second compound represented by the following general formula [2] is described later. In particular, when the first compound is a compound represented by the general formula [1], the second compound is preferably a compound represented by the following general formula [2].

[Chem. 11]

$$(Ar_1)-(Ar_2)_p-(Ar_3)_q-(Ar_4) \qquad [2]$$

<<First Compound (Iridium Complex)>>

Next, the first compound, which is a constituent material of the organic light-emitting element according to the present embodiment, is described. The first compound, which is a constituent material of the organic light-emitting element according to the present embodiment, is a compound represented by the following general formula [1] or [3] and is an iridium complex. The first compound represented by the general formula [1] or [3] emits red light.

[Chem. 12]

$$Ir\,L_m\,L'_n \qquad [1]$$

[Chem. 13]

$$Ir\,L\,L'\,L'' \qquad [3]$$

The compound represented by the general formula [1] and the compound represented by the general formula [3] are described in detail below.

<Compound Represented by General Formula [1]>

[Chem. 14]

$$Ir\,L_m\,L'_n \qquad [1]$$

In the general formula [1], Ir denotes iridium. L and L' denote different bidentate ligands. m is any one of 1 to 3, n is any one of 0 to 2, and m + n = 3. The partial structure $Ir(L)_m$ is a partial structure represented by the following general formula [1-1] or [1-2], and L' denotes a bidentate ligand represented by the following general formula [1-3] or [1-4]:

[Chem. 15]

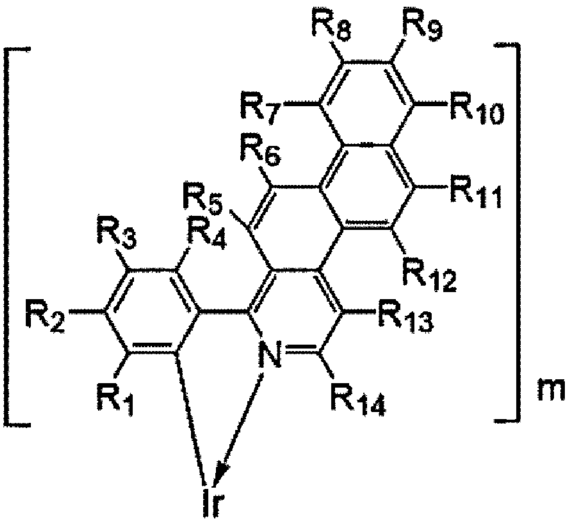

[1-1]

[Chem. 16]

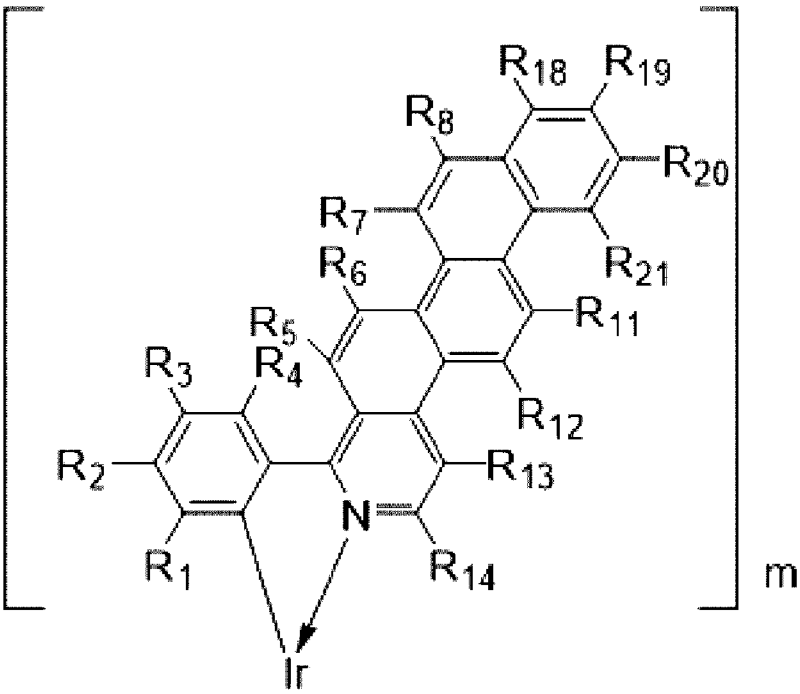

[1-2]

[Chem. 17]

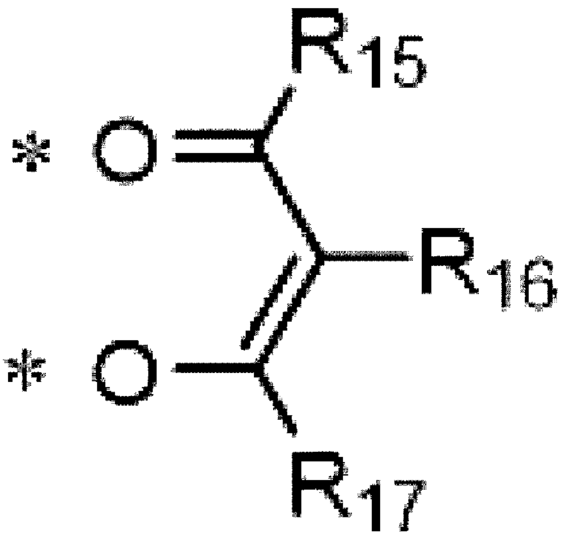

[1-3]

[Chem. 18]

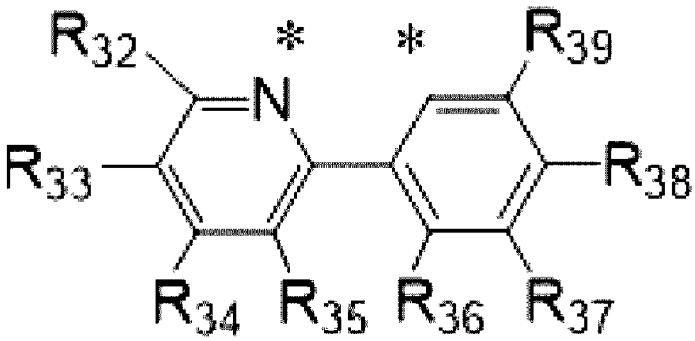

[1-4]

In the general formulae [1-1] and [1-2], $R_1$ denotes any one of a fluorine atom, an alkyl group, a deuterium-substituted alkyl group, an alkoxy group, a silyl group, an aryl group, and a heterocyclic group.

In the general formulae [1-1] and [1-2], $R_2$ to $R_{14}$ and $R_{18}$ to $R_{21}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group. Adjacent $R_1$ to $R_4$ may form a ring.

In the general formula [1-3], $R_{15}$ to $R_{17}$ are each independently selected from a hydrogen atom, a deuterium atom, a substituted or unsubstituted alkyl group, a deuterium-substituted alkyl group, an alkoxy group, a substituted amino group, a substituted or unsubstituted aryl group, and a substituted or unsubstituted heterocyclic group.

In the general formula [1-4], $R_{32}$ to $R_{39}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group. Adjacent $R_{32}$ to $R_{39}$ may form a ring.

(Ligand L)

In the general formulae [1-1] and [1-2], the alkyl group represented by $R_1$ is preferably an alkyl group with 1 or more and 4 or less carbon atoms, more preferably a methyl group. The alkyl group with 1 or more and 4 or less carbon atoms may be more specifically a methyl group, an ethyl group, a n-propyl group, an i-propyl group, a n-butyl group, an i-butyl group, a sec-butyl group, or a tert-butyl group.

In other words, the partial structure represented by the general formula [1-1] is preferably a partial structure represented by the following general formula [1-5]. In the general formula [1-5], adjacent $R_2$ to $R_4$ may form a ring.

[Chem. 19]

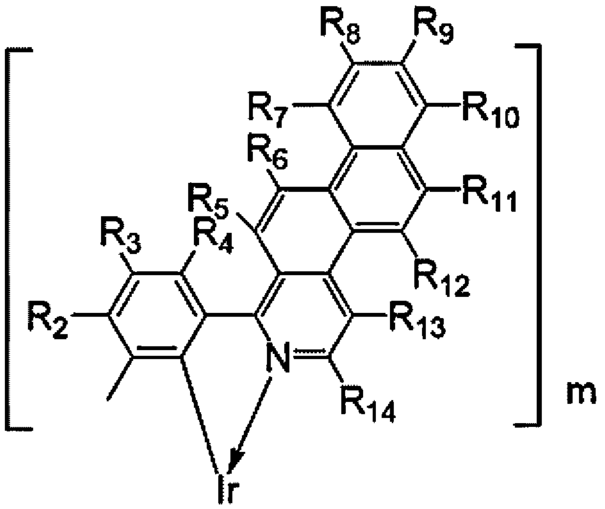

[1-5]

The alkyl groups represented by $R_2$ to $R_{14}$ and $R_{18}$ to $R_{21}$ are preferably alkyl groups with 1 or more and 10 or less carbon atoms, more preferably alkyl groups with 1 or more and 6 or less carbon atoms. More specifically, the alkyl group with 1 or more and 6 or less carbon atoms may be a methyl group, an ethyl group, a n-propyl group, an i-propyl group, a n-butyl group, an i-butyl group, a sec-butyl group, a tert-butyl group, a n-pentyl group, an i-pentyl group, a tert-pentyl group, a neopentyl group, a n-hexyl group, or a cyclohexyl group. Among these, a methyl group or a tert-butyl group is more preferred.

The alkoxy group denoted by $R_1$ to $R_{14}$ and $R_{18}$ to $R_{21}$ may be more specifically a methoxy group, an ethoxy group, an i-propoxy group, a n-butoxy group, a tert-butoxy group, or the like, preferably a methoxy group.

The substituted amino group denoted by $R_2$ to $R_{14}$ and $R_{18}$ to $R_{21}$ may be more specifically an N-methylamino group, an N-ethylamino group, an N,N-dimethylamino group, an N,N-diethylamino group, an N-methyl-N-ethylamino group, an N-benzylamino group, an N-methyl-N-benzylamino group, an N,N-dibenzylamino group, an anilino group, an N,N-diphenylamino group, an N,N-dinaphthylamino group, an N,N-difluorenylamino group, an N-phenyl-N-tolylamino group, an N,N-ditolylamino group, an N-methyl-N-phenylamino group, an N,N-dianisolylamino group, an N-mesityl-N-phenylamino group, an N,N-dimesitylamino group, an N-phenyl-N-(4-tert-butylphenyl)amino group, an N-phenyl-N-(4-trifluoromethylphenyl)amino group, or the like. Among these, an N,N-dimethylamino group and an N,N-diphenylamino group are preferred.

The aryl group denoted by $R_1$ may be more specifically a phenyl group, a naphthyl group, a biphenyl group, a terphenyl group, or the like. Among these, a phenyl group is preferred.

The aryl group denoted by $R_2$ to $R_{14}$ and $R_{18}$ to $R_{21}$ may be more specifically a phenyl group, a naphthyl group, a phenanthryl group, an anthryl group, a fluorenyl group, a biphenylenyl group, an acenaphthylenyl group, a chrysenyl group, a pyrenyl group, a triphenylenyl group, a picenyl group, a fluoranthenyl group, a perylenyl group, a naphthacenyl group, a biphenyl group, a terphenyl group, or the like. Among these, a phenyl group, a naphthyl group, a fluorenyl group, or a biphenyl group are preferred, and a phenyl group is more preferred.

The heterocyclic group denoted by $R_1$ may be more specifically a thienyl group, a pyrrolyl group, a pyrazinyl group, a pyridyl group, or the like.

The heterocyclic group denoted by $R_2$ to $R_{14}$ and $R_{18}$ to $R_{21}$ may be more specifically a thienyl group, a pyrrolyl group, a pyrazinyl group, a pyridyl group, an indolyl group, a quinolyl group, an isoquinolyl group, a naphthyridinyl group, an acridinyl group, phenanthrolinyl, a carbazolyl group, a benzo[a]carbazolyl group, a benzo[b]carbazolyl group, a benzo[c]carbazolyl group, a phenazinyl group, a phenoxazinyl group, phenothiazinyl, a benzothiophenyl group, a dibenzothiophenyl group, a benzofuranyl group, a dibenzofuranyl group, an oxazolyl group, an oxadiazolyl group, or the like.

An optional substituent of the alkyl group, the aryl group, and the heterocyclic group is, for example, but not limited to, an alkyl group, such as a methyl group, an ethyl group, a n-propyl group, an i-propyl group, a n-butyl group, an i-butyl group, a sec-butyl group, a tert-butyl group, a n-pentyl group, an i-pentyl group, a tert-pentyl group, a neopentyl group, a n-hexyl group, or a cyclohexyl group; an alkoxy group, such as a methoxy group, an ethoxy group, an i-propoxy group, a n-butoxy group, or a tert-butoxy group; a substituted amino group, such as an N-methylamino group, an N-ethylamino group, an N,N-dimethylamino group, an N,N-diethylamino group, an N-methyl-N-ethylamino group, an N-benzylamino group, an N-methyl-N-benzylamino group, an N,N-dibenzylamino group, an anilino group, an N,N-diphenylamino group, an N,N-dinaphthylamino group, an N,N-difluorenylamino group, an N-phenyl-N-tolylamino group, an N,N-ditolylamino group, an N-methyl-N-phenylamino group, an N,N-dianisolylamino group, an N-mesityl-N-phenylamino

group, an N,N-dimesitylamino group, an N-phenyl-N-(4-tert-butylphenyl)amino group, or an N-phenyl-N-(4-trifluoromethylphenyl)amino group; an aryl group, such as a phenyl group, a naphthyl group, a phenanthryl group, an anthryl group, a fluorenyl group, a biphenylenyl group, an acenaphthylenyl group, a chrysenyl group, a pyrenyl group, a triphenylenyl group, a picenyl group, a fluoranthenyl group, a perylenyl group, a naphthacenyl group, a biphenyl group, or a terphenyl group; a heterocyclic group, such as a thienyl group, a pyrrolyl group, a pyrazinyl group, a pyridyl group, an indolyl group, a quinolyl group, an isoquinolyl group, a naphthyridinyl group, an acridinyl group, phenanthrolinyl, a carbazolyl group, a benzo[a]carbazolyl group, a benzo[b]carbazolyl group, a benzo[c]carbazolyl group, a phenazinyl group, a phenoxazinyl group, a phenothiazinyl group, a benzothiophenyl group, a dibenzothiophenyl group, a benzofuranyl group, a dibenzofuranyl group, an oxazolyl group, or an oxadiazolyl group; a cyano group, a trifluoromethyl group, or the like.

An optional substituent of the alkyl group, the aryl group, and the heterocyclic group is preferably a methyl group, a tert-butyl group, a methoxy group, an N,N-dimethylamino group, an N,N-diphenylamino group, a phenyl group, a naphthyl group, a fluorenyl group, or a biphenyl group. In particular, a methyl group, a tert-butyl group, or a phenyl group is preferred.

In the present embodiment, $R_2$ to $R_{14}$ and $R_{18}$ to $R_{21}$ represented by any one of the general formulae [1-1] and [1-2] are preferably substituents selected from a hydrogen atom, a fluorine atom, and an alkyl group with 1 to 10 carbon atoms. A substituent selected from a hydrogen atom, a fluorine atom, a methyl group, and a tert-butyl group is more preferred.

As described above, the iridium complex represented by the general formula [1] is an iridium complex in which at least one of the ligands constituting the complex is a ligand with a main backbone of naphtho[2,1-f]isoquinoline or phenanthro[2,1-f]isoquinoline. As a result of extensive studies, the present inventors have found that an organic light-emitting element in which a compound with a substituent other than a hydrogen atom at $R_1$ in the general formulae [1-1] and [1-2] is used in a light-emitting layer has particularly good durability characteristics as compared with the case where $R_1$ is a hydrogen atom. Furthermore, the present inventors have found that an organic light-emitting element having a light-emitting layer containing the iridium complex as a guest and a second compound described later as a host has particularly good durability characteristics.

Furthermore, as described later, it has been found that a complex having phenanthro[2,1-f]isoquinoline as a ligand has higher oscillator strength and a narrower emission spectrum than a complex having naphtho[2,1-f]isoquinoline as a ligand (Table 2). That is, it has been found that, as represented by the general formula [2-2], a complex containing a ligand with a structure in which a fused ring is expanded from a nitrogen atom coordinately bonded to an Ir atom in the direction opposite to the Ir atom has higher oscillator strength and a sharper emission spectrum than the general formula [2-1]. A narrower emission spectrum results in improved color purity and an expanded color reproduction range in the use as a display, for example. Thus, among the iridium complexes represented by the general formula [1], an iridium complex containing phenanthro[2,1-f]isoquinoline represented by the formula [2-2] as a ligand is particularly preferred from the perspective of the color purity of light emission.

(Ligand L')

Next, the ligand L' is described. As described above, the ligand L' is a monovalent bidentate ligand represented by the general formula [1-3] or [1-4]. L' is, for example, acetylacetone, phenylpyridine, picolinic acid, oxalate, salen, or the like. The ligand L' is preferably represented by the general formula [1-3].

In the general formula [1], the partial structure $Ir(L')_n$ can also be represented by the following general formula [1-3'] or [1-4']. The partial structure $Ir(L')_n$ is preferably a partial structure represented by the general formula [1-3'].

[Chem. 20]

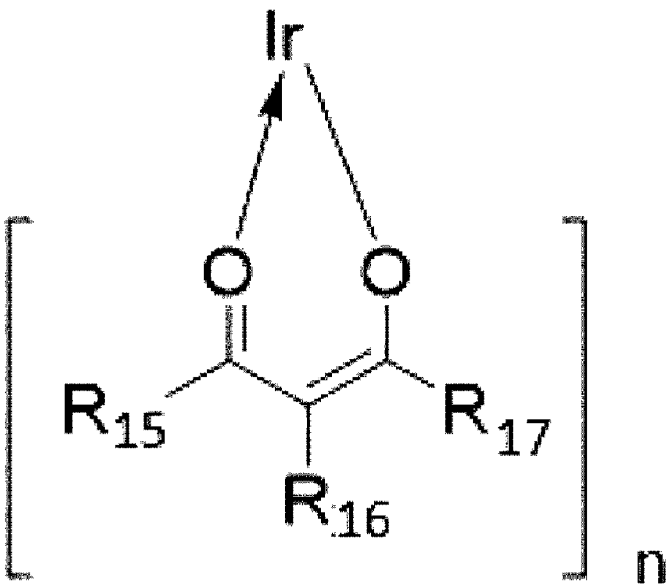

[1-3']

[Chem. 21]

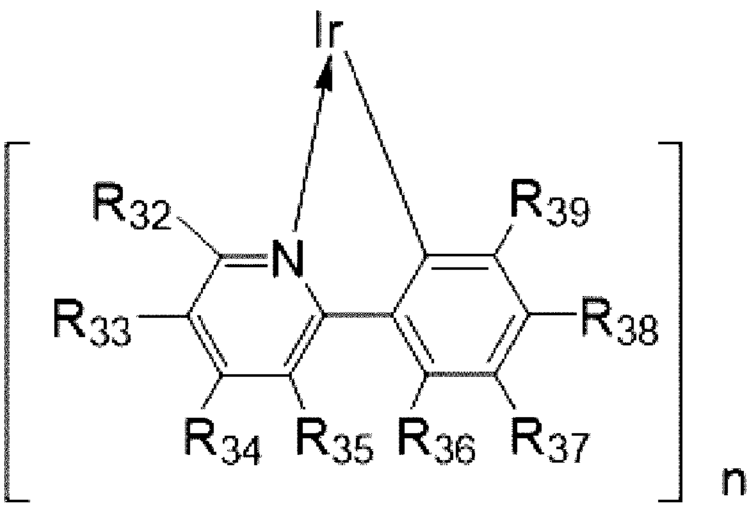

[1-4']

the general formula [1-3] or [1-3'], $R_{15}$ to $R_{17}$ are each independently selected from a hydrogen atom, a deuterium atom, an alkyl group, an alkoxy group, a substituted amino group, a substituted or unsubstituted aryl group, and a substituted or unsubstituted heterocyclic group.

In the general formula [1-4] or [1-4'], $R_{32}$ to $R_{39}$ are each independently selected from a hydrogen atom, a deuterium atom, a fluorine atom, an alkyl group, a deuterium-substituted alkyl group, an alkoxy group, a substituted amino group, a substituted or unsubstituted aryl group, and a substituted or unsubstituted heterocyclic group. Adjacent $R_{32}$ to $R_{39}$ may form a ring.

The alkyl groups represented by $R_{15}$ to $R_{17}$ or $R_{32}$ to $R_{39}$ are the same as the specific examples of the alkyl groups represented by $R_2$ to $R_{14}$ and $R_{18}$ to $R_{21}$ in the general formulae [1-1] and [1-2]. The alkyl group is preferably an alkyl group with 1 or more and 10 or less carbon atoms, more preferably an alkyl group with 1 or more and 6 or less carbon atoms, still more preferably a methyl group or a tert-butyl group.

Specific examples of the alkoxy groups represented by $R_{15}$ to $R_{17}$ or $R_{32}$ to $R_{39}$ are the same as the specific examples of the alkoxy groups represented by $R_2$ to $R_{14}$ and $R_{18}$ to $R_{21}$ in the general formulae [1-1] and [1-2]. A methoxy group is preferred.

Specific examples of the substituted amino groups represented by $R_{15}$ to $R_{17}$ or $R_{32}$ to $R_{39}$ are the same as the specific examples of the substituted amino groups represented by $R_2$ to $R_{14}$ and $R_{18}$ to $R_{21}$ in the general formulae [1-1] and [1-2]. An N,N-dimethylamino group or an N,N-diphenylamino group is preferred.

Specific examples of the aryl groups represented by $R_{15}$ to $R_{17}$ or $R_{32}$ to $R_{39}$ are the same as the specific examples of the aryl groups represented by $R_2$ to $R_{14}$ and $R_{18}$ to $R_{21}$ in the general formulae [1-1] and [1-2]. A phenyl

group, a naphthyl group, a fluorenyl group, or a biphenyl group is preferred, and a phenyl group is more preferred.

Specific examples of the heterocyclic groups represented by $R_{15}$ to $R_{17}$ or $R_{32}$ to $R_{39}$ are the same as the specific examples of the heterocyclic groups represented by $R_2$ to $R_{14}$ and $R_{18}$ to $R_{21}$ in the general formulae [1-1] and [1-2] .

When any one of $R_{15}$ to $R_{17}$ or $R_{32}$ to $R_{39}$ is an aryl group or a heterocyclic group, it may further have a substituent. The optional substituent of the aryl group and the heterocyclic group may be the same as in $R_2$ to $R_{14}$ and $R_{18}$ to $R_{21}$ in the general formulae [1-1] and [1-2].

An optional substituent of the alkyl group, the aryl group, and the heterocyclic group is, but not limited to, the same as the optional substituent of the alkyl group, the aryl group, and the heterocyclic group in the general formulae [1-1] and [1-2].

In the present embodiment, $R_{15}$ to $R_{17}$ or $R_{32}$ to $R_{39}$ represented by any one of the general formulae [1-3], [1-4], [1-3'], and [1-4'] are preferably substituents selected from a hydrogen atom and an alkyl group with 1 to 10 carbon atoms. A substituent selected from a hydrogen atom, a methyl group, and a tert-butyl group is more preferred.

<Compound Represented by General Formula [3]>

[Chem. 22]

Ir L L' L" [3]

In the general formula [3], Ir denotes iridium. L, L', and L" denote different bidentate ligands. The partial structure Ir(L) is a partial structure represented by the following general formula [3-1] or [3-2], L' denotes a bidentate ligand represented by the general formula [1-3], and L" denotes a bidentate ligand represented by the general formula [1-4].

[Chem. 23]

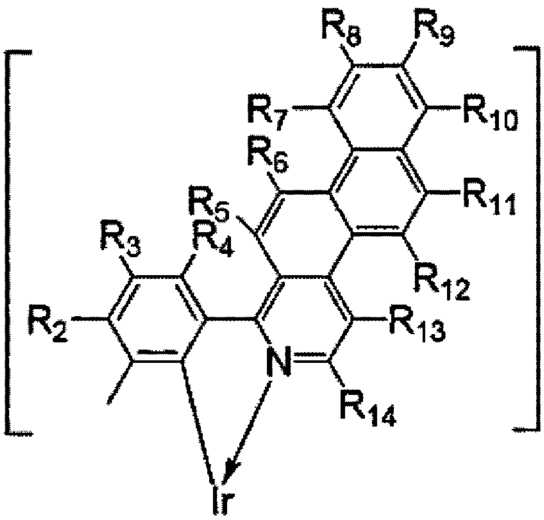

[3-1]

[Chem. 24]

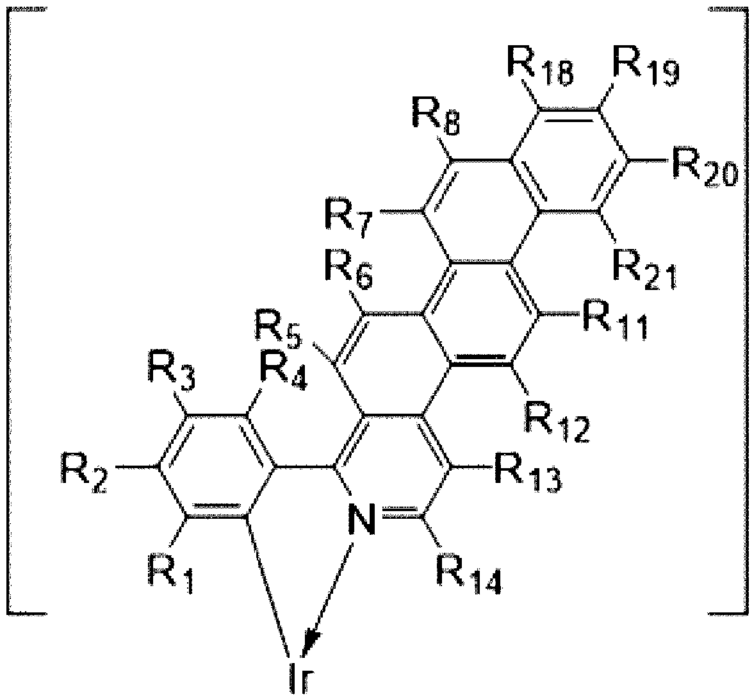

[3-2]

The substituents $R_1$ to $R_{14}$, $R_{18}$ to $R_{22}$, $R_{15}$ to $R_{27}$, and $R_{32}$ to $R_{39}$ of the ligands and partial structures in the general formula [3] are the same as those of the compound represented by the general formula [1] and are therefore not described here.

<Method for Synthesizing Iridium Complex>

Next, a method for synthesizing an iridium complex represented by the general formula [1] or [3] is described. The iridium complex represented by the general formula [1] or [3] is synthesized, for example, through the following processes (I) and (II).

(I) Synthesis of organic compound to be ligand
(II) Synthesis of organometallic complex

The processes (I) and (II) are, for example, the same as the methods described in Patent Literature 1 to Patent Literature 3.

When the iridium complex represented by the general formula [1] or [3] is used as a constituent material of an organic light-emitting element, sublimation purification is preferably performed as purification immediately before the use. The sublimation purification has a large purification effect and can therefore achieve higher purification of an organic compound. However, an organic compound with a higher molecular weight requires a higher temperature for sublimation purification and is likely to be thermally decomposed or the like due to the high temperature. Thus, an organic compound used as a constituent material of an organic light-emitting element preferably has a molecular weight of 1200 or less, more preferably 1100 or less, for sublimation purification without excessive heating.

<<Second Compound (Host Molecule)>>

Next, the second compound, which is a constituent material of the organic light-emitting element according to the present embodiment, is described. The second compound, which is a constituent material of the organic light-emitting element according to the present embodiment, is preferably a compound represented by the following general formula [2]. In the present embodiment, the second compound is preferably contained as a host in the light-emitting layer of the organic light-emitting element. In the present embodiment, the second compound is characterized by being composed of a hydrocarbon aromatic ring or heterocycle without an alkyl group.

[Chem. 25]

$$(Ar_1) - (Ar_2)_p - (Ar_3)_q - (Ar_4) \quad [2]$$

In the general formula [2], p and q are each independently any one of 0, 1, and 2 and satisfy the following relational expression:

$$0 \leq p + q \leq 4$$

In the general formula [2], $Ar_1$ to $Ar_4$ are each independently selected from benzene, naphthalene, phenanthrene, chrysene, triphenylene, picene, fluoranthene, and a compound represented by the following general formula [2-1], each of which has no alkyl group as a substituent, and at least one of $Ar_1$ to $Ar_4$ denotes any one of phenanthrene, chrysene, triphenylene, picene, fluoranthene, and a compound represented by the general formula [2-1]. $Ar_1$ to $Ar_4$ may be each independently selected from benzene, naphthalene, phenanthrene, chrysene, triphenylene, picene, and fluoranthene, each of which has no alkyl group as a substituent.

[Chem. 26]

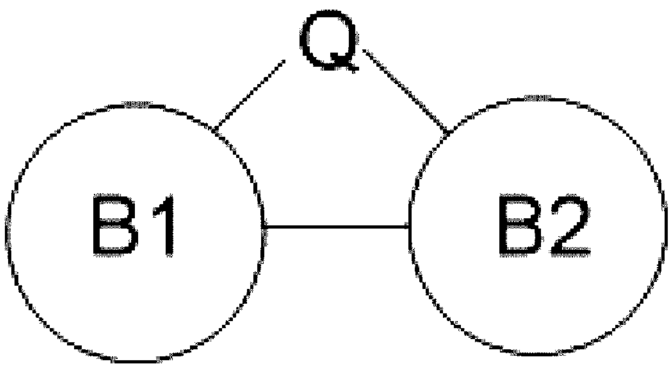


[2-1]

In the general formula [2-1], Q denotes any one of an oxygen atom, a sulfur atom, and a nitrogen atom. Q may have an aryl group or a heterocyclic group as a substituent when Q denotes a nitrogen atom.

The ring B1 and the ring B2 are each independently selected from a hydrocarbon aromatic ring and a heterocycle. The ring B1 and the ring B2 may further have a substituent. Q, the ring B1, and the ring B2 adjacent to each other may form a ring directly or indirectly via a substituent. The ring B1 and the ring B2 may be the same or different.

Specific examples of the ring B1 and the ring B2 include aromatic hydrocarbon groups, such as a phenyl group, a naphthyl group, a phenanthryl group, an acenaphthylenyl group, a chrysenyl group, a triphenylenyl group, a picenyl group, a fluoranthenyl group, a biphenyl group, and a terphenyl group; and heteroaromatic groups, such as a thienyl group, a pyrrolyl group, a pyrazinyl group, a pyridyl group, an indolyl group, a quinolyl group, an isoquinolyl group, a naphthyridinyl group, an acridinyl group, phenanthrolinyl, a carbazolyl group, a benzo[a]carbazolyl group, a benzo[b]carbazolyl group, a benzo[c]carbazolyl group, a phenazinyl group, a phenoxazinyl group, a phenothiazinyl group, a benzothiophenyl group, a dibenzothiophenyl group, a benzofuranyl group, a dibenzofuranyl group, an oxazolyl group, and an oxadiazolyl group.

A heterocycle-containing compound represented by the general formula [2-1] is preferably any one of the compounds of group A1 described below.

[Chem. 27]

[Group A1]

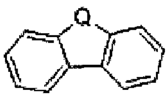
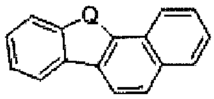
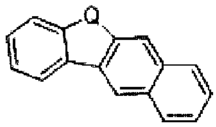
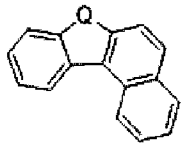

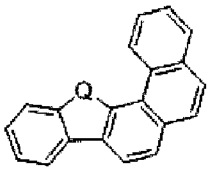
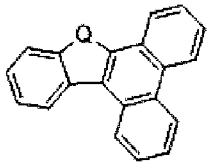
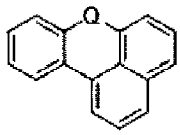
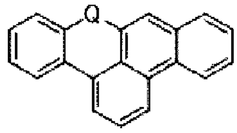

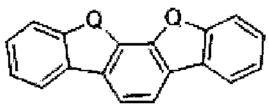
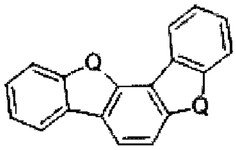
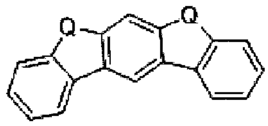

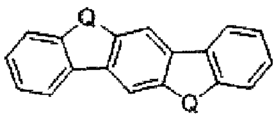
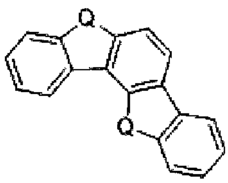
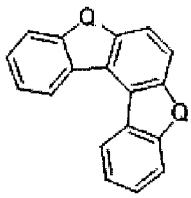

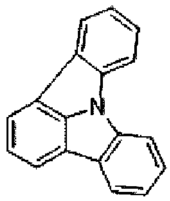
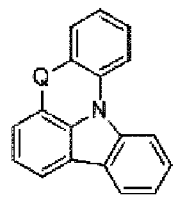
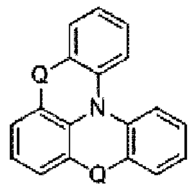

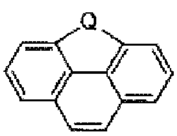
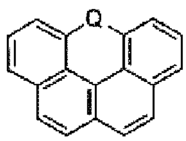

Furthermore, the second compound is particularly preferably any one of the compounds represented by the following general formulae [8] to [13].

[Chem. 28]

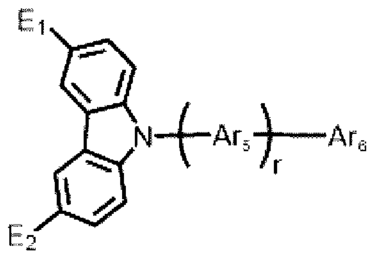

[8]

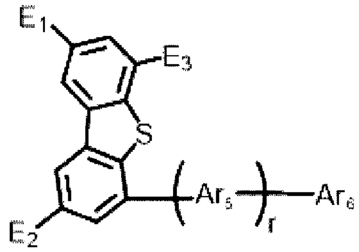

[9]

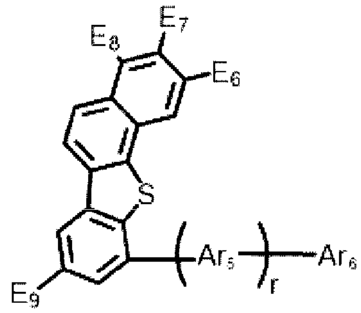

[10]

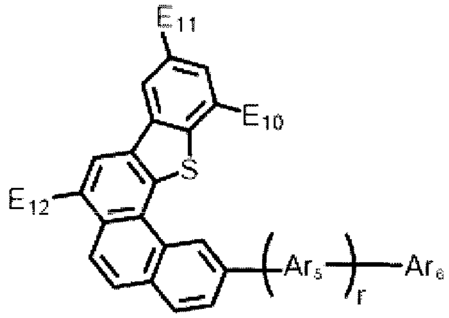

[11]

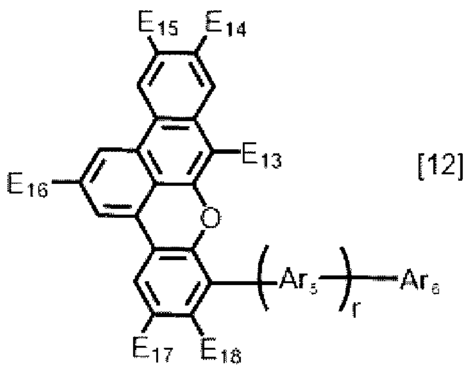

[12]

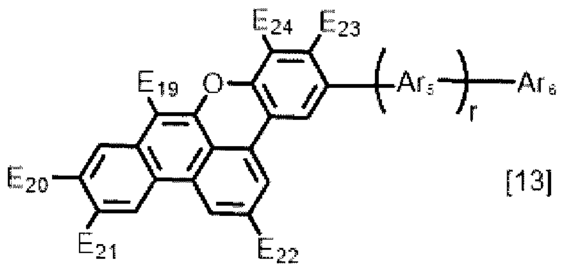

[13]

In the general formulae [8] to [13], $Ar_5$ and $Ar_6$ are each independently selected from benzene, naphthalene, phenanthrene, chrysene, triphenylene, picene, fluoranthene, and a compound represented by the general formula [2-1], each of which has no alkyl group as a substituent.

In the general formulae [8] to [13], $E_1$ to $E_{24}$ are each independently selected from a hydrogen atom and a substituted or unsubstituted aromatic hydrocarbon group. $E_1$ to $E_{24}$ have no alkyl group as a substituent. An optional substituent of the aromatic hydrocarbon groups represented by $E_1$ to $E_{24}$ may be an aromatic hydrocarbon group, such as a phenyl group, a naphthyl group, a phenanthryl group, an acenaphthylenyl group, a chrysenyl group, a triphenylenyl group, a picenyl group, a fluoranthenyl group, a biphenyl group, or a terphenyl group; a heteroaromatic group, such as a thienyl group, a pyrrolyl group, a pyrazinyl group, a pyridyl group, an indolyl group, a quinolyl group, an isoquinolyl group, a naphthyridinyl group, an acridinyl group, phenanthrolinyl, a carbazolyl group, a benzo[a]carbazolyl group, a benzo[b]carbazolyl group, a benzo[c]carbazolyl group, a phenazinyl group, a phenoxazinyl group, a phenothiazinyl group, a benzothiophenyl group, a dibenzothiophenyl group, a benzofuranyl group, a dibenzofuranyl group, an oxazolyl group, or an oxadiazolyl group; a cyano group, or the like. An optional substituent of the aromatic hydrocarbon groups represented by $E_1$ to $E_{24}$ is preferably a phenyl group, a naphthyl group, a fluorenyl group, a biphenyl group, or a terphenyl group.

In the general formulae [8] to [13], r is an integer in the range of 0 to 4. Preferably, r is 1. When r is 2 or more, a plurality of $Ar_5$s may be the same or different.

The following are possible reasons why the compounds represented by the general formulae [8] to [13] are

preferred as the second compound as described above. First, in heterocyclic compounds, it is thought that thiophene derivatives are more stable than furan derivatives among five-membered ring compounds, and xanthene derivatives are more stable than thioxanthene derivatives among six-membered ring compounds. Second, it is thought that the presence of a substituent at a chemically reactive site (an ortho or para position to an oxygen atom or a sulfur atom) in a (aromatic) heterocyclic skeleton increases the chemical stability.

Each compound used as a constituent material of the organic light-emitting element according to the present embodiment is desirably purified in advance and is preferably purified by sublimation purification. This is because the sublimation purification has a large purification effect in the purification of organic compounds. In sublimation purification, an organic compound with a higher molecular weight to be purified generally requires heating at a higher temperature, and a high temperature tends to cause the thermal decomposition or the like of the compound. Thus, an organic compound used as a constituent material of an organic light-emitting element preferably has a molecular weight of 1500 or less for sublimation purification without excessive heating. On the other hand, at a constant molecular weight, a compound with a smaller Π-conjugated plane in its molecular skeleton has a relatively smaller intermolecular interaction and is easy to sublimate, which is advantageous for sublimation purification. Conversely, a compound with a large Π-conjugated plane in its molecular skeleton has a (relatively) large intermolecular interaction and is difficult to sublimate, which is disadvantageous for sublimation purification.

On the other hand, an excessively low molecular weight results in an unstable vapor evaporation rate during vacuum evaporation. In particular, when the second compound is used as a host, this problem becomes significant.

Thus, in consideration of the molecular weight balance and the size of the Π-conjugated plane described above, p is preferably 1 in the heterocycle-containing compounds represented by the general formulae [8] to [13]. Furthermore, depending on the balance with chemical stability, all of $E_1$ to $E_{24}$ are more preferably hydrogen atoms because the molecular weight is lowered.

Among the compounds represented by the general formula [2], a compound in which the largest dihedral angle formed by adjacent two of $Ar_2$ to $Ar_4$ is 26 degrees or less is preferred. In other words, the second compound preferably has a molecular structure with high planarity. The second compound having a molecular structure with high planarity can efficiently diffuse triplet excitons in a layer containing the second compound. This can reduce exciton annihilation of triplet excitons and further improve the operational durability.

Table 1 shows the molecular structures of exemplary compounds suitable as the second compound, the largest dihedral angle (the maximum value of the dihedral angle) among the dihedral angles formed by adjacent two of $Ar_2$ to $Ar_4$ in each exemplary compound, and the operational durability ratio of an organic light-emitting element containing each exemplary compound as a host. The structure of the organic light-emitting element is the structure of Exemplary Embodiment 2 or Comparative Example 2 described later in the case of Exemplary Compound L-104, and the ratio of the half-time (half-life) of Exemplary Embodiment 2 to the half-time (half-life) of Comparative Example 2 is shown as the operational durability ratio. The other exemplary compounds and comparative compounds are similar except that the host is changed to the corresponding exemplary compound or comparative compound. The dihedral angle was calculated by molecular orbital calculation using MM2 of Chem3D.

[Table 1]

Table 1

| | Second compound | Maximum value of dihedral angle | Operational durability ratio |
|---|---|---|---|
| Exemplary compound L -1 04 | 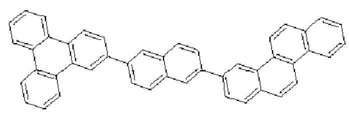 L-104 | 10 | 1.30 |
| Exemplary compound H-131 | 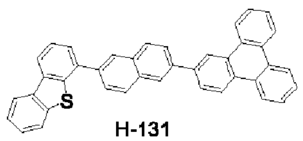 H-131 | 25° | 1.29 |

(continued)

| | Second compound | Maximum value of dihedral angle | Operational durability ratio |
|---|---|---|---|
| Exemplary compound H-424 | 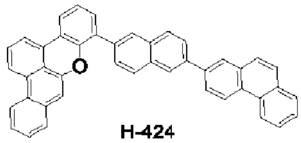 H-424 | 26° | 1.25 |
| Exemplary compound H-712 | 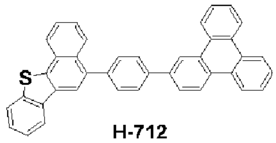 H-712 | 34° | 1.10 |
| Exemplary compound K-104 | 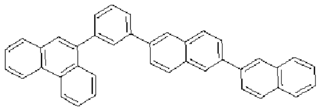 K-104 | 37° | 10.8 |
| Comparative compound R-101 | 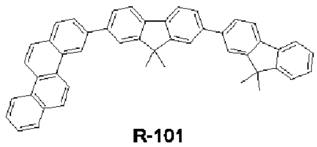 R-101 | 4° | 1.00 |

Table 1 shows that the second compound in which the maximum value of the dihedral angle is 26 degrees or less has particularly good operational durability when combined with the first compound of the present embodiment. Thus, the operational durability of the organic light-emitting element can be significantly improved by using the second compound having high planarity with the maximum value of the dihedral angle of 26 degrees or less in combination with the first compound represented by the general formula [1] in the light-emitting layer.

Comparative Compound R-101 with an alkyl group as a substituent has a small maximum value of the dihedral angle of 4 degrees but has no durability improving effect, as described later.

<<Operation and Effect of First Compound and Second Compound>>

In the organic light-emitting element according to the present embodiment, the organic compound layer (for example, the light-emitting layer) contains an iridium complex (first compound) represented by the general formula [1] or [3]. Alternatively, the organic compound layer contains an iridium complex (first compound) represented by the general formula [1] and a second compound represented by the general formula [2].

The iridium complex represented by the general formula [1] or [3] is an organometallic complex in which at least one aryl-naphtho[2,1-f]isoquinoline ligand or aryl-phenanthro[2,1-f]isoquinoline ligand is coordinated to an iridium metal. The iridium complex in the present embodiment is a red-light-emitting phosphorescent material with a high emission quantum yield. The term "red-light-emitting" as used herein refers to light emission with an emission peak wavelength in the range of 580 nm or more and 650 nm or less. Alternatively, it means that the lowest excited triplet level (T1) ranges from 1.9 eV or more and 2.1 eV or less.

As shown in an exemplary embodiment described later, an organic light-emitting element containing an iridium complex with an aryl-naphtho[2,1-f]isoquinoline ligand or an aryl-phenanthro[2,1-f]isoquinoline ligand, for example, as a guest in a light-emitting layer has very high light emission efficiency. It has also been found that $R_1$ with a substituent other than a hydrogen atom in the general formula [1-1] or [1-2] further decreases the half-width of an emission spectrum and improves the color purity.

Furthermore, as a result of extensive studies, the present inventors have found that the iridium complex represented by the general formula [1] in combination with the second compound represented by the general formula [2] in the light-emitting layer specifically improves the operational durability. This effect is described below.

A second compound as a host material suitable for use with the iridium complex of the present embodiment in the light-emitting layer was examined to more effectively use the iridium complex. The present inventors have found that the operational durability of an organic light-emitting element can be improved by designing the molecules of a host

material in consideration of the following points.

(I) The host material has no alkyl group and has a tricyclic or higher polycyclic fused-ring skeleton.
(II) The iridium complex has a steric hindrance group near an iridium atom of the ligand.

That is, the following two factors considered as luminance decay factors are suppressed: (i) exciton annihilation of triplet excitons, which results in degradation of a light-emitting layer material, and (ii) degradation of a host due to bond dissociation. This can increase the life (improve the operational durability) of the organic light-emitting element.

(I) The host material has no alkyl group and has a tricyclic or higher polycyclic fused-ring skeleton.

It is known that exciton annihilation of triplet excitons generated by recombination in a light-emitting layer of a phosphorescent element reduces the efficiency and the operational durability. This is because triplet excitons have a longer excitation lifetime than singlet excitons, exist in a light-emitting layer for an extended period, and are more likely to collide with each other.
The present inventors have found a means for reducing the probability of collision between triplet excitons. This means improves the planarity of a host molecule and reduces the intermolecular distance, thereby making it easy to diffuse triplet excitons.
Thus, a molecule having a tricyclic or higher polycyclic fused-ring structure and not substituted with a steric hindrance group, such as an alkyl group, to shorten the intermolecular distance was designed to improve the planarity. Fig. 1 is a schematic view summarizing the structures of a guest and a host and the interaction between the guest and the host in organic light-emitting elements of exemplary embodiments and comparative examples. As illustrated in Fig. 1, when the same iridium complex was used as a guest, the host without an alkyl group shown in Comparative Example 3 (Exemplary Compound L-104) had higher operational durability than the host with an alkyl group shown in Comparative Example 1 (Comparative Compound R-101). This is because the host without an alkyl group (Exemplary Compound L-104) has a shorter intermolecular distance (the distance between second compound molecules in the light-emitting layer), and triplet excitons diffuse more efficiently. This is probably because triplet excitons can diffuse efficiently and are less likely to remain in the host, collide with each other, and cause exciton annihilation.

(II) The iridium complex has a steric hindrance group near an iridium atom of the ligand.

Phenylnaphtho[2,1-f]isoquinoline and phenylphenanthro[2,1-f]isoquinoline ligand backbones have a structure in which a naphthalene ring or a phenanthrene ring is fused to quinoline, and have an enlarged Π-orbital conjugate plane. Thus, an interaction is likely to occur with another nearby molecule (in particular, a host material in the light-emitting layer). Consequently, it is thought that trapping an electric charge of another molecule, such as a host material, due to the interaction and forming a radical state or forming an exciplex with another molecule, such as a host material, tend to reduce the light emission efficiency and the operational durability.
The present inventors have searched for a complex with the ligand backbone and with a structure that has a weaker interaction with another molecule to avoid the formation of a radical state or an exciplex. As a result, it has been found that the operational durability of an organic light-emitting element can be further improved particularly by "providing a steric hindrance group near the iridium atom" among the ligands of the iridium complex.
As shown in Fig. 1, the iridium complex in Comparative Example 4 does not have a methyl group as a steric hindrance group near the iridium atom of the ligand. This reduces the distance between the iridium atom and the host. In Comparative Example 4, this tends to cause an interaction between the iridium complex and the host and form an exciplex and a radical state, and reduces the light emission efficiency and the operational durability. On the other hand, in Exemplary Embodiment 2 using the compound of the present embodiment, the ligand in the iridium complex has a methyl group as a steric hindrance near the iridium atom. This increases the distance between the iridium atom and the host. In Exemplary Embodiment 2, this can reduce an interaction between the iridium complex and the host, can reduce the formation of an exciplex and a radical state, and improves the light emission efficiency and the operational durability.
As described above, with the features (I) and (II), the present embodiment could control triplet excitons, exciplexes, and the radical state, and improve the operational durability.
A substituent $R_1$ in the general formulae [1-1] and [1-2] is preferably a methyl group. This is because an excessively large substituent $R_1$ interferes with another ligand in the molecule, distorts the structure of the complex, and lowers the thermal stability of the complex. Thus, $R_1$ is preferably a methyl group from the perspective of the thermal stability of the complex and of reducing the interaction with another molecule, such as a host material.
Furthermore, as a result of extensive studies, it has been found that $R_3$ is preferably a phenyl group in terms of a narrower emission spectrum, as shown in Table 2.
When $R_3$ is an aryl group or a heterocyclic group, however, the iridium complex may have an excessively high

molecular weight. An excessively high molecular weight may cause decomposition during sublimation. Thus, when $R_3$ is an aryl group or a heterocyclic group, a substituent to suppress intermolecular stacking is preferably introduced into any one of $R_2$ to $R_{13}$ and $R_{18}$ to $R_{21}$. This can suppress intermolecular stacking and improve sublimability. The substituent to suppress intermolecular stacking is, for example, an i-propyl group, a tert-butyl group, a fluorine group, or a fluorine-substituted alkyl group, and may be any substituent that can suppress intermolecular stacking. As shown in Table 2, Exemplary Compound K-106 substituted with a tert-butyl group and Exemplary Compound K-109 substituted with a fluorine group were not decomposed during sublimation. Furthermore, as described above, Comparative Compound 2-b substituted with a sterically bulky i-propyl group at $R_1$ is not preferred due to low thermal stability.

Furthermore, as a result of extensive studies, it has been found that the use of a phenanthro[2,1-f]isoquinoline ligand is effective in narrowing an emission spectrum without introducing a phenyl group at the $R_3$ position. In other words, it has been found that when the partial structure $Ir(L)_m$ in the general formula [1] or [3] is a partial structure represented by the general formula [1-2], the emission spectrum is further narrowed.

[Table 2]

Table 2

| | Partial structure of ligand | Spectrum narrowing effect | Thermal stability |
|---|---|---|---|
| Exemplary compound K-101 | 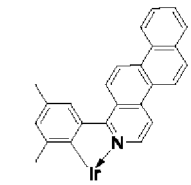 | - | ○ |
| Exemplary compound K-106 | 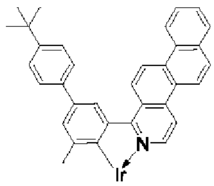 | ○ | ○ |
| Exemplary compound K-106 | 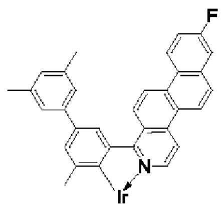 | ○ | ○ |
| Exemplary compound K-151 | 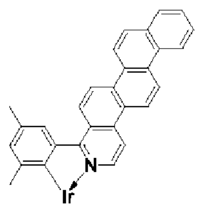 | ○ | ○ |
| Comparative compound 2-a | 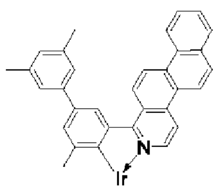 | ○ | × |

(continued)

| | Partial structure of ligand | Spectrum narrowing effect | Thermal stability |
|---|---|---|---|
| Comparative compound 2-b | 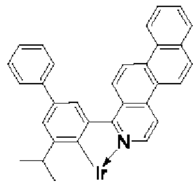 | ○ | × |

<<Specific Example of First Compound (Iridium Complex)>>

Specific examples of the first compound are shown below.

[Chem. 29]

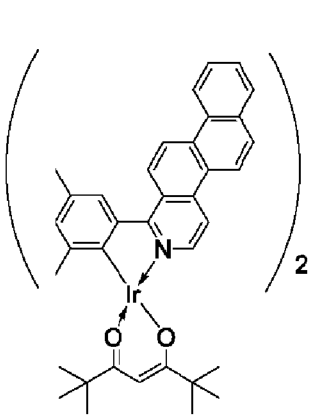

KK-101

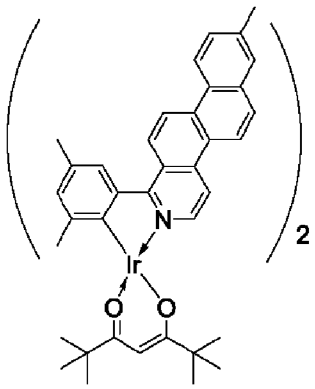

KK-102

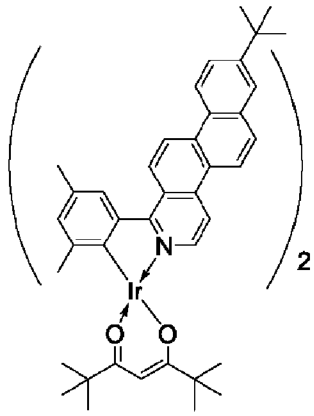

KK-103

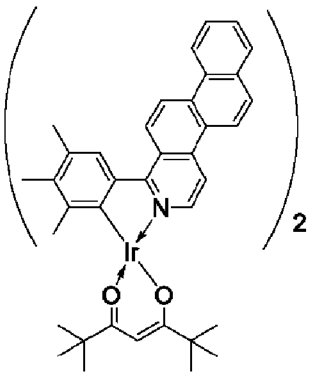

KK-104

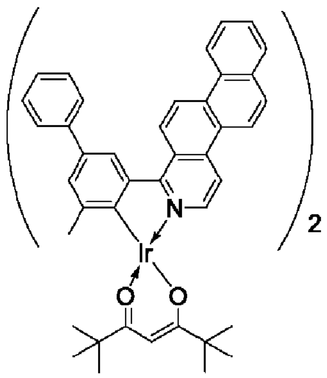

KK-105

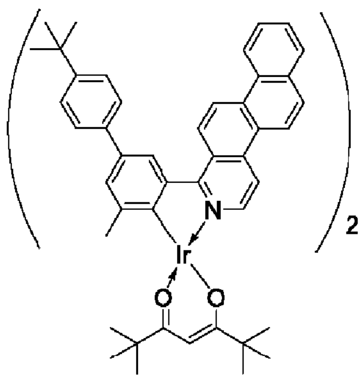

KK-106

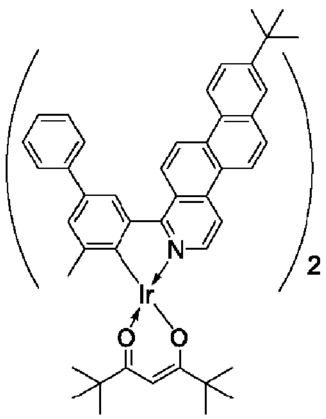

KK-107

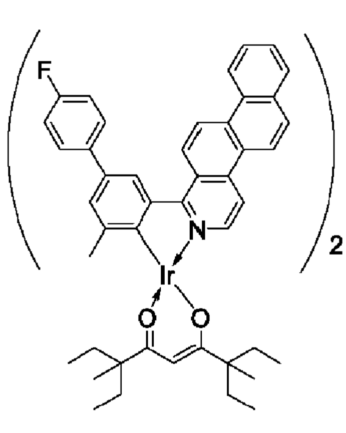

KK-108

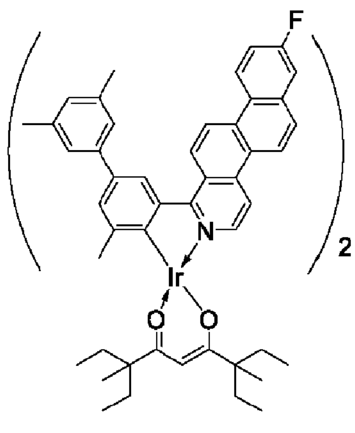

KK-109

[Chem. 30]

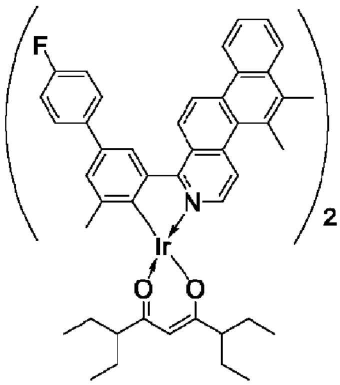

KK-110

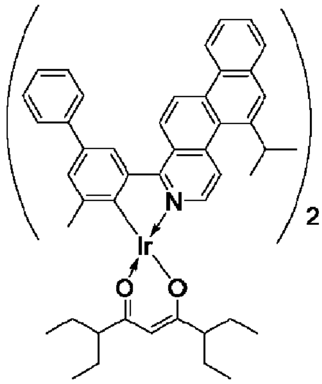

KK-111

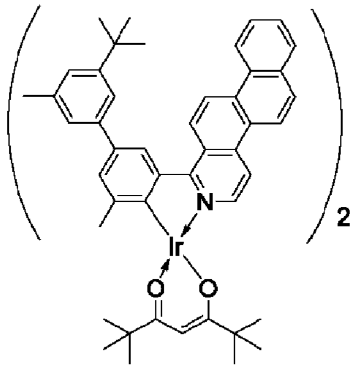

KK-112

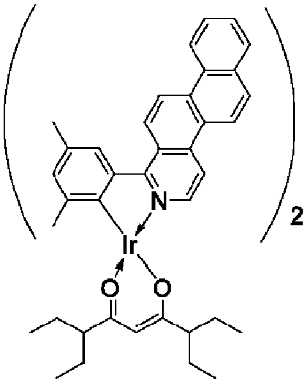

KK-113

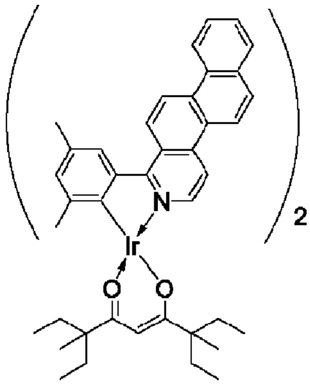

KK-114

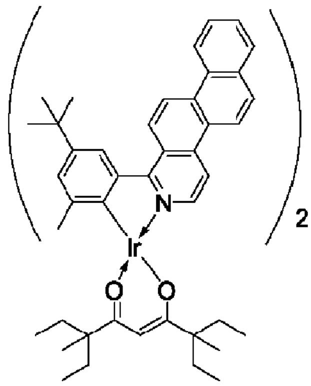

KK-115

[Chem. 31]

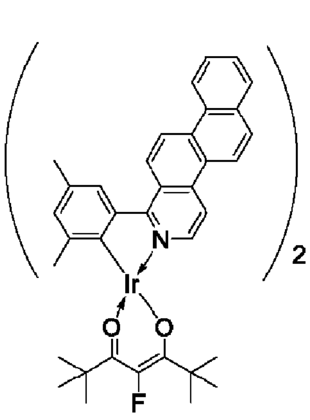

KK-116

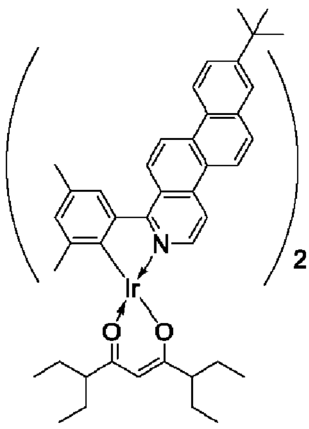

KK-117

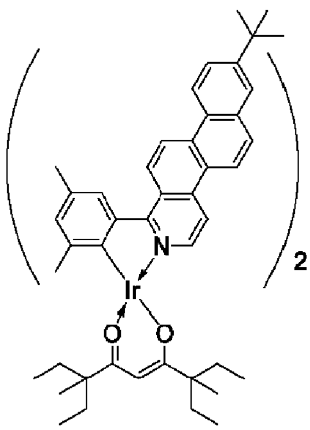

KK-118

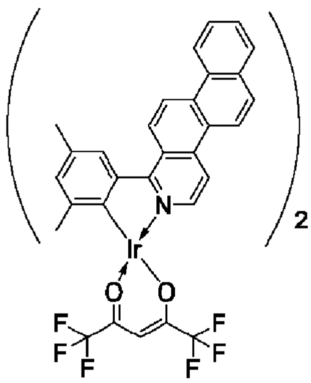

KK-119

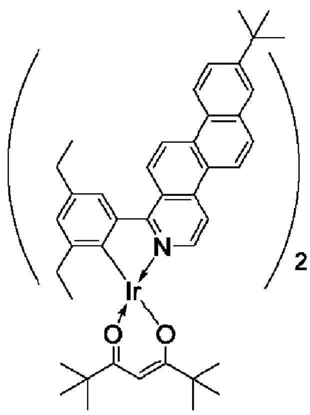

KK-120

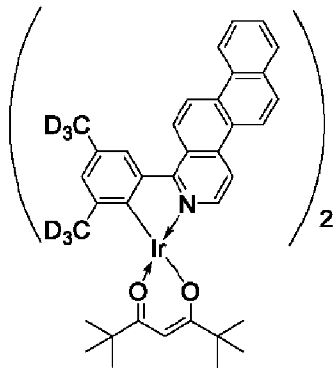

KK-121

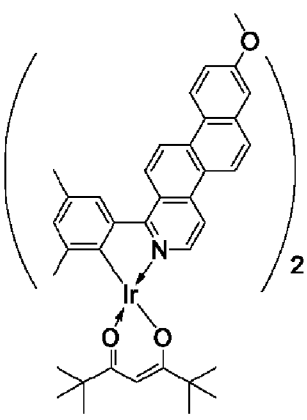

KK-122

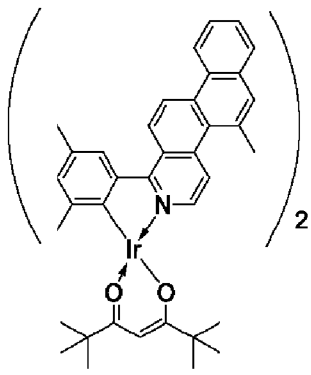

KK-123

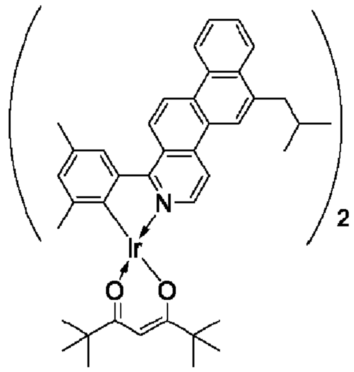

KK-124

[Chem. 32]

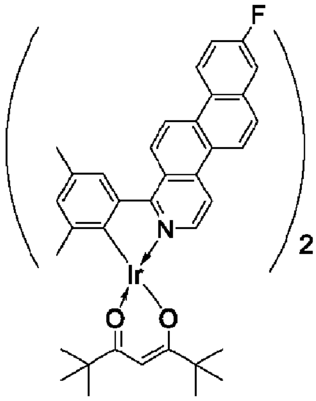

KK-125

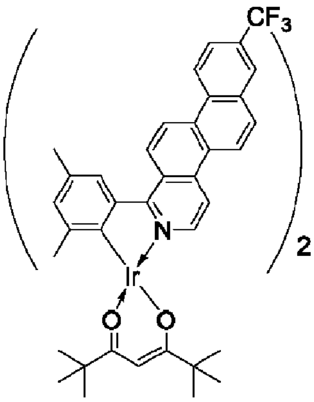

KK-126

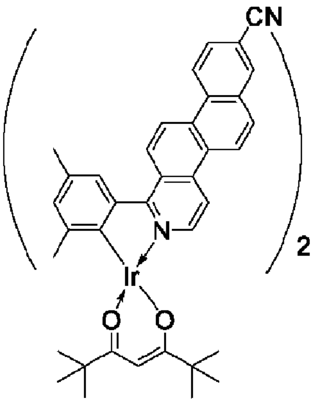

KK-127

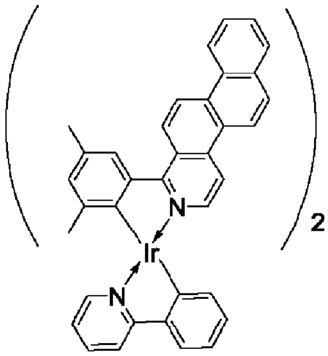

KK-128

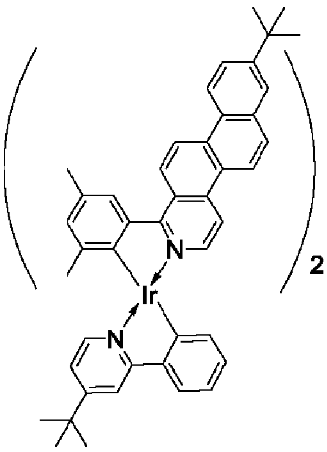

KK-129

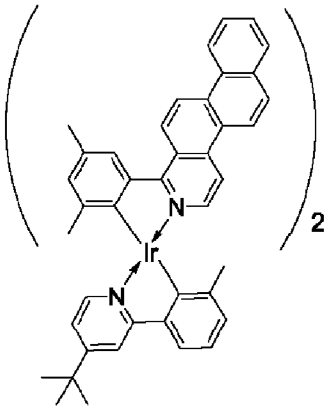

KK-130

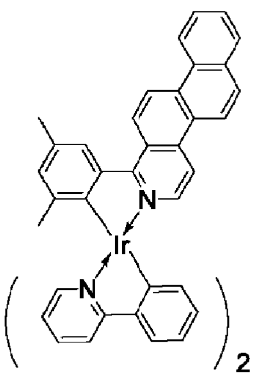

KK-131

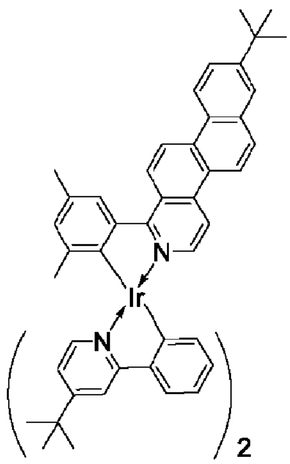

KK-132

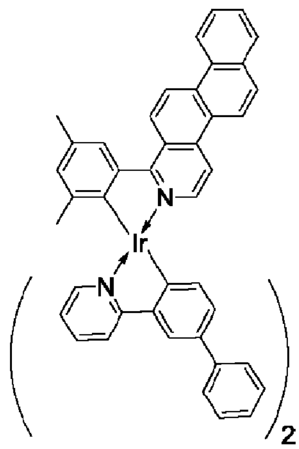

KK-133

[Chem. 33]

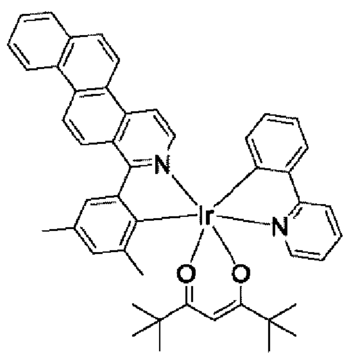

KK-134

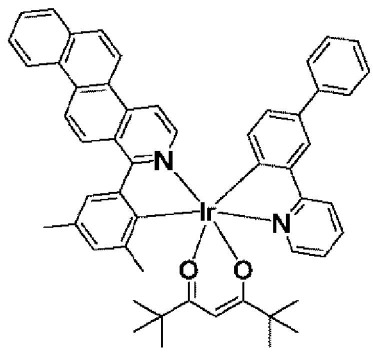

KK-135

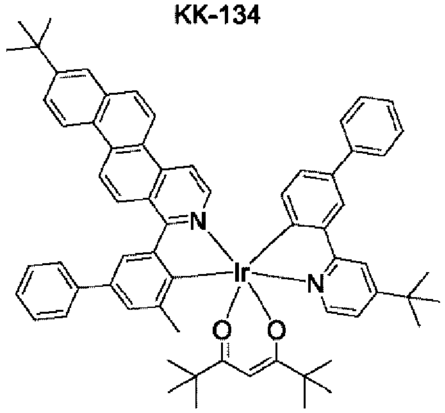

KK-136

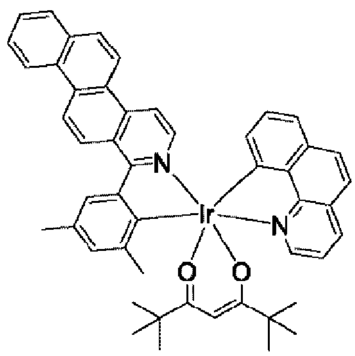

KK-137

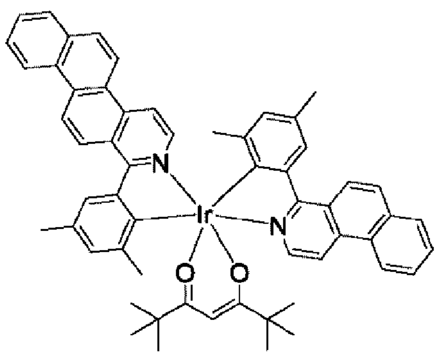

KK-138

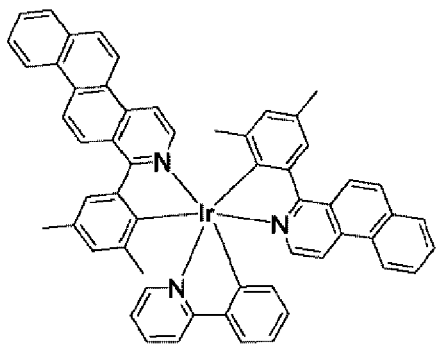

KK-139

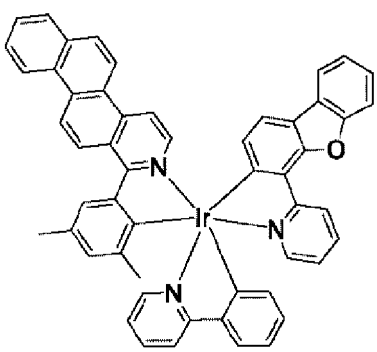

KK-140

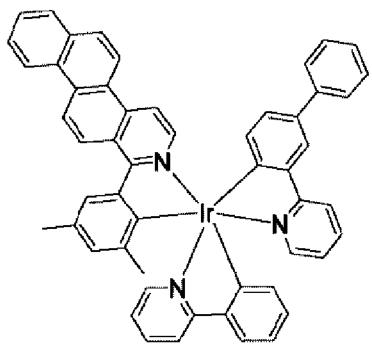

KK-141

[Chem. 34]

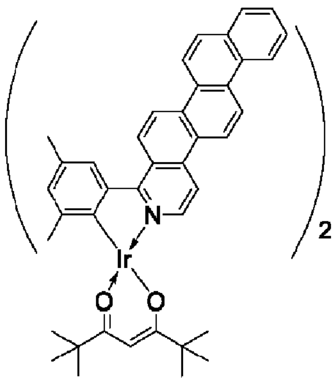

KK-151

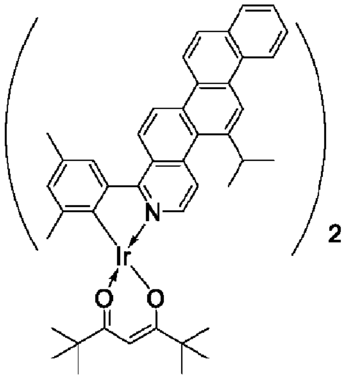

KK-152

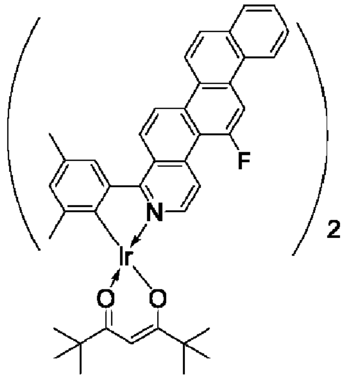

KK-153

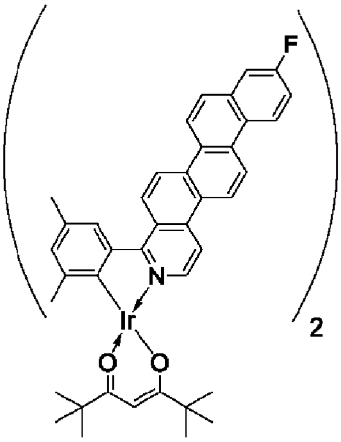

KK-154

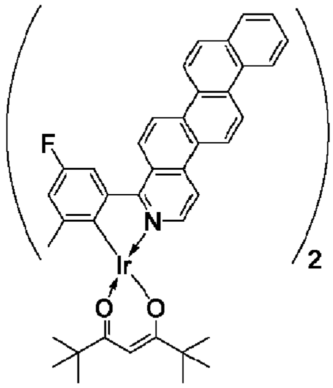

KK-155

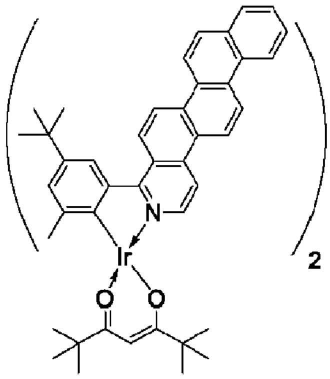

KK-156

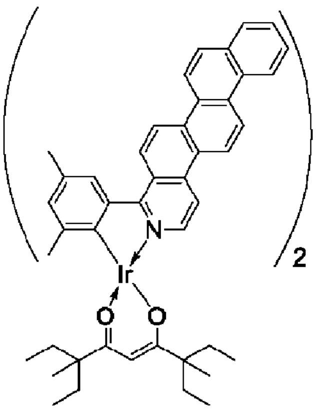

KK-157

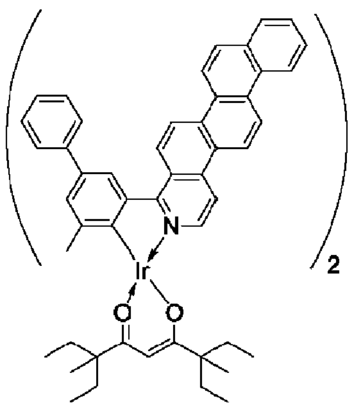

KK-158

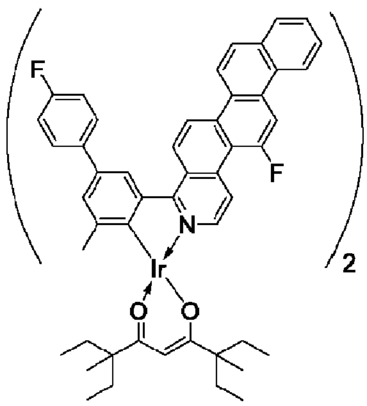

KK-159

[Chem. 35]

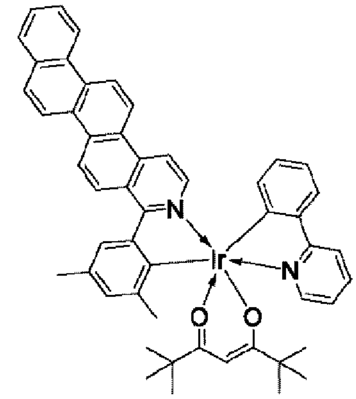

KK-160

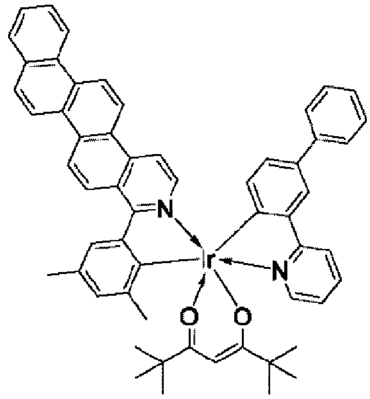

KK-161

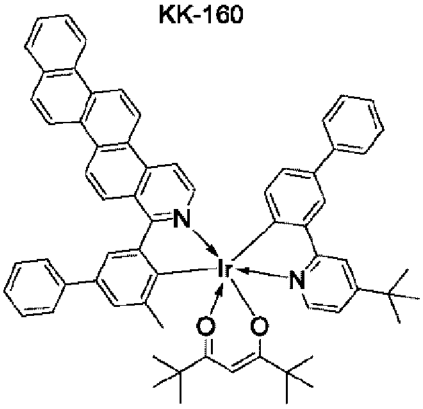

KK-162

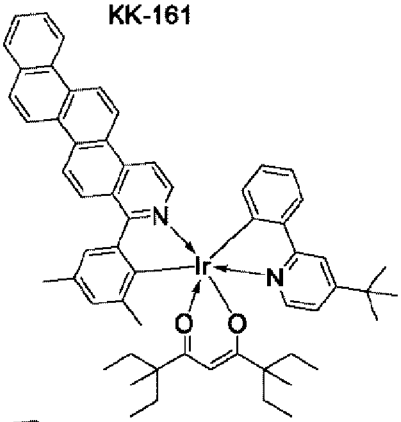

KK-163

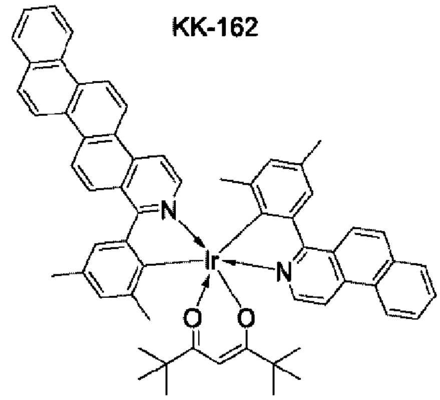

KK-164

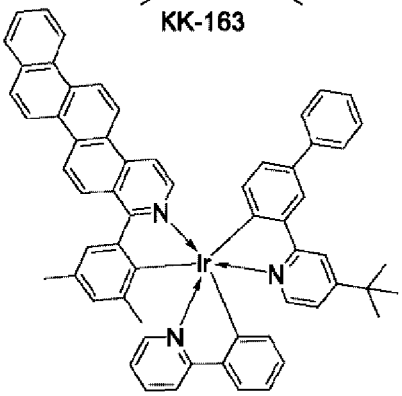

KK-165

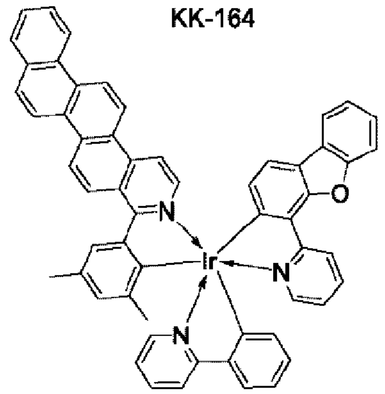

KK-166

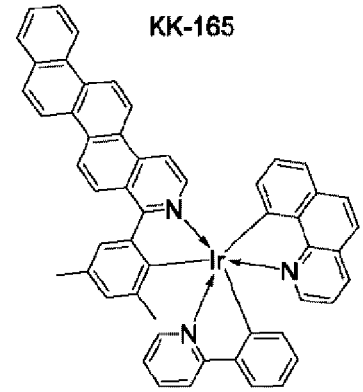

KK-167

[Chem. 36]

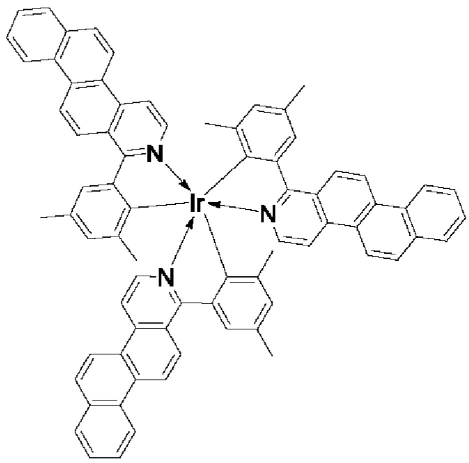

KK-170

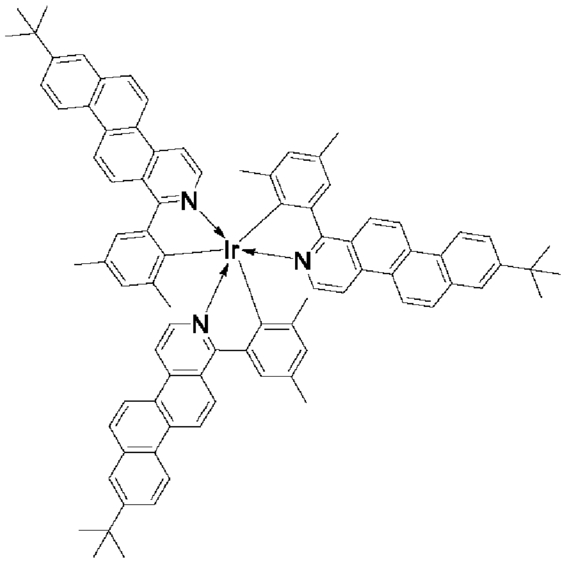

KK-171

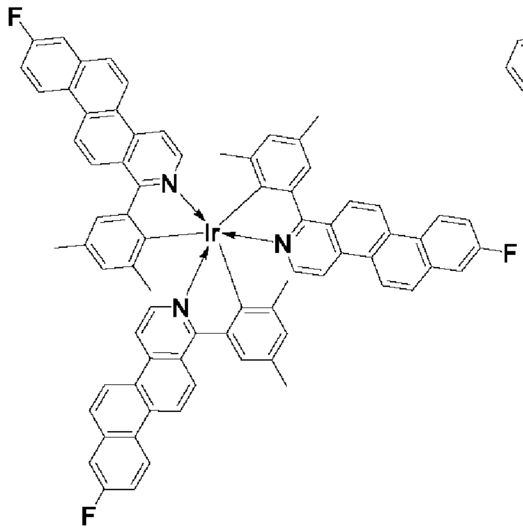

KK-172

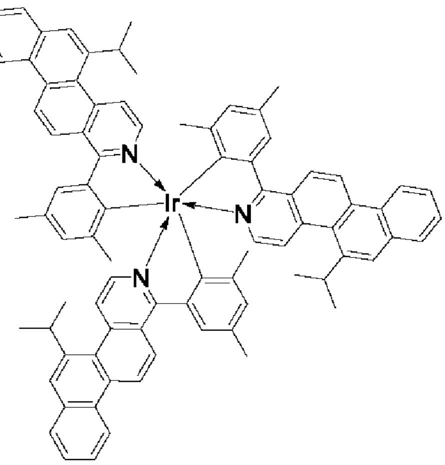

KK-173

[Chem. 37]

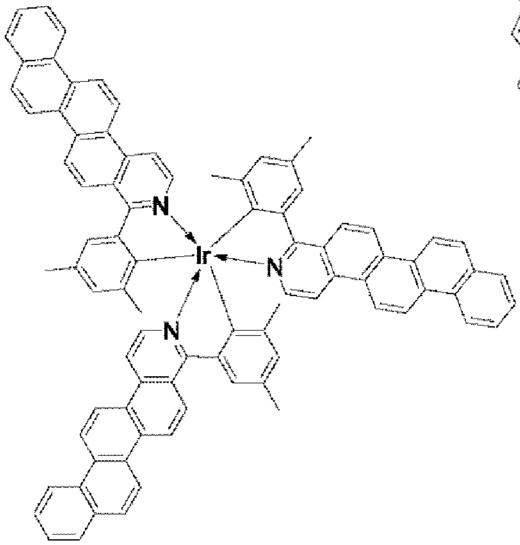

KK-174

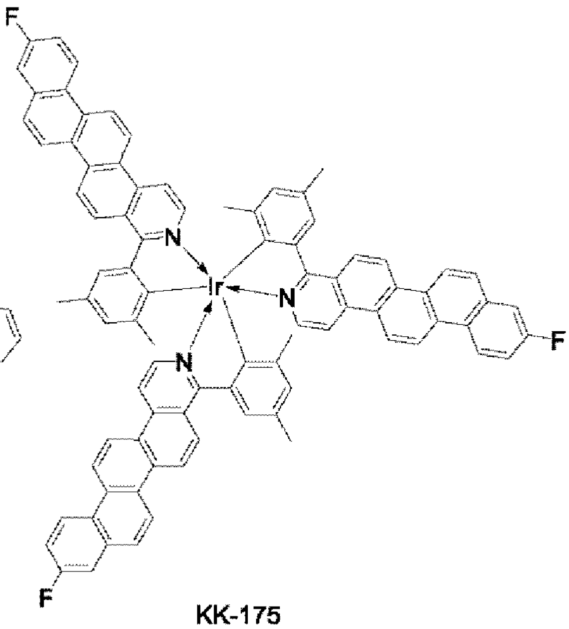

KK-175

<<Specific Example of Second Compound>>

Specific examples of the second compound are shown below.

[Chem. 38]

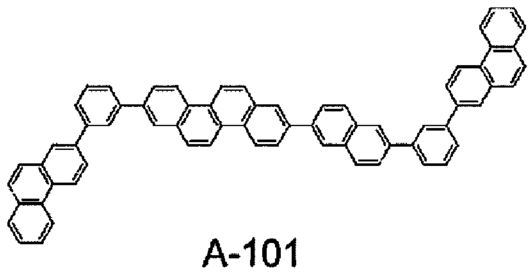

A-101

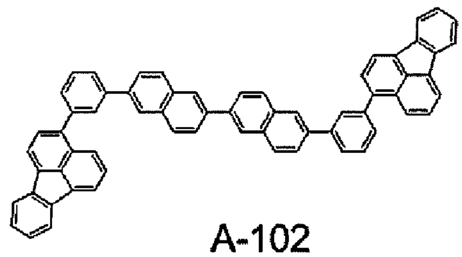

A-102

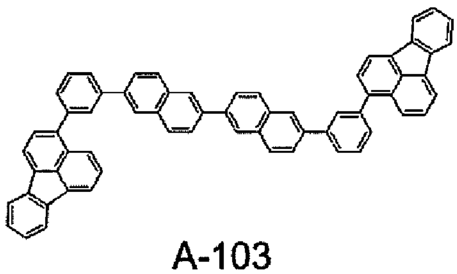

A-103

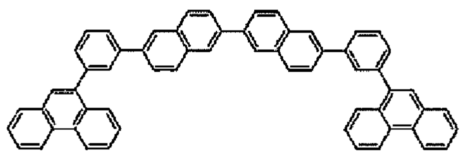

A-104

[Chem. 39]

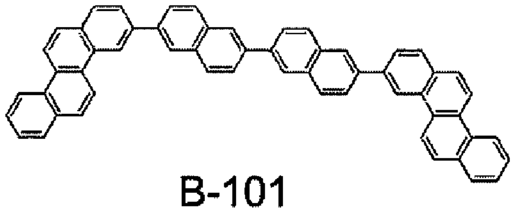

B-101

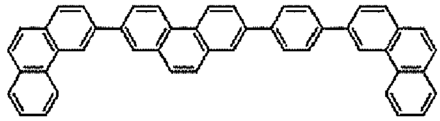

B-102

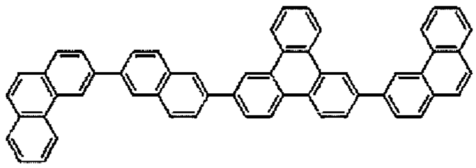

B-103

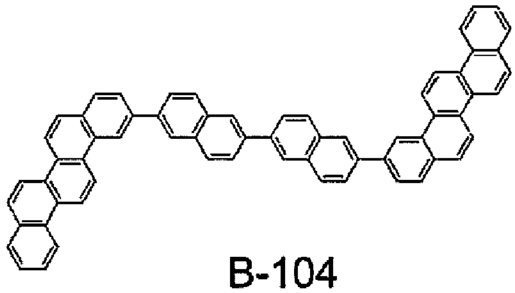

B-104

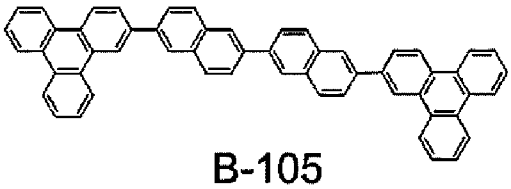

B-105

[Chem. 40]

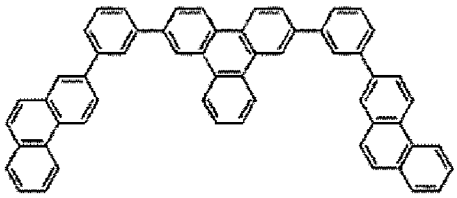

C-101

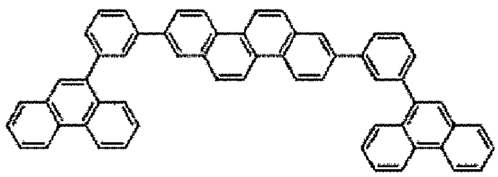

C-102

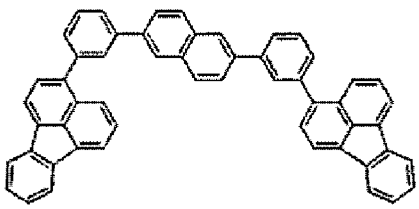

C-103

[Chem. 41]

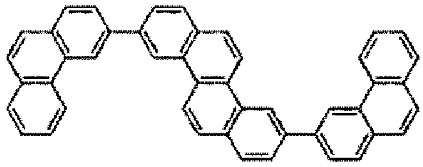

D-101

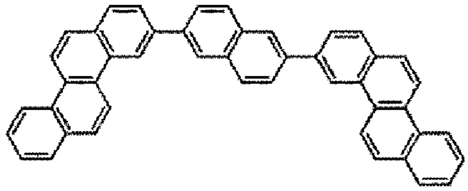

D-102

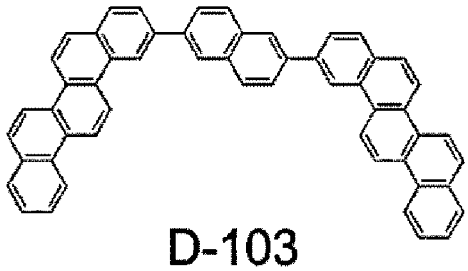

D-103

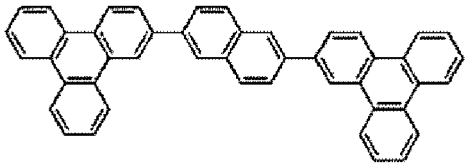

D-104

[Chem. 42]

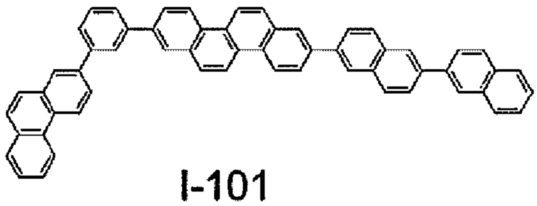

I-101

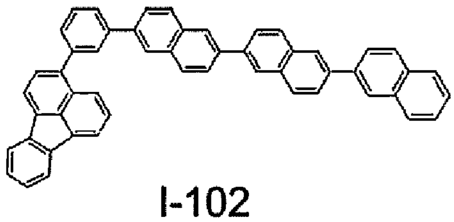

I-102

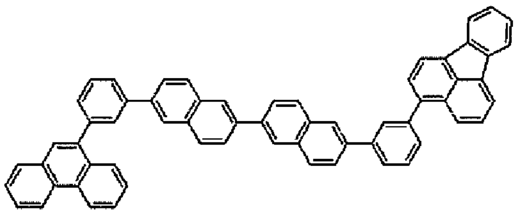

I-103

[Chem. 43]

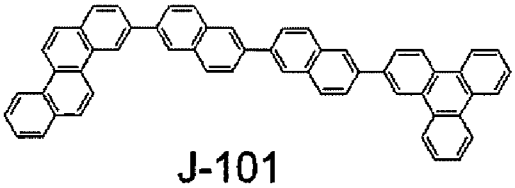

J-101

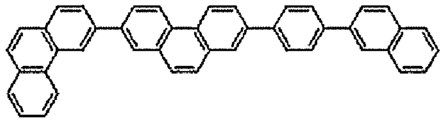

J-102

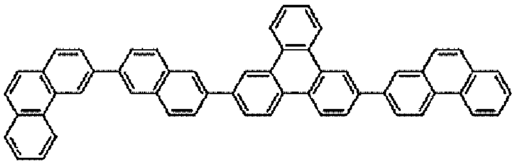

J-103

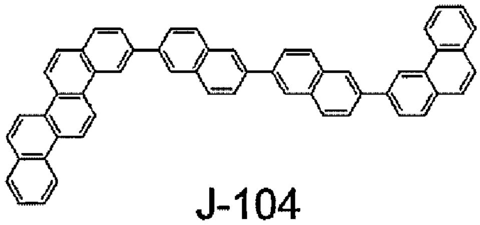

J-104

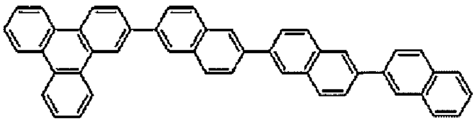

J-105

[Chem. 44]

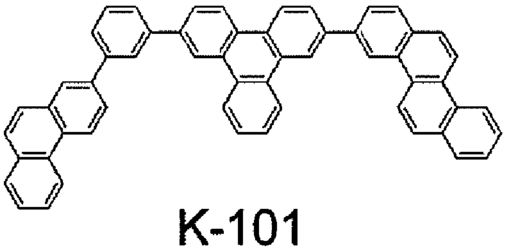

K-101

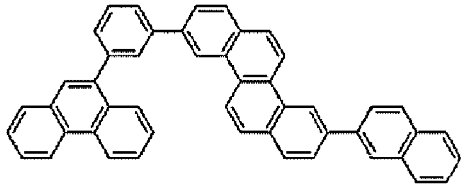

K-102

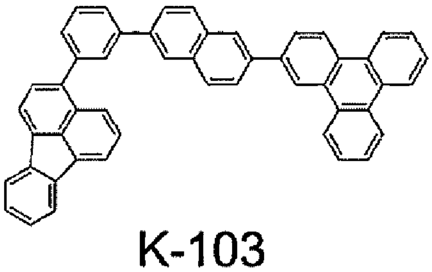

K-103

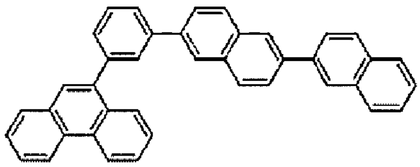

K-104

[Chem. 45]

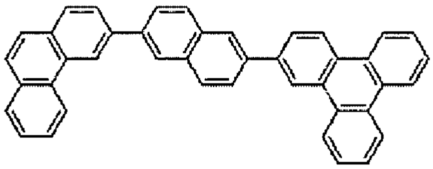

L-101

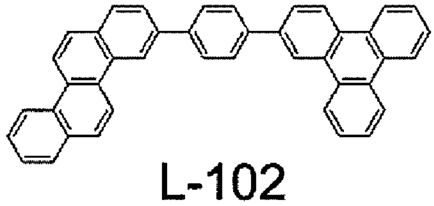

L-102

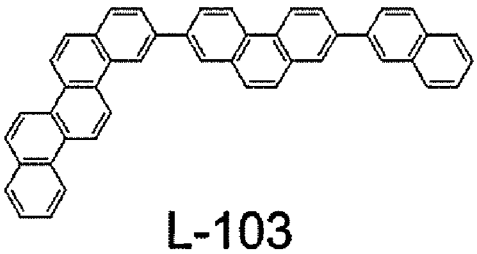

L-103

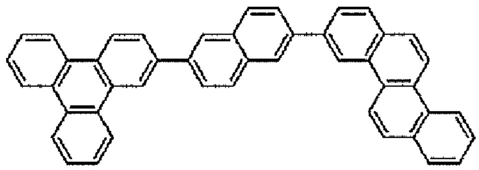

L-104

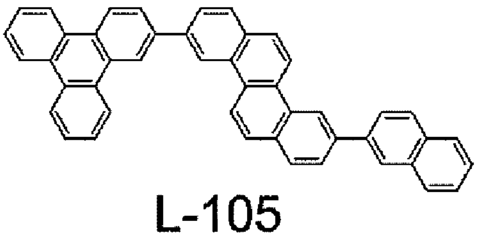

L-105

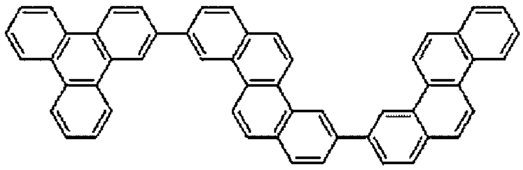

L-106

[Chem. 46]

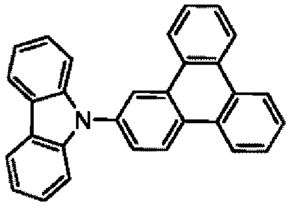

X-101

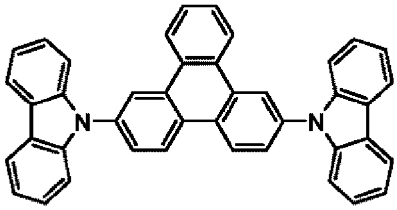

X-105

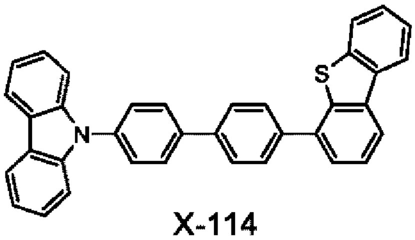

X-114

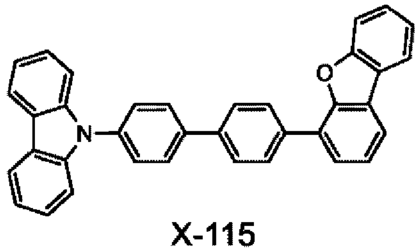

X-115

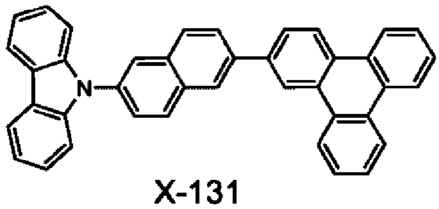

X-131

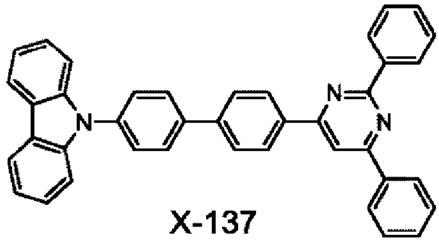

X-137

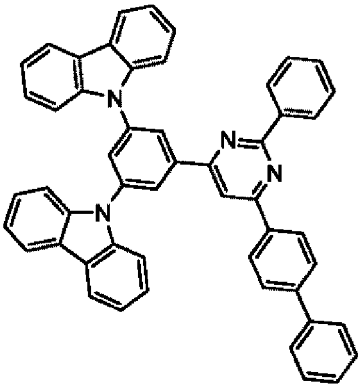

X-139

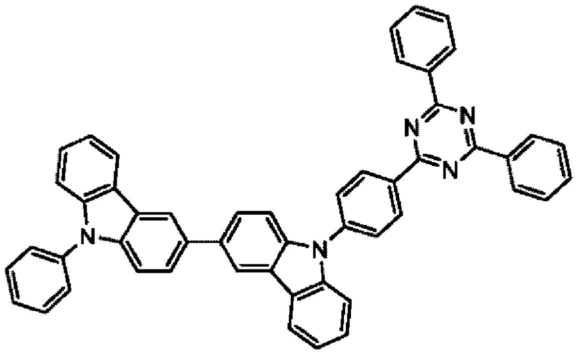

X-140

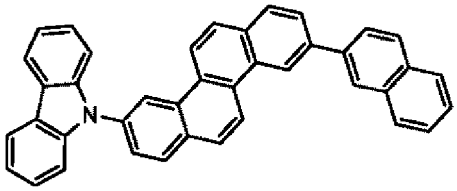

X-145

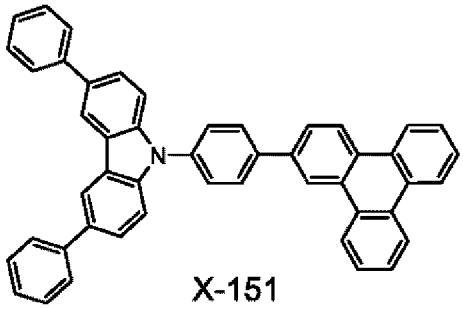

X-151

[Chem. 47]

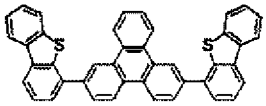
H-105

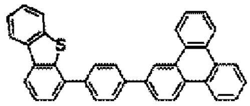
H-108

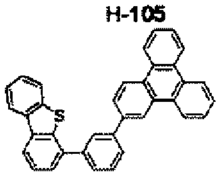
H-109

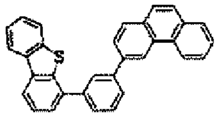
H-110

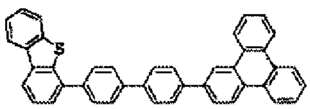
H-111

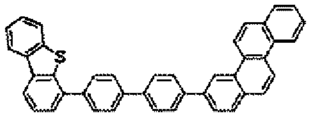
H-112

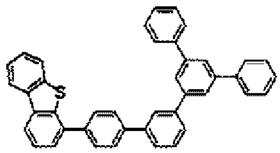
H-113

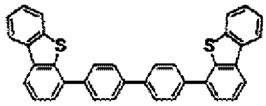
H-114

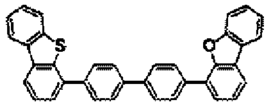
H-115

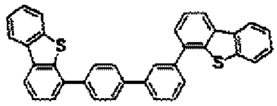
H-116

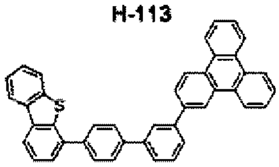
H-117

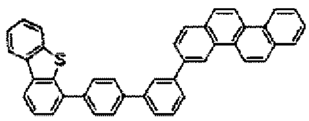
H-118

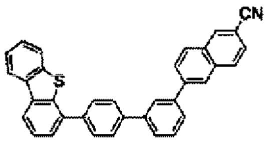
H-119

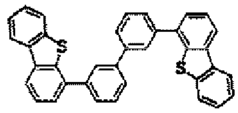
H-120

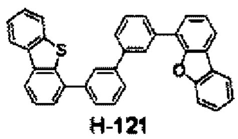
H-121

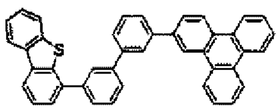
H-122

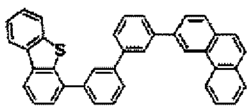
H-123

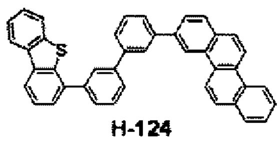
H-124

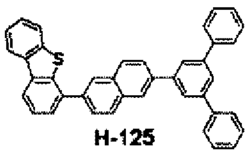
H-125

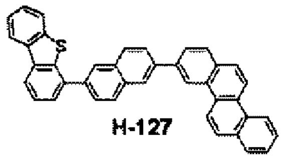
H-127

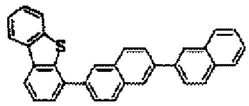
H-128

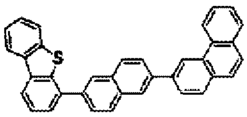
H-129

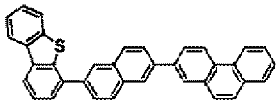
H-130

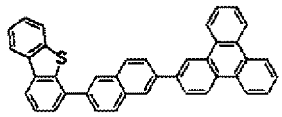
H-131

[Chem. 48]

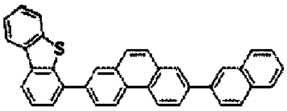
H-135

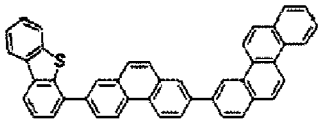
H-137

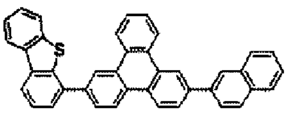
H-138

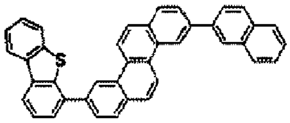
H-139

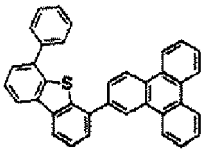
H-141

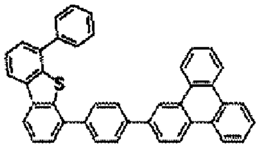
H-142

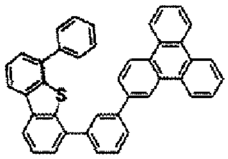
H-143

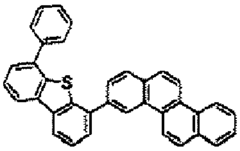
H-144

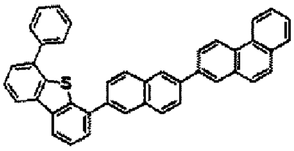
H-145

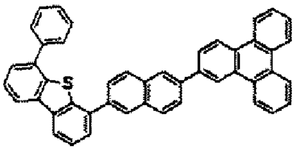
H-146

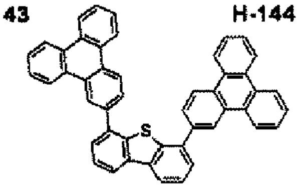
H-147

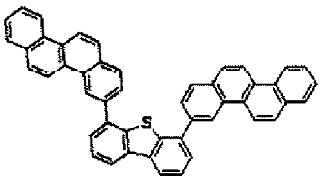
H-148

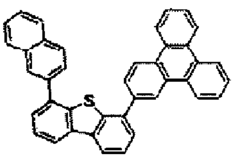
H-149

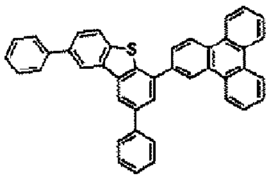
H-150

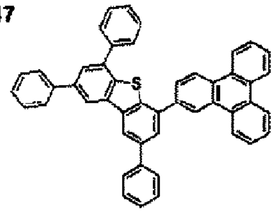
H-151

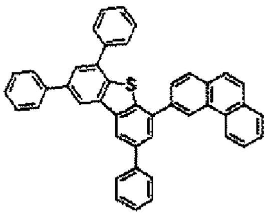
H-152

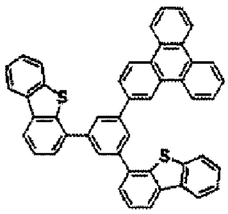
H-153

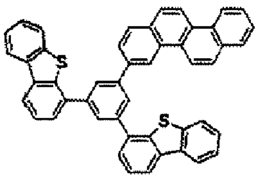
H-154

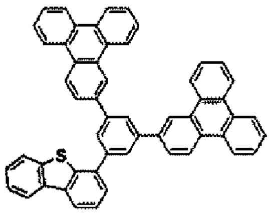
H-155

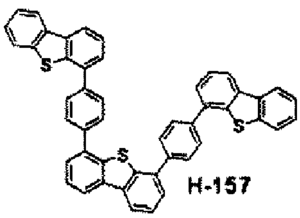
H-157

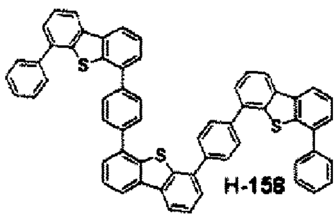
H-158

[Chem. 49]

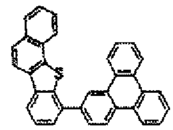
H-201

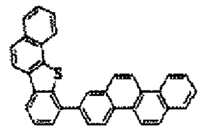
H-203

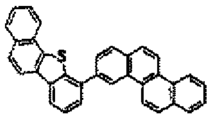
H-204

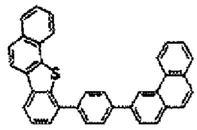
H-205

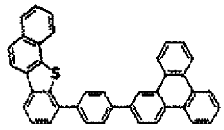
H-206

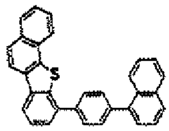
H-207

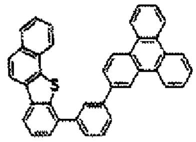
H-208

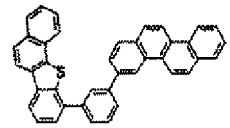
H-209

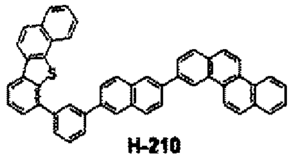
H-210

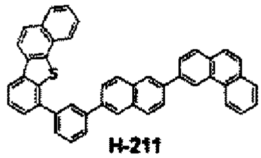
H-211

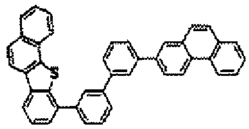
H-212

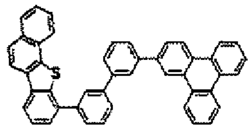
H-213

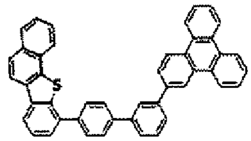
H-214

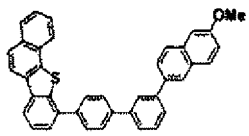
H-215

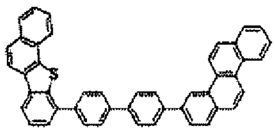
H-216

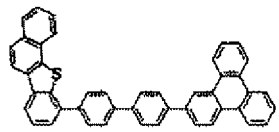
H-217

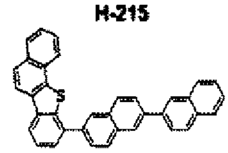
H-218

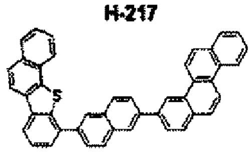
H-220

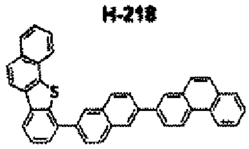
H-221

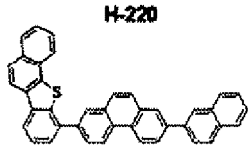
H-223

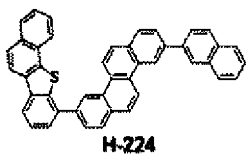
H-224

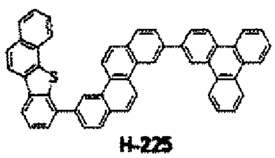
H-225

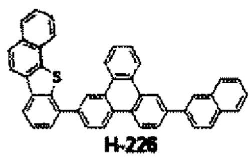
H-226

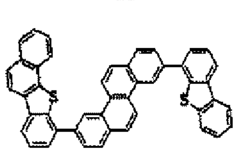
H-227

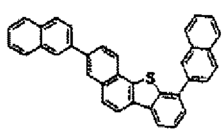
H-229

[Chem. 50]

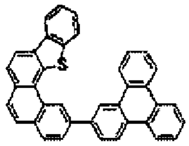
H-301

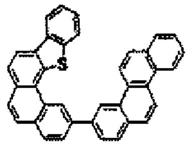
H-302

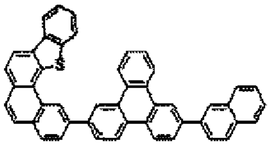
H-303

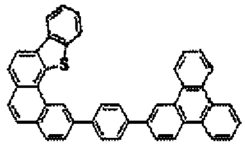
H-304

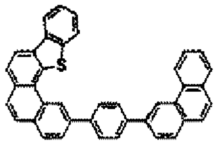
H-305

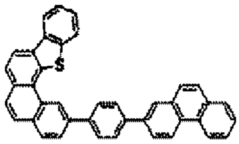
H-306

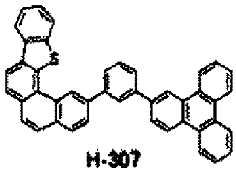
H-307

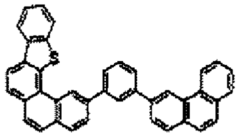
H-308

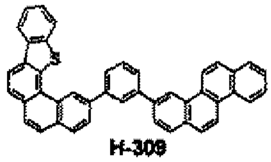
H-309

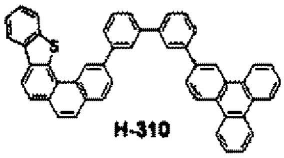
H-310

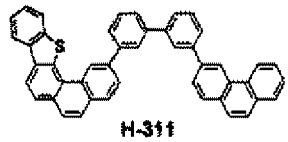
H-311

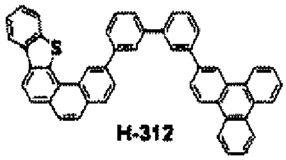
H-312

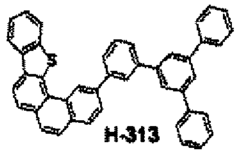
H-313

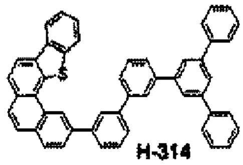
H-314

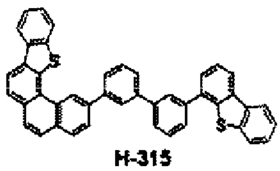
H-315

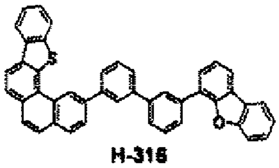
H-316

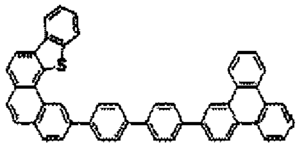
H-317

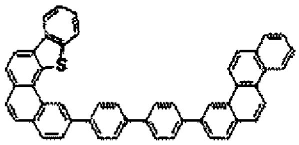
H-318

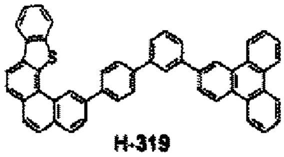
H-319

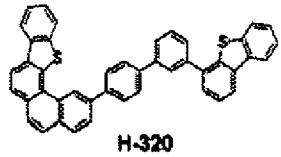
H-320

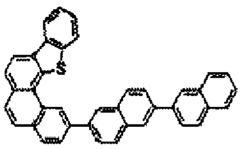
H-321

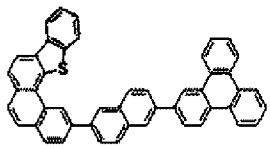
H-323

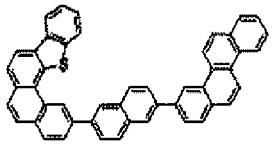
H-324

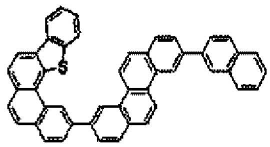
H-326

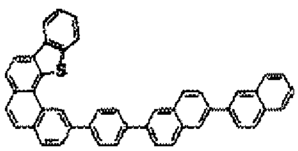
H-327

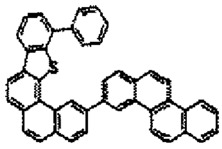
H-328

[Chem. 51]

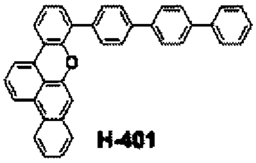
H-401

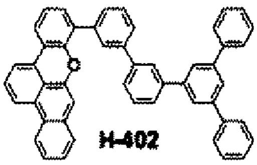
H-402

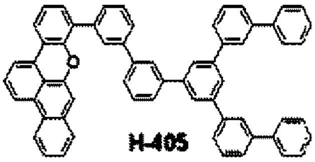
H-405

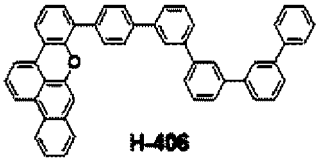
H-406

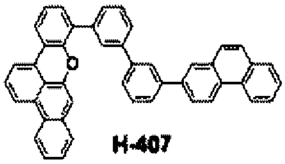
H-407

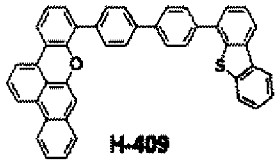
H-409

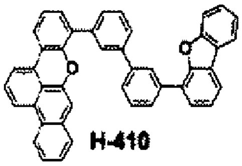
H-410

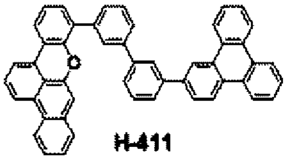
H-411

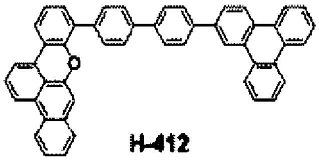
H-412

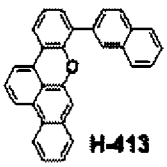
H-413

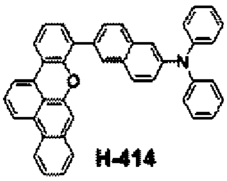
H-414

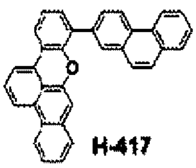
H-417

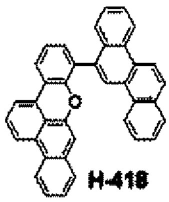
H-418

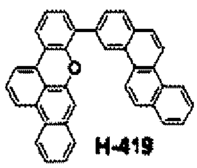
H-419

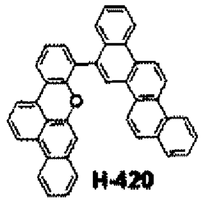
H-420

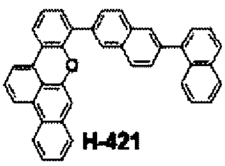
H-421

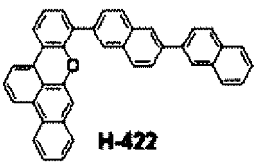
H-422

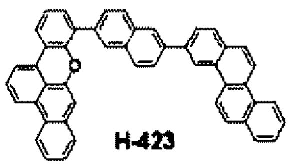
H-423

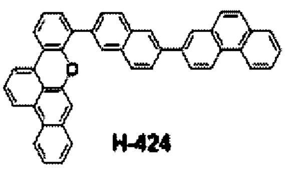
H-424

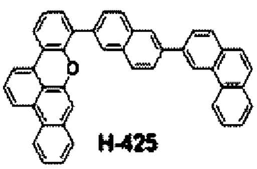
H-425

[Chem. 52]

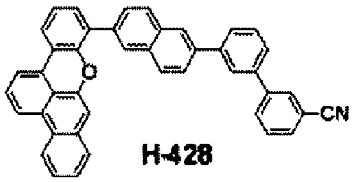
H-428

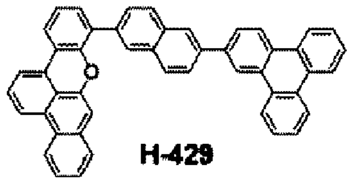
H-429

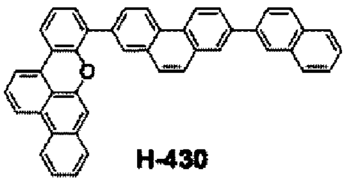
H-430

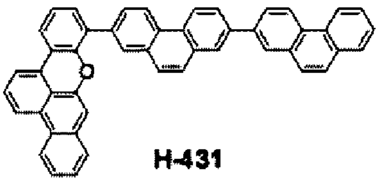
H-431

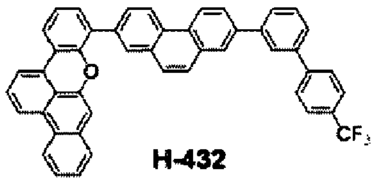
H-432

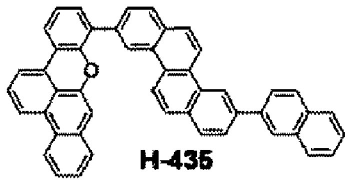
H-435

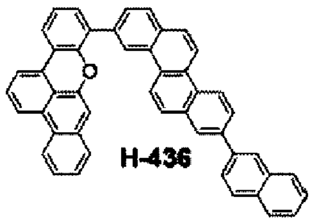
H-436

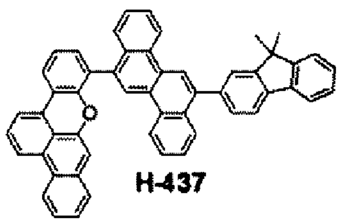
H-437

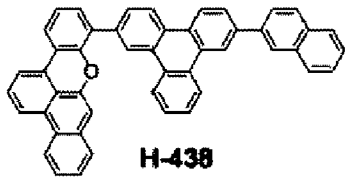
H-438

[Chem. 53]

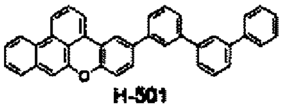
H-501

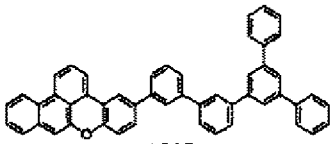
H-505

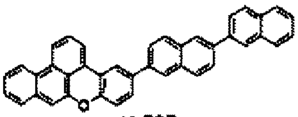
H-507

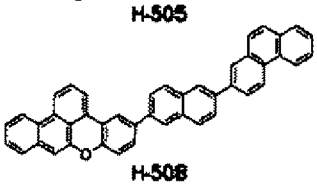
H-508

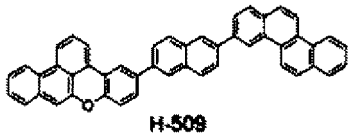
H-509

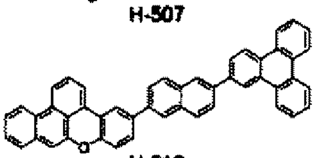
H-510

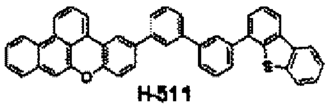
H-511

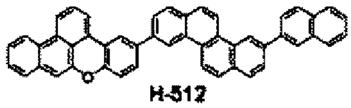
H-512

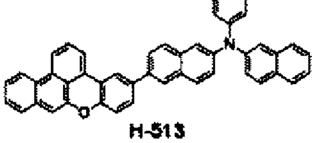
H-513

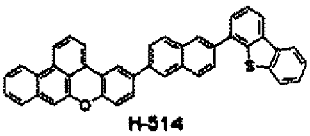
H-514

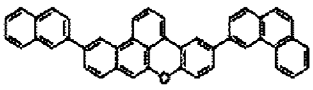
H-516

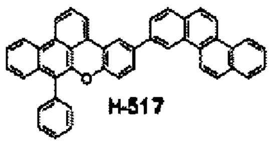
H-517

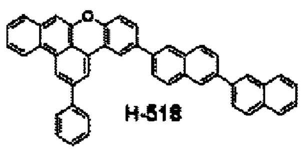
H-518

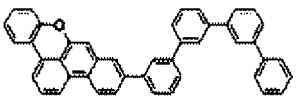
H-601

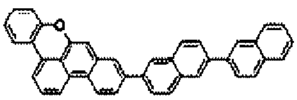
H-602

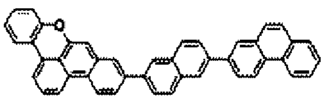
H-603

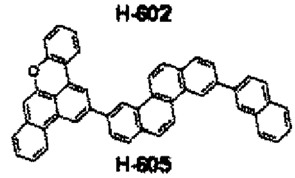
H-605

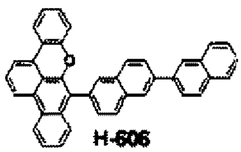
H-606

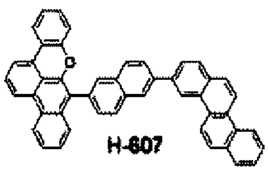
H-607

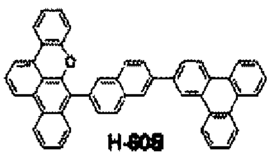
H-608

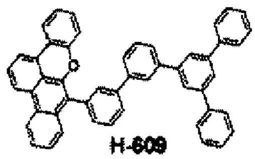
H-609

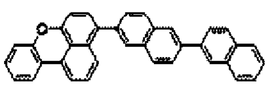
H-610

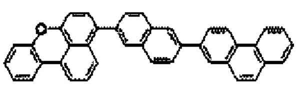
H-611

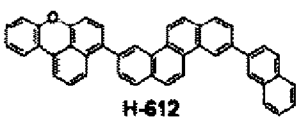
H-612

[Chem. 54]

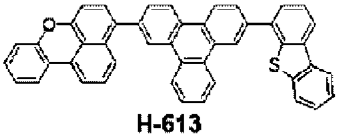
H-613
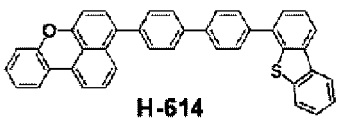
H-614
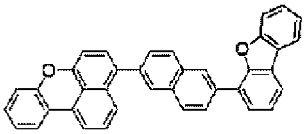
H-615
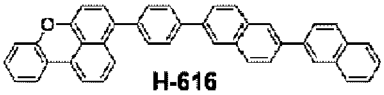
H-616
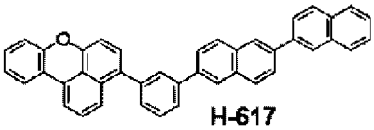
H-617
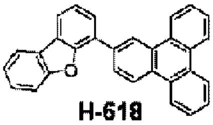
H-618
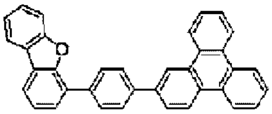
H-619
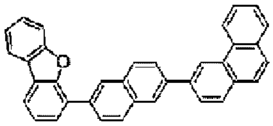
H-620
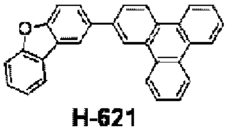
H-621
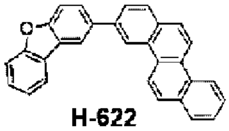
H-622
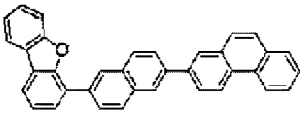
H-623
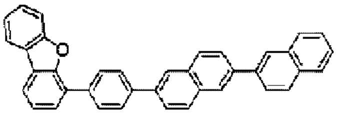
H-624
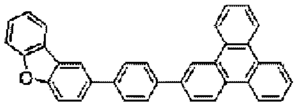
H-625
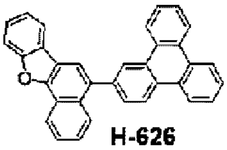
H-626
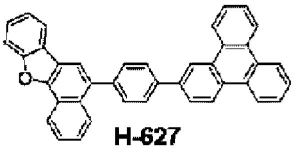
H-627
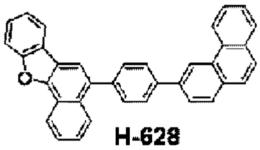
H-628
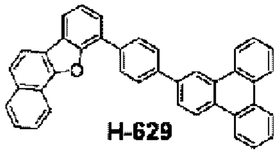
H-629
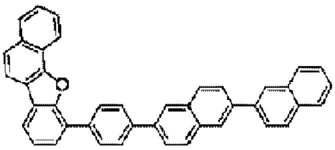
H-630
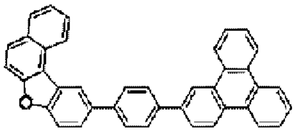
H-631
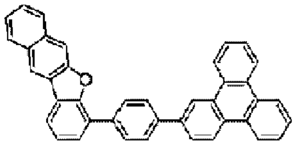
H-632
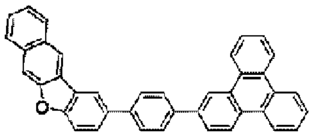
H-634
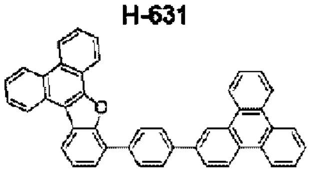
H-635
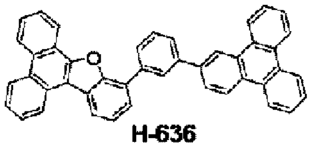
H-636
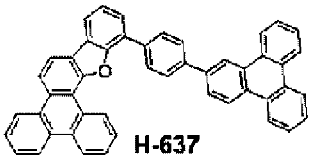
H-637
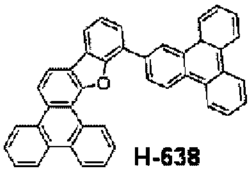
H-638
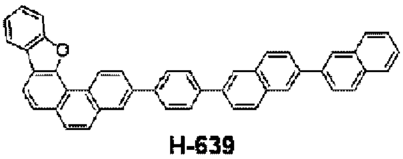
H-639
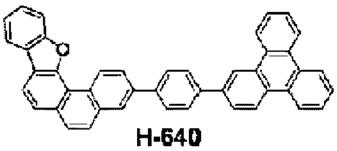
H-640
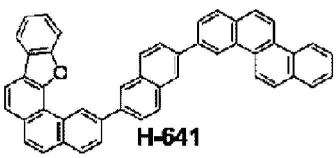
H-641
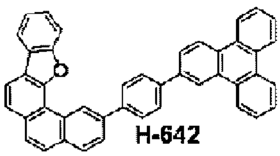
H-642

[Chem. 55]

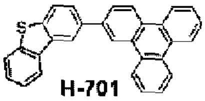
H-701
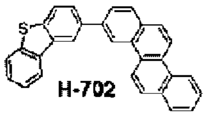
H-702
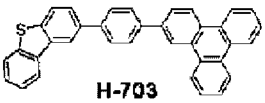
H-703
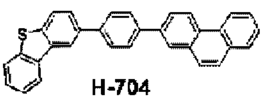
H-704
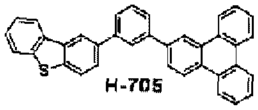
H-705
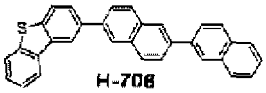
H-706
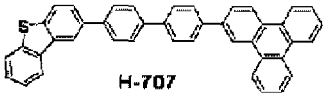
H-707
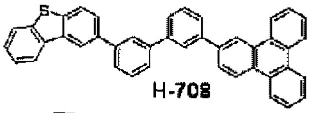
H-708
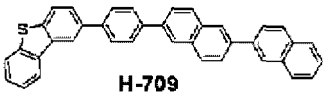
H-709
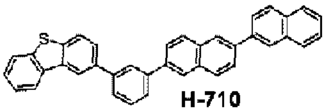
H-710
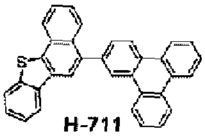
H-711
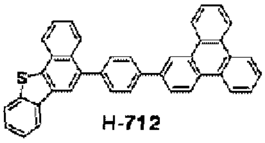
H-712
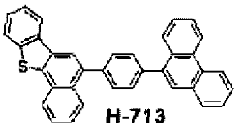
H-713
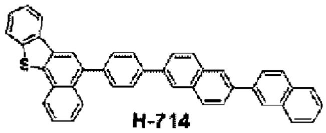
H-714
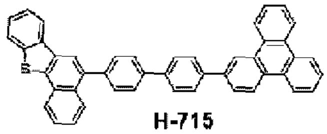
H-715
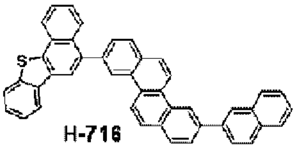
H-716
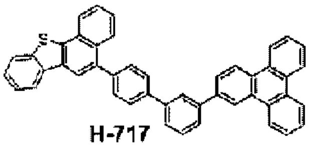
H-717
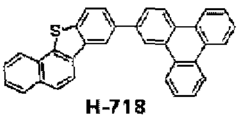
H-718
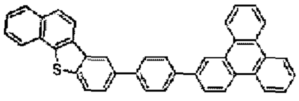
H-719
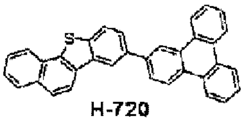
H-720
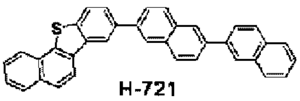
H-721
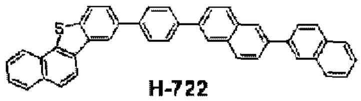
H-722
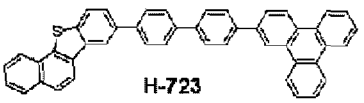
H-723
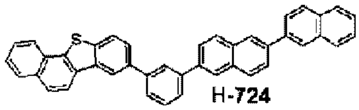
H-724
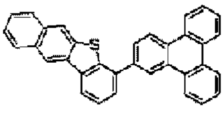
H-725
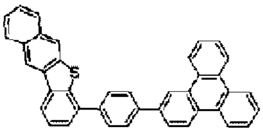
H-726
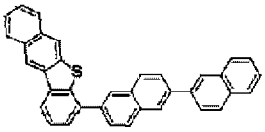
H-727
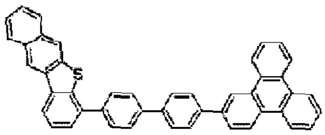
H-728
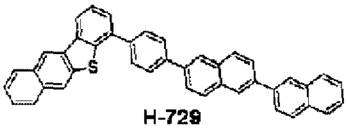
H-729
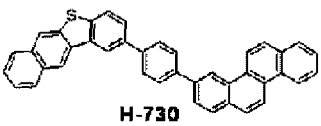
H-730
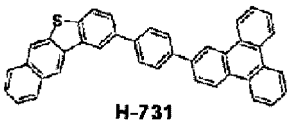
H-731
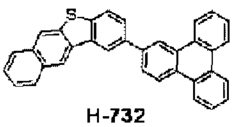
H-732
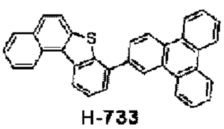
H-733
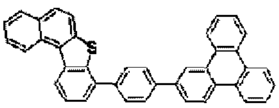
H-734
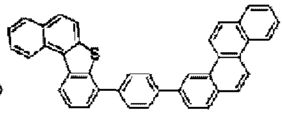
H-735
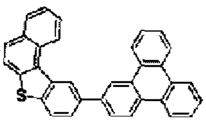
H-736
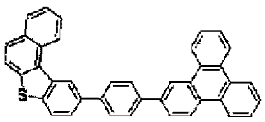
H-737
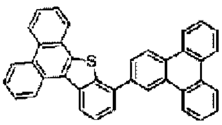
H-738
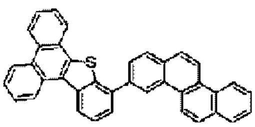
H-739

[Chem. 56]

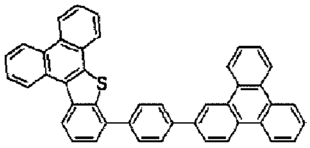
H-740

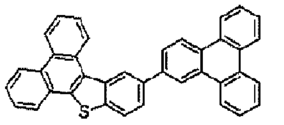
H-741

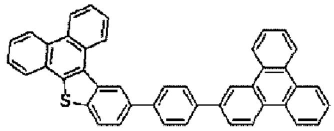
H-742

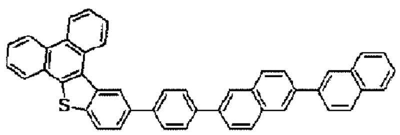
H-743

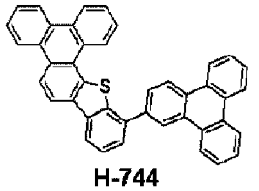
H-744

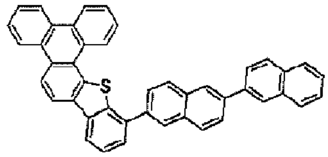
H-745

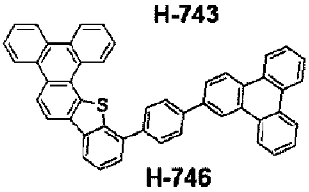
H-746

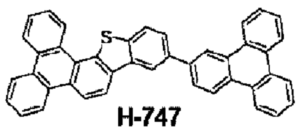
H-747

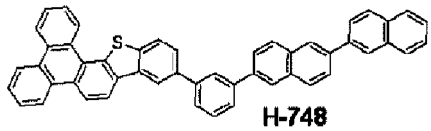
H-748

<<Other Materials>>

As described above, in the organic light-emitting element according to the present embodiment, the light-emitting layer contains at least the first compound represented by the general formula [1] or [3]. Alternatively, in the organic light-emitting element according to the present embodiment, the light-emitting layer contains at least the first compound represented by the general formula [1] and the second compound represented by the general formula [2]. In each layer constituting the organic light-emitting element according to the present embodiment, in addition to these compounds, a known low-molecular-weight material and a known high-molecular-weight material can be used in combination, if necessary. More specifically, a hole-injection/transport material, a host, a light-emitting assist material, or an electron-injection/transport material can be used in combination with each compound.

<<Each Layer Constituting Organic Light-Emitting Element>>

Next, other layers constituting the organic light-emitting element according to the present embodiment are described. As described above, the organic light-emitting element according to the present embodiment includes at least a pair of electrodes (a positive electrode and a negative electrode) and an organic compound layer between the electrodes. The organic compound layer may be a single layer or a laminate composed of a plurality of layers as long as the organic compound layer includes a light-emitting layer. Although the light-emitting layer of the organic compound layer contains the first compound in the above embodiment, a layer other than the light-emitting layer may contain the first compound.

The present inventors have conducted various studies and have found that the first compound according to the present embodiment can be used as a host or guest in a light-emitting layer, particularly as a guest in the light-emitting layer, to provide an element that can efficiently emit bright light and that has very high durability. The light-emitting layer may be monolayer or multilayer or may contain a light-emitting material with another emission color to mix the emission color with the red emission color of the present embodiment. The term "multilayer", as used herein, refers to a laminate of a light-emitting layer and another light-emitting layer. In such a case, the emission color of the organic light-emitting element is not limited to red. More specifically, the emission color may be white or a neutral color. For white color emission, another light-emitting layer emits light of a color other than red, such as blue or green. Such a layer is formed by vapor evaporation or coating. This is described in detail below in exemplary embodiments.

The first compound according to the present embodiment can be used as a constituent material of an organic compound layer other than the light-emitting layer constituting the organic light-emitting element according to the present embodiment. More specifically, the organic compound according to the present embodiment may be used as a constituent material of an electron-transport layer, an electron-injection layer, a hole-transport layer, a hole-injection layer, and/or a hole-blocking layer. In such a case, the emission color of the organic light-emitting element is not limited to red. More specifically, the emission color may be white or a neutral color.

If necessary, the organic compound according to the present embodiment may be used in combination with a known low-molecular-weight or high-molecular-weight hole-injection compound or hole-transport compound, host compound, light-emitting compound, electron-injection compound, or electron-transport compound. Examples of these compounds are described below.

The hole-injection/transport material is preferably a material with high hole mobility to facilitate the injection of holes from a positive electrode and to transport the injected holes to a light-emitting layer. Furthermore, a material with a high glass transition temperature is preferably used to reduce degradation of film quality, such as crystallization, in an organic light-emitting element. Examples of the low-molecular-weight or high-molecular-weight material with hole-injection/transport ability include, but are not limited to, triarylamine derivatives, aryl carbazole derivatives, phenylenediamine derivatives, stilbene derivatives, phthalocyanine derivatives, porphyrin derivatives, polyvinylcarbazole, polythiophene, and other electrically conductive polymers. The hole-injection/transport material is also suitable for use in an electron-blocking layer. Specific examples of compounds that can be used as hole-injection/transport materials include, but are not limited to, the following.

[Chem. 57]

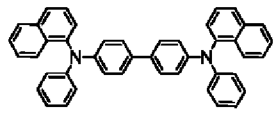
**HT1**

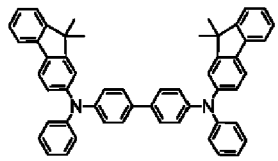
**HT2**

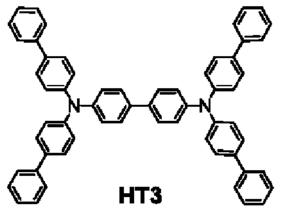
**HT3**

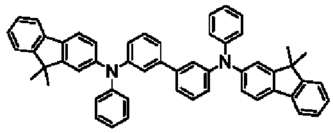
**HT4**

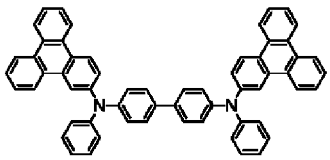
**HT5**

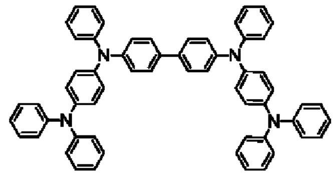
**HT6**

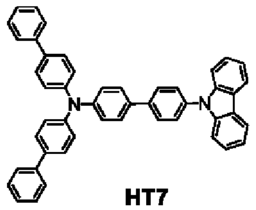
**HT7**

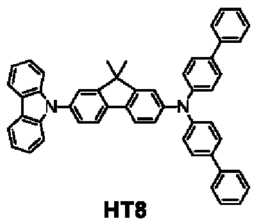
**HT8**

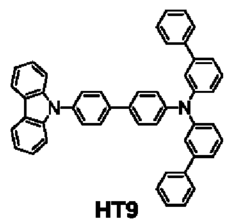
**HT9**

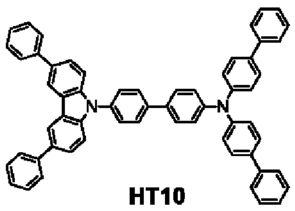
**HT10**

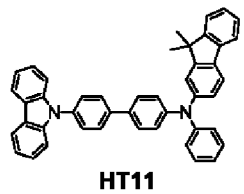
**HT11**

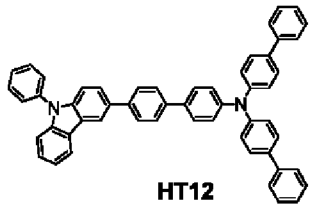
**HT12**

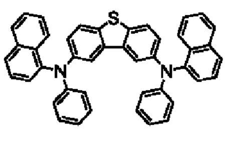
**HT13**

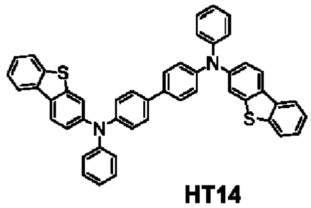
**HT14**

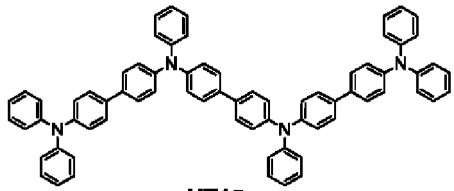
**HT15**

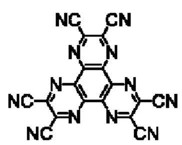
**HT16**

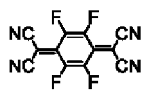
**HT17**

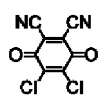
**HT18**

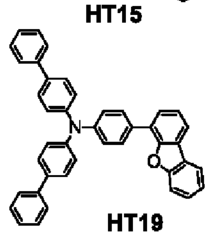
**HT19**

Examples of a light-emitting material mainly related to the light-emitting function include, in addition to the first compound represented by the general formula [1] or [3], fused-ring compounds (for example, fluorene derivatives, naphthalene derivatives, pyrene derivatives, perylene derivatives, tetracene derivatives, anthracene derivatives, rubrene, etc.), quinacridone derivatives, coumarin derivatives, stilbene derivatives, organoaluminum complexes, such as tris(8-quinolinolato)aluminum, iridium complexes, platinum complexes, rhenium complexes, copper complexes, europium complexes, ruthenium complexes, and polymer derivatives, such as poly(phenylene vinylene) derivatives, polyfluorene derivatives, and polyphenylene derivatives.

Specific examples of compounds that can be used as light-emitting materials include, but are not limited to, the following.

[Chem. 58]

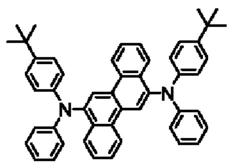
BD1
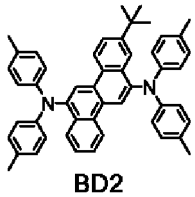
BD2
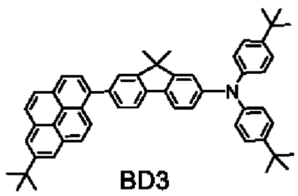
BD3
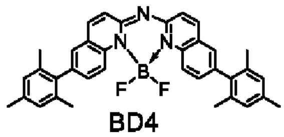
BD4
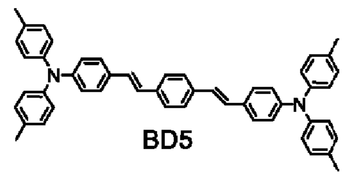
BD5
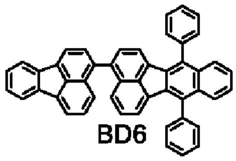
BD6
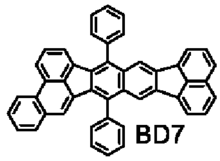
BD7
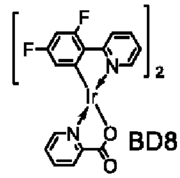
BD8

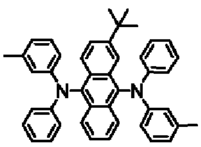
GD1
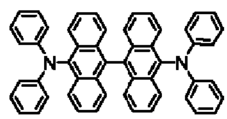
GD2
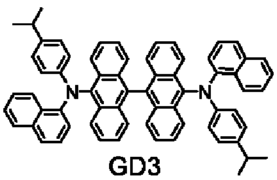
GD3
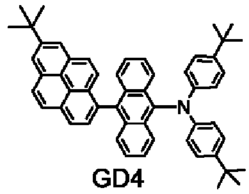
GD4

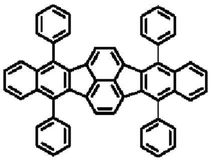
GD5
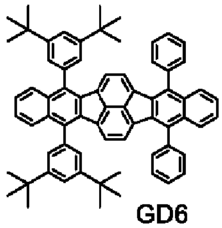
GD6
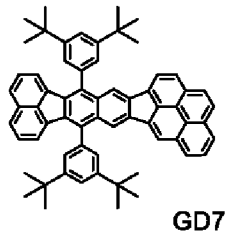
GD7
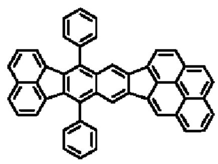
GD8

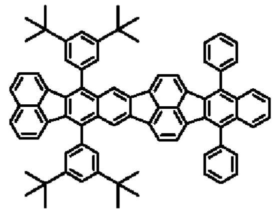
GD9
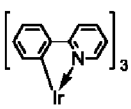
GD10
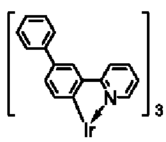
GD11
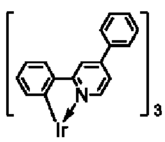
GD12

[Chem. 59]

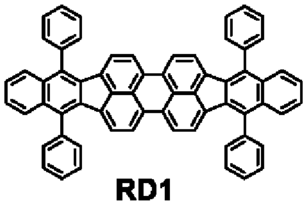
RD1

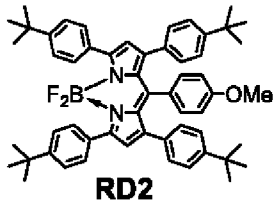
RD2

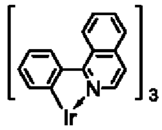
RD3

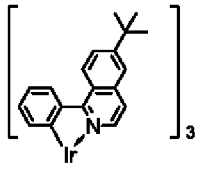
RD4

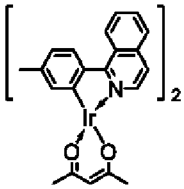
RD5

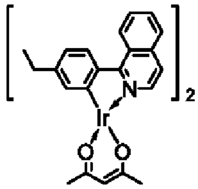
RD6

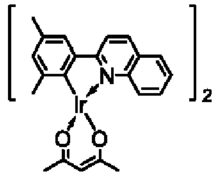
RD7

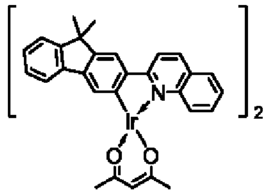
RD8

Examples of a light-emitting layer host or a light-emitting assist material other than the second compound in a light-emitting layer include, but are not limited to, aromatic hydrocarbon compounds and derivatives thereof, carbazole derivatives, dibenzofuran derivatives, dibenzothiophene derivatives, organoaluminum complexes, such as tris(8-quinolinolato)aluminum, and organoberyllium complexes.

Specific examples of a compound other than the second compound in the light-emitting layer used as a light-emitting layer host or a light-emitting assist material are shown below, but as a matter of course the present invention is not limited thereto.

[Chem. 60]

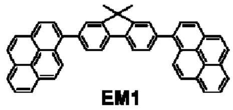
EM1
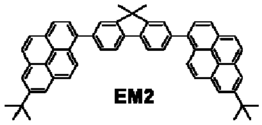
EM2
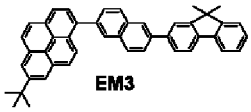
EM3
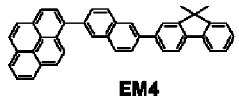
EM4

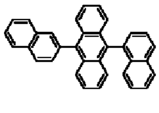
EM5
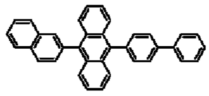
EM6
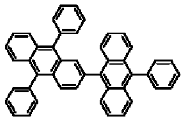
EM7
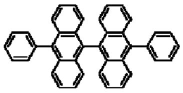
EM8
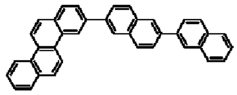
EM9

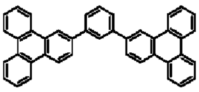
EM10
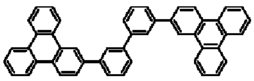
EM11
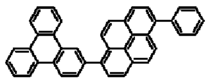
EM12
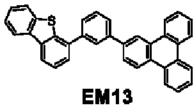
EM13

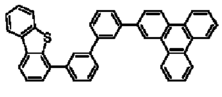
EM14
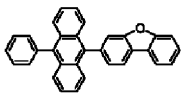
EM15
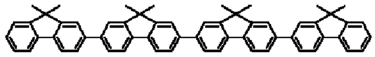
EM16

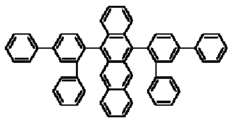
EM17
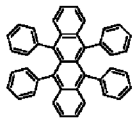
EM18
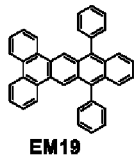
EM19
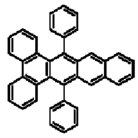
EM20
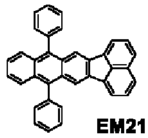
EM21

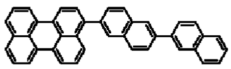
EM22
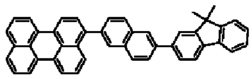
EM23
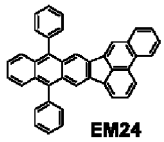
EM24
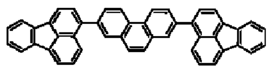
EM25

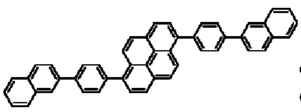
EM26
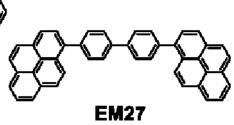
EM27
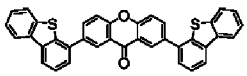
EM28
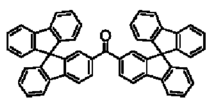
EM29

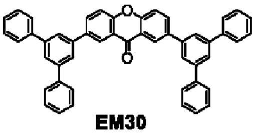
EM30
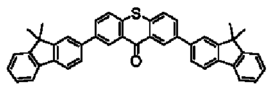
EM31
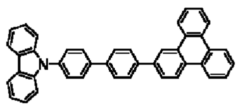
EM32
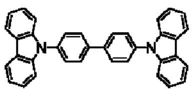
EM33

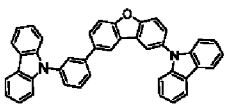
EM34
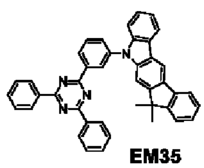
EM35
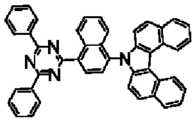
EM36
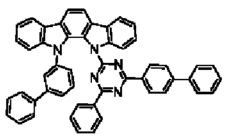
EM37

An electron-transport material can be selected from materials that can transport electrons injected from the negative electrode to the light-emitting layer and is selected in consideration of the balance with the hole mobility of a hole-transport material and the like. Examples of materials with electron-transport ability include, but are not limited to, oxadiazole derivatives, oxazole derivatives, pyrazine derivatives, triazole derivatives, triazine derivatives, quinoline derivatives, quinoxaline derivatives, phenanthroline derivatives, organoaluminum complexes, and fused-ring compounds (for example, fluorene derivatives, naphthalene derivatives, chrysene derivatives, and anthracene derivatives). Furthermore, the electron-transport material is also suitable for use in a hole-blocking layer. Specific examples of compounds that can be used as electron-transport materials include, but are not limited to, the following.

[Chem. 61]

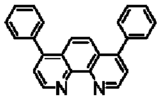
ET1

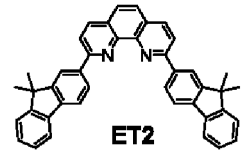
ET2

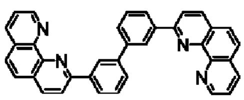
ET3

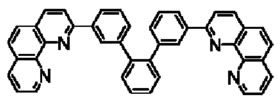
ET4

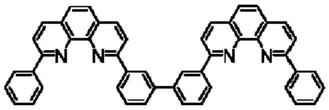
ET5

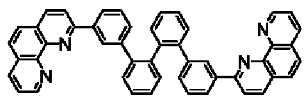
ET6

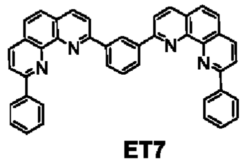
ET7

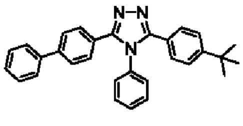
ET8

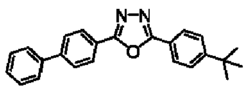
ET9

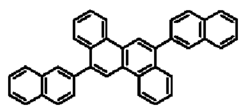
ET10

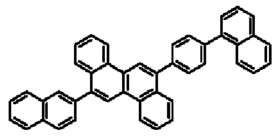
ET11

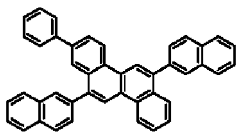
ET12

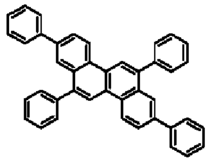
ET13

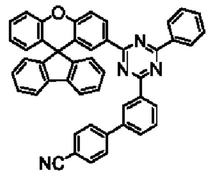
ET14

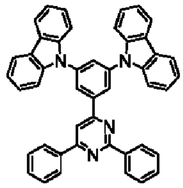
ET15

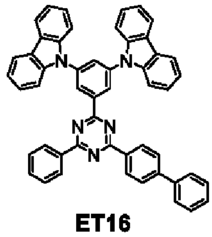
ET16

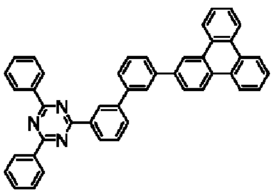
ET17

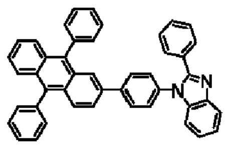
ET18

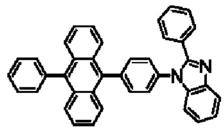
ET19

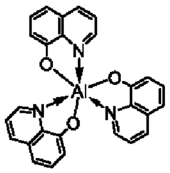
ET20

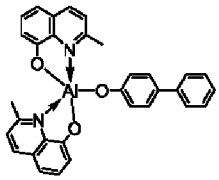
ET21

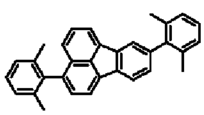
ET22

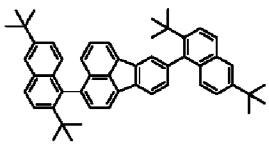
ET23

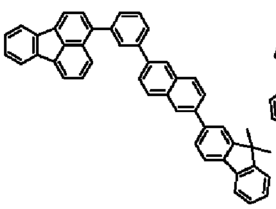
ET24

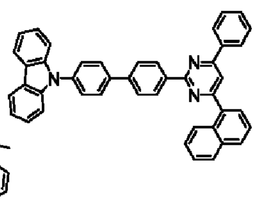
ET25

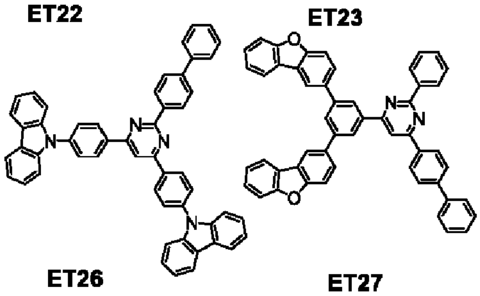
ET26

ET27

Constituents other than the organic compound layers constituting the organic light-emitting element according to the present embodiment are described below. The organic light-emitting element may include a first electrode, an organic compound layer, and a second electrode on a substrate. One of the first electrode and the second electrode is a positive electrode, and the other is a negative electrode. A protective layer, a color filter, or the like may be provided on the second electrode. When a color filter is provided, a planarization layer may be provided between the color filter and the protective layer. The planarization layer may be composed of an acrylic resin or the like.

The substrate may be formed of quartz, glass, silicon, resin, metal, or the like. The substrate may have a switching element, such as a transistor, and wiring, on which an insulating layer may be provided. The insulating layer may be formed of any material, provided that the insulating layer can have a contact hole to ensure electrical connection

between the positive electrode and wiring and can be insulated from unconnected wiring. For example, the insulating layer may be formed of a resin, such as polyimide, silicon oxide, or silicon nitride.

A constituent material of the positive electrode can have as large a work function as possible. Examples of the constituent material include metal elements, such as gold, platinum, silver, copper, nickel, palladium, cobalt, selenium, vanadium, and tungsten, mixtures thereof, alloys thereof, and metal oxides, such as tin oxide, zinc oxide, indium oxide, indium tin oxide (ITO), and indium zinc oxide. Electrically conductive polymers, such as polyaniline, polypyrrole, and polythiophene, may also be used. These electrode materials may be used alone or in combination. The positive electrode may be composed of a single layer or a plurality of layers. When used as a reflective electrode, for example, chromium, aluminum, silver, titanium, tungsten, molybdenum, an alloy thereof, or a laminate thereof can be used. When used as a transparent electrode, an oxide transparent electroconductive layer, such as indium tin oxide (ITO) or indium zinc oxide, can be used. However, the present disclosure is not limited thereto. The positive electrode may be formed by photolithography.

On the other hand, a constituent material of the negative electrode is preferably a material with a small work function. For example, an alkali metal, such as lithium, an alkaline-earth metal, such as calcium, a metal element, such as aluminum, titanium, manganese, silver, lead, or chromium, or a mixture thereof may be used. An alloy of these metal elements may also be used. For example, magnesium-silver, aluminum-lithium, aluminum-magnesium, silver-copper, or zinc-silver may be used. A metal oxide, such as indium tin oxide (ITO), may also be used. These electrode materials may be used alone or in combination. The negative electrode may be composed of a single layer or a plurality of layers. In particular, silver is preferably used, and a silver alloy is more preferably used to reduce the aggregation of silver. As long as the aggregation of silver can be reduced, the alloy may have any ratio. For example, it may be 1:1.

The negative electrode may be, but is not limited to, an oxide electroconductive layer, such as ITO, for a top emission element or a reflective electrode, such as aluminum (Al), for a bottom emission element. The negative electrode may be formed by any method. A direct-current or alternating-current sputtering method is preferred because it can achieve good film coverage and easily decrease resistance.

A protective layer may be provided after the negative electrode is formed. For example, a glass sheet with a moisture absorbent may be attached to the negative electrode to decrease the amount of water or the like entering the organic compound layer and to reduce the occurrence of display defects. In another embodiment, a passivation film of silicon nitride or the like may be provided on the negative electrode to decrease the amount of water or the like entering the organic compound layer. For example, after the negative electrode is formed, the negative electrode is transferred to another chamber without breaking the vacuum, and a silicon nitride film with a thickness of 2 um may be formed as a protective layer by a chemical vapor deposition (CVD) method. The film formation by the CVD method may be followed by the formation of a protective layer by an atomic layer deposition (ALD) method.

Furthermore, each pixel may be provided with a color filter. For example, a color filter that matches the size of the pixel may be provided on another substrate and may be bonded to the substrate of the organic light-emitting element, or a color filter may be patterned by photolithography on the protective layer formed of silicon oxide or the like.

An organic compound layer (a hole-injection layer, a hole-transport layer, an electron-blocking layer, a light-emitting layer, a hole-blocking layer, an electron-transport layer, an electron-injection layer, etc.) constituting the organic light-emitting element according to the present embodiment is formed by the following method. That is, an organic compound layer may be formed by a dry process, such as a vacuum deposit method, an ionized deposition method, sputtering, or plasma. Instead of the dry process, a wet process may also be employed in which a layer is formed by a known coating method (for example, spin coating, dipping, a casting method, an LB method, an ink jet method, or the like) using an appropriate solvent. A layer formed by a vacuum evaporation method, a solution coating method, or the like undergoes little crystallization or the like and has high temporal stability. When a film is formed by a coating method, the film may also be formed in combination with an appropriate binder resin. Examples of the binder resin include, but are not limited to, polyvinylcarbazole resins, polycarbonate resins, polyester resins, ABS resins, acrylic resins, polyimide resins, phenolic resins, epoxy resins, silicon resins, and urea resins. The binder resins may be used alone or in combination as a homopolymer or a copolymer. If necessary, an additive agent, such as a known plasticizer, oxidation inhibitor, and/or ultraviolet absorbent, may also be used.

<<Apparatus Including Organic Light-Emitting Element>>

The organic light-emitting element according to the present embodiment can be used as a constituent of a display apparatus or a lighting apparatus. Other applications include an exposure light source for an electrophotographic image-forming apparatus, a backlight for a liquid crystal display, and a light-emitting apparatus with a color filter in a white light source.

The display apparatus may be an image-information-processing apparatus that includes an image input unit for inputting image information from an area CCD, a linear CCD, a memory card, or the like, includes an information processing unit for processing the input information, and displays an input image on a display unit. The display apparatus

may have a plurality of pixels, and at least one of the pixels may include the organic light-emitting element according to the present embodiment and a transistor coupled to the organic light-emitting element. The substrate may be a semiconductor substrate formed of silicon or the like, and the transistor may be a MOSFET formed on the substrate.

A display unit of an imaging apparatus or an ink jet printer may have a touch panel function. A driving system of the touch panel function may be, but is not limited to, an infrared radiation system, an electrostatic capacitance system, a resistive film system, or an electromagnetic induction system. The display apparatus may be used for a display unit of a multifunction printer.

Next, a display apparatus according to the present embodiment is described with reference to the accompanying drawings.

Figs. 2A and 2B are schematic cross-sectional views of an example of a display apparatus that includes an organic light-emitting element and a transistor coupled to the organic light-emitting element. The transistor is an example of an active element. The transistor may be a thin-film transistor (TFT).

Fig. 2A illustrates an example of a pixel serving as a constructional element of the display apparatus according to the present embodiment. The pixel has subpixels 10. The subpixels are 10R, 10G, and 10B with different emission colors. The emission colors may be distinguished by the wavelength of light emitted from the light-emitting layer, or light emitted from each subpixel may be selectively transmitted or color-converted with a color filter or the like. Each subpixel has, on an interlayer insulating layer 1, a reflective electrode 2 as a first electrode, an insulating layer 3 covering the ends of the reflective electrode 2, organic compound layers 4 covering the first electrode and the insulating layer, a transparent electrode 5, a protective layer 6, and a color filter 7.

A transistor and/or a capacitor element may be provided under or inside the interlayer insulating layer 1. The transistor may be electrically connected to the first electrode via a contact hole (not shown) or the like.

The insulating layer 3 is also referred to as a bank or a pixel separation film. The insulating layer 3 covers the ends of the first electrode and surrounds the first electrode. A portion of the first electrode not covered with the insulating layer is in contact with the organic compound layers 4 and serves as a light-emitting region.

The organic compound layers 4 include a hole-injection layer 41, a hole-transport layer 42, a first light-emitting layer 43, a second light-emitting layer 44, and an electron-transport layer 45.

The second electrode 5 may be a transparent electrode, a reflective electrode, or a semitransparent electrode.

The protective layer 6 reduces the penetration of moisture into the organic compound layers. The protective layer is illustrated as a single layer but may be a plurality of layers. The protective layer 6 may include an inorganic compound layer and an organic compound layer.

The color filter 7 is divided into 7R, 7G, and 7B according to the color. The color filter may be formed on a planarization film (not shown). Furthermore, a resin protective layer (not shown) may be provided on the color filter. The color filter may be formed on the protective layer 6. Alternatively, the color filter 7 may be bonded after being provided on an opposite substrate, such as a glass substrate.

A display apparatus 100 illustrated in Fig. 2B includes an organic light-emitting element 26 and a TFT 18, which is an example of a transistor. The display apparatus 100 includes a substrate 11 made of glass, silicon, or the like and an insulating layer 12 on the substrate 11. An active element, such as the TFT 18, and a gate electrode 13, a gate-insulating film 14, and a semiconductor layer 15 of the active element are provided on the insulating layer 12.

The TFT 18 includes a semiconductor layer 15, a drain electrode 16, and a source electrode 17. The TFT 18 is covered with an insulating film 19. A positive electrode 21 constituting the organic light-emitting element 26 is connected to the source electrode 17 via a contact hole 20.

The method for electrically connecting the electrodes (the positive electrode 21 and a negative electrode 23) of the organic light-emitting element 26 to the electrodes (the source electrode 17 and the drain electrode 16) of the TFT is not limited to the embodiment illustrated in Fig. 2B. More specifically, it is only necessary to electrically connect either the positive electrode 21 or the negative electrode 23 to either the source electrode 17 or the drain electrode 16 of the TFT 18.

Although an organic compound layer 22 is a single layer in the display apparatus 100 illustrated in Fig. 2B, the organic compound layer 22 may be composed of a plurality of layers. The negative electrode 23 is covered with a first protective layer 25 and a second protective layer 24 for reducing degradation of the organic light-emitting element.

Although the display apparatus 100 illustrated in Fig. 2B includes a transistor as a switching element, another switching element, such as a MIM element, may be used instead.

The transistor used in the display apparatus 100 in Fig. 2B is not limited to a thin-film transistor including an active layer on an insulating surface of a substrate and may also be a transistor including a single crystal silicon wafer. The active layer may be single-crystal silicon, non-single-crystal silicon, such as amorphous silicon or microcrystalline silicon, or a non-single-crystal oxide semiconductor, such as indium zinc oxide or indium gallium zinc oxide. The thin-film transistor is also referred to as a TFT element.

The transistor in the display apparatus 100 illustrated in Fig. 2B may be formed within a substrate, such as a Si substrate. The phrase "formed within a substrate" means that the substrate, such as a Si substrate, itself is processed

to form the transistor. Thus, the transistor within the substrate can be considered that the substrate and the transistor are integrally formed.

In the organic light-emitting element according to the present embodiment, the luminous brightness is controlled with the TFT, which is an example of a switching element. The organic light-emitting element can be provided in a plurality of planes to display an image at each luminous brightness. The switching element according to the present embodiment is not limited to the TFT and may be a transistor formed of low-temperature polysilicon or an active-matrix driver formed on a substrate, such as a Si substrate. The phrase "on a substrate" may also be referred to as "within a substrate". Whether a transistor is provided within a substrate or a TFT is used depends on the size of a display unit. For example, for an approximately 0.5-inch display unit, an organic light-emitting element is preferably provided on a Si substrate.

Fig. 3 is a schematic view of an example of the display apparatus according to the present embodiment. A display apparatus 1000 may include a touch panel 1003, a display panel 1005, a frame 1006, a circuit substrate 1007, and a battery 1008 between an upper cover 1001 and a lower cover 1009. The touch panel 1003 and the display panel 1005 are coupled to flexible print circuits FPC 1002 and 1004, respectively. Transistors are printed on the circuit substrate 1007. The battery 1008 is not necessarily provided when the display apparatus is not a mobile device, or may be provided at another position even when the display apparatus is a mobile device.

The display apparatus according to the present embodiment may be used for a display unit of an imaging apparatus that includes an optical unit with a plurality of lenses and an imaging element for receiving light passing through the optical unit. The imaging apparatus may include a display unit for displaying information acquired by the imaging element. The display unit may be a display unit exposed outside from the imaging apparatus or a display unit located in a finder. The imaging apparatus may be a digital camera or a digital video camera. The imaging apparatus may also be referred to as a photoelectric conversion apparatus.

Fig. 4A is a schematic view of an example of an imaging apparatus according to the present embodiment. An imaging apparatus 1100 may include a viewfinder 1101, a rear display 1102, an operating unit 1103, and a housing 1104. The viewfinder 1101 may include the display apparatus according to the present embodiment. In such a case, the display apparatus may display environmental information, imaging instructions, and the like as well as an image to be captured. The environmental information may include the intensity of external light, the direction of external light, the travel speed of the photographic subject, the possibility that the photographic subject is shielded by a shielding material, and the like.

Because the appropriate timing for imaging is a short time, it is better to display information as early as possible. Thus, a display apparatus including the organic light-emitting element according to the present embodiment can be used. This is because the organic light-emitting element has a high response speed. A display apparatus including the organic light-emitting element can be more suitably used than these apparatuses and liquid crystal displays that require a high display speed.

The imaging apparatus 1100 includes an optical unit (not shown). The optical unit has a plurality of lenses and focuses an image on an imaging element in the housing 1104. The focus of the lenses can be adjusted by adjusting their relative positions. This operation can also be automatically performed.

The display apparatus according to the present embodiment may include color filters of red, green, and blue colors. In the color filters, the red, green, and blue colors may be arranged in a delta arrangement.

The display apparatus according to the present embodiment may be used for a display unit of electronic equipment, such as a mobile terminal. Such a display apparatus may have both a display function and an operation function. Examples of the mobile terminal include mobile phones, such as smartphones, tablets, and head-mounted displays.

Fig. 4B is a schematic view of an example of electronic equipment according to the present embodiment. Electronic equipment 1200 includes a display unit 1201, an operating unit 1202, and a housing 1203. The housing 1203 may include a circuit, a printed circuit board including the circuit, a battery, and a communication unit. The operating unit 1202 may be a button or a touch panel response unit. The operating unit may be a biometric recognition unit that recognizes a fingerprint and releases the lock. Electronic equipment with a communication unit may also be referred to as communication equipment.

Figs. 5A and 5B are schematic views of an example of the display apparatus according to the present embodiment. Fig. 5A illustrates a display apparatus, such as a television monitor or a PC monitor. A display apparatus 1300 includes a frame 1301 and a display unit 1302. The light-emitting apparatus according to the present embodiment may be used for the display unit 1302. The display apparatus 1300 includes a base 1303 for supporting the frame 1301 and the display unit 1302. The base 1303 is not limited to the structure illustrated in Fig. 5A. The lower side of the frame 1301 may also serve as the base. The frame 1301 and the display unit 1302 may be bent so that the display surface of the display unit 1302 is curved. The radius of curvature thereof may be 5000 mm or more and 6000 mm or less.

Fig. 5B is a schematic view of another example of the display apparatus according to the present embodiment. A display apparatus 1310 in Fig. 5B is configured to be foldable and is a so-called foldable display apparatus. The display

apparatus 1310 includes a first display unit 1311, a second display unit 1312, a housing 1313, and a folding point 1314. The first display unit 1311 and the second display unit 1312 may include the light-emitting apparatus according to the present embodiment. The first display unit 1311 and the second display unit 1312 may be a single display apparatus without a joint. The first display unit 1311 and the second display unit 1312 can be divided by the folding point. The first display unit 1311 and the second display unit 1312 may display different images or one image.

Fig. 6A is a schematic view of an example of a lighting apparatus according to the present embodiment. A lighting apparatus 1400 may include a housing 1401, a light source 1402, a circuit substrate 1403, an optical film 1404 that transmits light emitted by the light source 1402, and a light-diffusing unit 1405. The light source 1402 may include the organic light-emitting element according to the present embodiment. An optical filter may be a filter for improving the color rendering properties of the light source. The light-diffusing unit can effectively diffuse light from the light source and widely spread light as in illumination. The optical filter and the light-diffusing unit may be provided on the light output side of the lighting apparatus. If necessary, a cover may be provided on the outermost side.

For example, the lighting apparatus is an interior lighting apparatus. The lighting apparatus may emit white light, neutral white light, or light of any color from blue to red. The lighting apparatus may have a light control circuit for controlling such light or a color control circuit for controlling emission color. The lighting apparatus may include the organic light-emitting element according to the present embodiment and a power supply circuit coupled thereto. The power supply circuit is a circuit that converts an AC voltage to a DC voltage. White has a color temperature of 4200 K, and neutral white has a color temperature of 5000 K. The lighting apparatus may have a color filter.

The lighting apparatus according to the present embodiment may include a heat dissipation unit. The heat dissipation unit releases heat from the apparatus to the outside and may be a metal or liquid silicon with a high specific heat.

Fig. 6B is a schematic view of an automobile as an example of a moving body according to the present embodiment. The automobile has a taillight as an example of a lamp. An automobile 1500 may have a taillight 1501, which comes on when a brake operation or the like is performed.

The taillight 1501 may include the organic light-emitting element according to the present embodiment. The taillight 1501 may have a protective member for protecting an organic EL element. The protective member may be formed of any transparent material with moderately high strength and is preferably formed of polycarbonate or the like. The polycarbonate may be mixed with a furan dicarboxylic acid derivative, an acrylonitrile derivative, or the like.

The automobile 1500 may have a body 1503 and a window 1502 on the body 1503. The window 1502 may be a transparent display as long as it is not a window for checking the front and rear of the automobile. The transparent display may include the organic light-emitting element according to the present embodiment. In such a case, constituent materials, such as electrodes, of the organic light-emitting element are transparent materials.

The moving body according to the present embodiment may be a ship, an aircraft, a drone, or the like. The moving body may include a body and a lamp provided on the body. The lamp may emit light to indicate the position of the body. The lamp includes the organic light-emitting element according to the present embodiment.

Application examples of the display apparatus according to one of the embodiments are described below with reference to Figs. 7A and 7B. The display apparatus can be applied to a system that can be worn as a wearable device, such as smart glasses, a head-mounted display (HMD), or smart contact lenses. An imaging and displaying apparatus used in such an application example includes an imaging apparatus that can photoelectrically convert visible light and a display apparatus that can emit visible light.

Fig. 7A illustrates glasses 1600 (smart glasses) according to one application example. An imaging apparatus 1602, such as a complementary metal-oxide semiconductor (CMOS) sensor or a single-photon avalanche photodiode (SPAD), is provided on the front side of a lens 1601 of the glasses 1600. The display apparatus according to one of the embodiments is provided on the back side of the lens 1601.

The glasses 1600 further include a controller 1603. The controller 1603 functions as a power supply for supplying power to the imaging apparatus 1602 and the display apparatus according to one of the embodiments. The controller 1603 controls the operation of the imaging apparatus 1602 and the display apparatus. The lens 1601 has an optical system for focusing light on the imaging apparatus 1602.

Fig. 7B illustrates glasses 1610 (smart glasses) according to one application example. The glasses 1610 have a controller 1612, which includes an imaging apparatus corresponding to the imaging apparatus 1602 and a display apparatus. A lens 1611 includes an optical system for projecting light from the imaging apparatus of the controller 1612 and the display apparatus, and an image is projected on the lens 1611. The controller 1612 functions as a power supply for supplying power to the imaging apparatus and the display apparatus and controls the operation of the imaging apparatus and the display apparatus. The controller may include a line-of-sight detection unit for detecting the line of sight of the wearer. Infrared radiation may be used to detect the line of sight. An infrared radiation unit emits infrared light to an eyeball of a user who is gazing at a display image. Reflected infrared light from the eyeball is detected by an imaging unit including a light-receiving element to capture an image of the eyeball. A reduction unit for reducing light from the infrared radiation unit to a display unit in a plan view is provided to reduce degradation in image quality.

The line of sight of the user for the display image is detected from the image of the eyeball captured by infrared

imaging. Any known technique can be applied to line-of-sight detection using the image of the eyeball. For example, it is possible to use a line-of-sight detection method based on a Purkinje image obtained by the reflection of irradiation light by the cornea.

More specifically, a line-of-sight detection process based on a pupil-corneal reflection method is performed. The line of sight of the user is detected by calculating a line-of-sight vector representing the direction (rotation angle) of an eyeball on the basis of an image of a pupil and a Purkinje image included in a captured image of the eyeball using the pupil-corneal reflection method.

A display apparatus according to an embodiment of the present invention may include an imaging apparatus including a light-receiving element and may control a display image on the basis of line-of-sight information of a user from the imaging apparatus.

More specifically, on the basis of the line-of-sight information, the display apparatus determines a first visibility region at which the user gazes and a second visibility region other than the first visibility region. The first visibility region and the second visibility region may be determined by the controller of the display apparatus or may be received from an external controller. In the display region of the display apparatus, the first visibility region may be controlled to have higher display resolution than the second visibility region. In other words, the second visibility region may have lower resolution than the first visibility region.

The display region has a first display region and a second display region different from the first display region, and the priority of the first display region and the second display region depends on the line-of-sight information. The first visibility region and the second visibility region may be determined by the controller of the display apparatus or may be received from an external controller. A region with a higher priority may be controlled to have higher resolution than another region. In other words, a region with a lower priority may have lower resolution.

The first visibility region or a region with a higher priority may be determined by artificial intelligence (AI). The AI may be a model configured to estimate the angle of the line of sight and the distance to a target ahead of the line of sight from an image of an eyeball using the image of the eyeball and the direction in which the eyeball actually viewed in the image as teaching data. The AI program may be stored in the display apparatus, the imaging apparatus, or an external device. The AI program stored in an external device is transmitted to the display apparatus via communication.

For display control based on visual recognition detection, the present disclosure can be applied to smart glasses further having an imaging apparatus for imaging the outside. Smart glasses can display captured external information in real time.

Fig. 8 is a schematic view of an example of an image-forming apparatus according to the present embodiment. An image-forming apparatus 40 is an electrophotographic image-forming apparatus and includes a photosensitive member 27, an exposure light source 28, a charging unit 30, a developing unit 31, a transfer unit 32, a conveying roller 33, and a fixing unit 35. The exposure light source 28 emits light 29, and an electrostatic latent image is formed on the surface of the photosensitive member 27. The exposure light source 28 includes the organic light-emitting element according to the present embodiment. The developing unit 31 contains toner and the like. The charging unit 30 electrifies the photosensitive member 27. The transfer unit 32 transfers a developed image onto a recording medium 34. The conveying roller 33 conveys the recording medium 34. The recording medium 34 is paper, for example. The fixing unit 35 fixes an image on the recording medium 34.

Figs. 9A and 9B are schematic views of the exposure light source 28, wherein a plurality of light-emitting portions 36 are arranged on a long substrate. An arrow 37 indicates a longitudinal direction in which the organic light-emitting elements are arranged. This column direction is the same as the direction of the rotation axis of the photosensitive member 27. This direction can also be referred to as the major-axis direction of the photosensitive member 27. In Fig. 9A, the light-emitting portions 36 are arranged in the major-axis direction of the photosensitive member 27. In Fig. 9B, unlike Fig. 9A, the light-emitting portions 36 are alternately arranged in the column direction in the first and second columns. The first and second columns are arranged at different positions in the row direction. In the first column, the light-emitting portions 36 are arranged at intervals. In the second column, the light-emitting portions 36 are arranged at positions corresponding to the spaces between the light-emitting portions 36 of the first column. Thus, the light-emitting portions 36 are also arranged at intervals in the row direction. The arrangement in Fig. 9B can also be referred to as a grid-like pattern, a staggered pattern, or a checkered pattern, for example.

As described above, an apparatus including the organic light-emitting element according to the present embodiment can be used to stably display a high-quality image for extended periods.

## Exemplary Embodiments

[Synthesis Examples 1 to 9 (Synthesis of Exemplary Compounds)]

Each exemplary compound was synthesized on the basis of the synthesis process described in Patent Literature 1 to Patent Literature 3. Table 3 shows exemplary compounds synthesized in Synthesis Examples 1 to 6, and Table 4

shows exemplary compounds synthesized in Synthesis Examples 1 to 6. Measured values m/z of measured mass spectrometry results are shown.

[Table 3]

Table 3

| Synthesis example | Exemplary compound | m/z | Synthesis example | Exemplary compound | m/z |
|---|---|---|---|---|---|
| 1 | 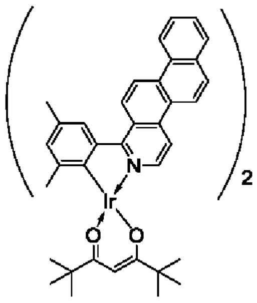 KK-101 | 1,040 | 4 | 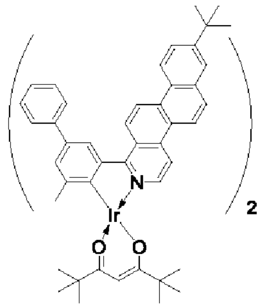 KK-107 | 1,277 |
| 2 | 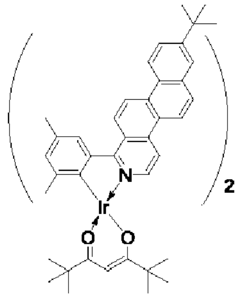 KK-103 | 1,153 | 5 | 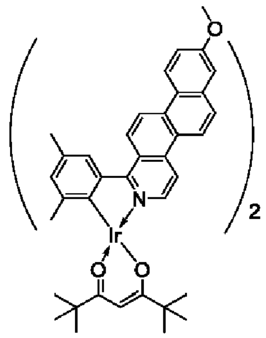 KK-122 | 1,100 |
| 3 | 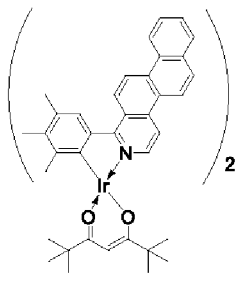 KK-104 | 1,068 | 6 | 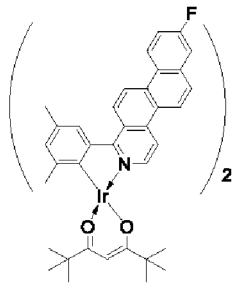 KK-125 | 1,076 |

[Table 4]

Table 4

| Synthesis example | Exemplary compound | m/z | Synthesis example | Exemplary compound | m/z |
|---|---|---|---|---|---|
| 7 | 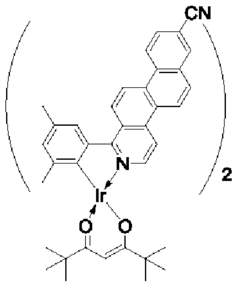 KK-127 | 1,090 | 5 | 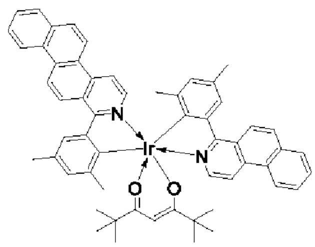 KK-138 | 990 |
| 8 | 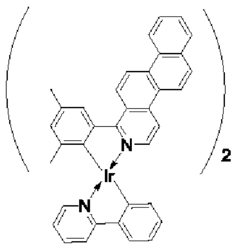 KK-128 | 1,011 | 6 | 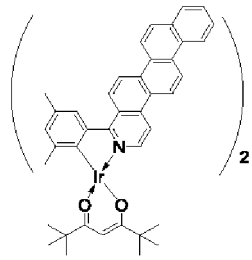 KK-151 | 1,140 |
| 9 | 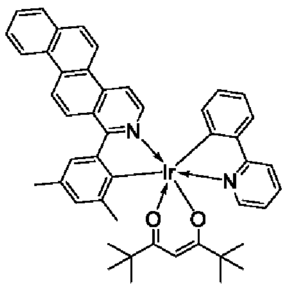 KK-134 | 862 | 7 | 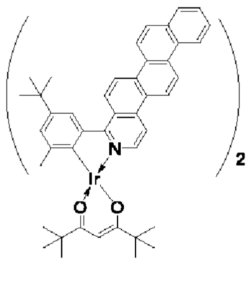 KK-156 | 1,225 |

[Exemplary Embodiment 1]

An organic light-emitting element of a bottom emission type was produced. The organic light-emitting element included a positive electrode, a hole-injection layer, a hole-transport layer, an electron-blocking layer, a light-emitting layer, a hole-blocking layer, an electron-transport layer, an electron-injection layer, and a negative electrode sequentially formed on a substrate.

First, an ITO film was formed on a glass substrate and was subjected to desired patterning to form an ITO electrode (positive electrode). The ITO electrode had a thickness of 100 nm. The substrate on which the ITO electrode was formed was used as an ITO substrate in the following process. Vacuum evaporation was then performed by resistance heating in a vacuum chamber at $1.33 \times 10^{-4}$ Pa to continuously form an organic compound layer and an electrode layer shown in Table 5 on the ITO substrate. The counter electrode (a metal electrode layer, a negative electrode) had an electrode area of 3 $mm^2$.

[Table 5]

Table 5

| | | | Material | Ratio in light-emitting layer (mass%) | Thickness (nm) |
|---|---|---|---|---|---|
| Electrode layer | Negative electrode | | Al | - | 100 |
| Organic compound layer | Electron-injection layer (EIL) | | LiF | - | 1 |
| | Electron-transport layer (ETL) | | ET2 | - | 20 |
| | Hole-blocking layer (HBL) | | ET11 | - | 20 |
| | Light-emitting layer (EML) | Host | K-104 | 88 | 20 |
| | | Guest | KK-103 | 12 | |
| | Electron-blocking layer (EBL) | | HT19 | - | 15 |
| | Hole-transport layer (HTL) | | HT3 | - | 30 |
| | Hole-injection layer (HIL) | | HT16 | - | 5 |

The characteristics of the element were measured and evaluated. The element had a light emission efficiency of 24 cd/A and emitted red light with chromaticity (X, Y) = (0.69, 0.32). Furthermore, a continuous operation test was performed at a current density of 100 mA/cm$^2$, and the luminance half-life (LT50) was measured to be 430 hours.

In the present exemplary embodiment, with respect to measuring apparatuses, more specifically, the current-voltage characteristics were measured with a microammeter 4140B manufactured by Hewlett-Packard Co., and the luminous brightness was measured with BM7 manufactured by Topcon Corporation.

[Exemplary Embodiments 2 to 22 and Comparative Examples 1 to 9]

Organic light-emitting elements were produced in the same manner as in Exemplary Embodiment 1 except that the materials forming each layer were appropriately changed to the compounds shown in Table 6. A layer not shown in Table 6 had the same structure as in Exemplary Embodiment 1. Characteristics of the elements were measured and evaluated in the same manner as in Exemplary Embodiment 1. Table 6 shows the measurement results together with the measurement results of Exemplary Embodiment 1.

The structures of Comparative Compounds R-101, KK-28, and KK-31 used in comparative examples are shown below.

[Chem. 62]

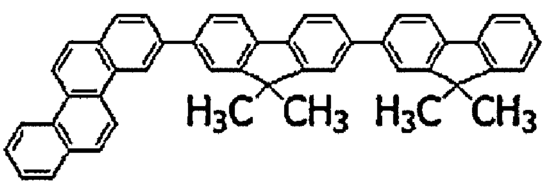

R-101

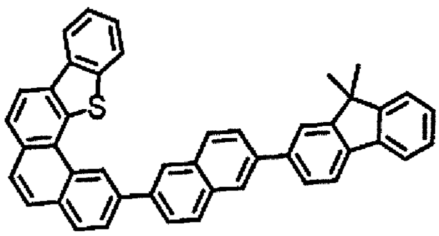

R-102

[Chem. 63]

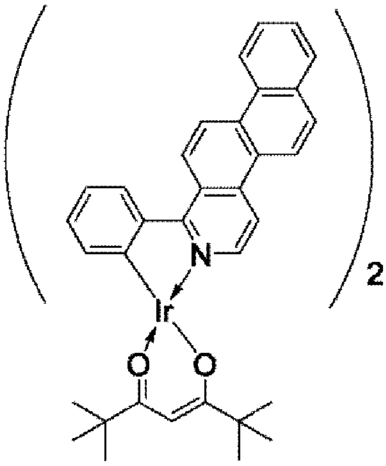

KK-28

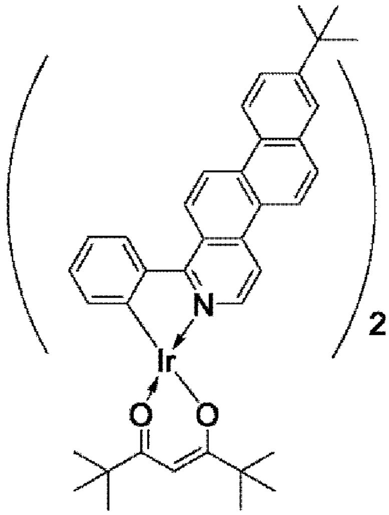

KK-31

[Table 6]

Table 6

| | HTL | EBL | EML | | HBL | ETL | Efficiency [cd/A] | Luminance half-life [h] |
|---|---|---|---|---|---|---|---|---|
| | | | Host | Guest | | | | |
| Exemplary embodiment 1 | HT1 | HT7 | K-104 | KK-103 | ET11 | ET2 | 25 | 430 |
| Comparative example 1 | HT1 | HT7 | K-104 | K K-31 | ET11 | ET2 | 23 | 400 |
| Exemplary embodiment 2 | HT1 | HT7 | L-104 | KK-101 | ET11 | ET2 | 23 | 910 |
| Comparative example 2 | HT1 | HT7 | L-104 | KK-28 | ET11 | ET2 | 22 | 700 |
| Exemplary embodiment 3 | HT3 | HT10 | L-104 | KK-103 | ET12 | ET7 | 24 | 920 |
| Exemplary embodiment 4 | HT2 | HT12 | L-104 | KK-104 | ET10 | ET2 | 23 | 895 |
| Exemplary embodiment 5 | HT1 | HT7 | L-104 | KK-107 | ET11 | ET2 | 23 | 910 |
| Exemplary embodiment 6 | HT2 | HT7 | L-104 | KK-122 | ET11 | ET2 | 23 | 870 |
| Exemplary embodiment 7 | HT2 | HT8 | L-104 | KK-125 | ET12 | ET3 | 24 | 885 |
| Exemplary embodiment 8 | HT1 | HT12 | L-104 | KK-127 | ET11 | ET2 | 23 | 865 |
| Exemplary embodiment 9 | HT3 | HT10 | L-104 | KK-128 | ET10 | ET2 | 23 | 935 |
| Exemplary embodiment 10 | HT2 | HT8 | L-104 | KK-134 | ET10 | ET3 | 23 | 900 |
| Exemplary embodiment 11 | HT1 | HT7 | L-104 | KK-151 | ET11 | ET2 | 25 | 920 |
| Comparative example 3 | HT1 | HT7 | R-101 | KK-101 | ET11 | ET2 | 23 | 300 |
| Comparative example 4 | HT1 | HT7 | R-101 | KK-28 | ET11 | ET2 | 23 | 300 |
| Exemplary embodiment 13 | HT2 | HT7 | H-131 | KK-101 | ET10 | ET2 | 24 | 880 |
| Comparative example 5 | HT2 | HT7 | H-131 | KK-28 | ET10 | ET2 | 23 | 680 |
| Comparative example 6 | HT2 | HT7 | R-102 | KK-103 | ET11 | ET2 | 24 | 320 |
| Comparative example 7 | HT2 | HT7 | R-102 | K K-31 | ET11 | ET2 | 24 | 320 |

(continued)

| | HTL | EBL | EML | | HBL | ETL | Efficiency [cd/A] | Luminance half-life [h] |
|---|---|---|---|---|---|---|---|---|
| | | | Host | Guest | | | | |
| Exemplary embodiment 14 | HT2 | HT7 | H-424 | KK-103 | ET11 | ET2 | 25 | 800 |
| Comparative example 8 | HT2 | HT7 | H-424 | K K-31 | ET11 | ET2 | 24 | 640 |
| Exemplary embodiment 15 | HT2 | HT7 | H-712 | KK-103 | ET11 | ET2 | 25 | 800 |
| Comparative example 9 | HT2 | HT7 | H-712 | K K-31 | ET11 | ET2 | 24 | 730 |
| Exemplary embodiment 16 | HT3 | HT10 | H-131 | KK-103 | ET12 | ET7 | 26 | 890 |
| Exemplary embodiment 17 | HT1 | HT7 | H-131 | KK-107 | ET11 | ET2 | 25 | 880 |
| Exemplary embodiment 18 | HT2 | HT8 | H-131 | KK-125 | ET12 | ET3 | 26 | 855 |
| Exemplary embodiment 19 | HT3 | HT10 | H-131 | KK-128 | ET10 | ET2 | 25 | 905 |
| Exemplary embodiment 20 | HT2 | HT8 | H-131 | KK-134 | ET10 | ET3 | 25 | 870 |
| Exemplary embodiment 21 | HT2 | HT7 | H-131 | KK-151 | ET10 | ET2 | 25 | 900 |
| Exemplary embodiment 22 | HT2 | HT7 | H-131 | KK-160 | ET10 | ET2 | 25 | 880 |

Comparative Examples 3 and 4 were organic light-emitting elements containing Comparative Compound R-101 as a host, and Comparative Examples 6 and 7 were organic light-emitting elements containing Comparative Compound R-102. Comparative Compounds R-101 and R-102 are compounds with an alkyl group. It has been found that, when a compound with an alkyl group is used as a host, the effect of improving operational durability is not sufficiently exhibited even when a guest is a compound represented by the general formula [1] in which the partial structure $Ir(L)_m$ is represented by the general formula [1-5] and L' denotes a compound represented by the general formula [1-3]. This is probably because the alkyl group of the compound used as the host inhibits the interaction between host molecules, as described above. Thus, the effect of reducing the interaction between the host and the iridium complex and reducing the formation of an exciplex and a radical state by a substituent other than hydrogen at $R_1$ in the general formula [1-1] is not sufficiently exhibited.

The luminance half-life was shorter in Comparative Example 1 than in Exemplary Embodiment 1, in Comparative Example 2 than in Exemplary Embodiment 2, in Comparative Example 5 than in Exemplary Embodiment 13, in Comparative Example 8 than in Exemplary Embodiment 14, and in Comparative Example 9 than in Exemplary Embodiment 15. The compounds used as hosts in these exemplary embodiments and comparative examples are compounds represented by the general formula [2] without an alkyl group and with a tricyclic or higher polycyclic fused-ring skeleton. It has been found that the luminance half-life is shortened when such a compound is used as a host and when an iridium complex with a partial structure in which $R_1$ in the general formula [1-1] and the general formula [1-2] is hydrogen is used as a guest (Comparative Examples 1, 2, 5, 8, and 9). On the other hand, it has been found that the luminance half-life is improved when an iridium complex with a partial structure in which $R_1$ in the general formula [1-1] or the general formula [1-2] is a substituent other than hydrogen is used as a guest (Exemplary Embodiments 1, 2, 13, 14, and 15). This is probably because the substituent reduces the interaction between the host and the iridium complex and reduces the formation of an exciplex and a radical state, as described above.

Table 1 shows the maximum values of the dihedral angles of the compounds used as hosts in Exemplary Embodiments 1, 2, 13, 14, and 15. Tables 1 and 6 show that the operational durability is particularly improved when the maximum value of the dihedral angle of the compound (second compound) used as a host is 26 degrees or less.

Also in other exemplary embodiments, a long luminance half-life was obtained by using an iridium complex with a partial structure in which $R_1$ in the general formula [1-1] or the general formula [1-2] is a substituent other than hydrogen as a guest.

The present invention is not limited to these embodiments, and various changes and modifications may be made therein without departing from the spirit and scope of the present invention. Accordingly, the following claims are attached to make the scope of the present invention public.

This application claims the benefit of Japanese Patent Application No. 2021-086666 filed May 24, 2021, which is hereby incorporated by reference herein in its entirety.

Reference Signs List

1 organic light-emitting element
11 substrate
21 positive electrode
22 organic compound layer
23 negative electrode

## Claims

**1.** An organic light-emitting element comprising: a positive electrode; a negative electrode; and a light-emitting layer between the positive electrode and the negative electrode, wherein

the light-emitting layer contains a first compound represented by the following general formula [1] and a second compound represented by the following general formula [2] .
[Chem. 1]

$$IrL_mL'_n \qquad [1]$$

[Chem. 2]

$$(Ar_1)\!-\!(Ar_2)_p\!-\!(Ar_3)_q\!-\!(Ar_4) \qquad [2]$$

(in the general formula [1], Ir denotes iridium, L and L' denote different bidentate ligands, m is any one of 1 to 3, n is any one of 0 to 2, and m + n = 3, the partial structure $Ir(L)_m$ is a partial structure represented by the following general formula [1-1] or [1-2], and L' denotes a bidentate ligand represented by the following general formula [1-3] or [1-4]:

[Chem. 3]

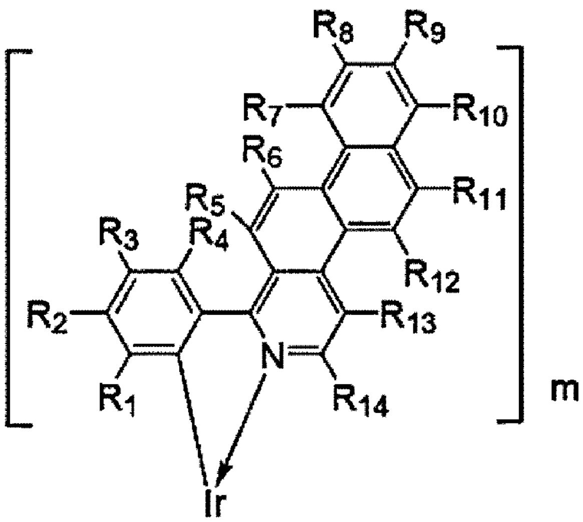

[1-1]

[Chem. 4]

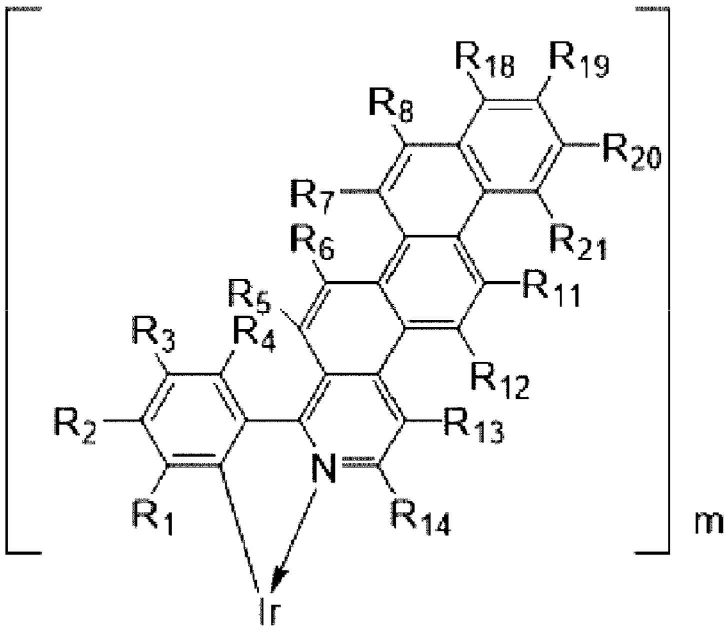

[1-2]

[Chem. 5]

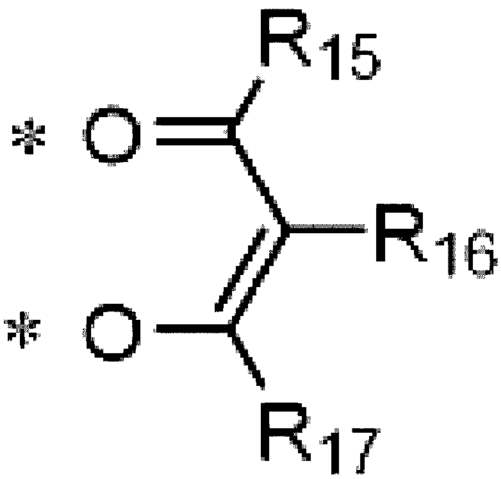

[1-3]

[Chem. 6]

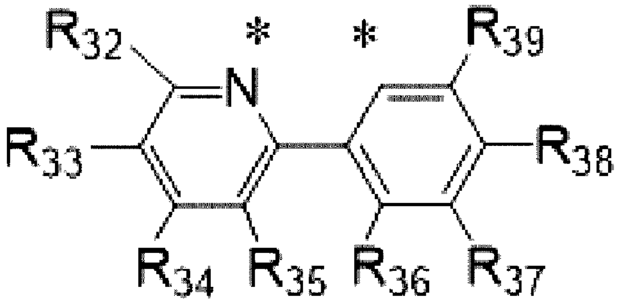

[1-4]

(in the general formula [1-1], $R_1$ denotes any one of a fluorine atom, an alkyl group, a deuterium-substituted alkyl group, an alkoxy group, a silyl group, an aryl group, and a heterocyclic group, in the general formulae [1-1] and [1-2], $R_2$ to $R_{14}$ and $R_{18}$ to $R_{21}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_1$ to $R_4$ may form a ring, in the general formula [1-3], $R_{15}$ to $R_{17}$ are each independently selected from a hydrogen atom, a deuterium atom, a substituted or unsubstituted alkyl group, a deuterium-substituted alkyl group, an alkoxy group, a substituted amino group, a substituted or unsubstituted aryl group, and a substituted or unsubstituted heterocyclic group, in the general formula [1-4], $R_{32}$ to $R_{39}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_{32}$ to $R_{39}$ may form a ring))

(in the general formula [2], p and q are each independently any one of 0, 1, and 2 and satisfy the following relational expression:

$$0 \leq p + q \leq 4$$

in the general formula [2], $Ar_1$ to $Ar_4$ are each independently selected from benzene, naphthalene, phenanthrene, chrysene, triphenylene, picene, fluoranthene, and a compound represented by the following general formula [2-1], each of which has no alkyl group as a substituent, and at least one of $Ar_1$ to $Ar_4$ denotes any one of phenanthrene, chrysene, triphenylene, picene, fluoranthene, and a compound represented by the general formula [2-1],

[Chem. 7]

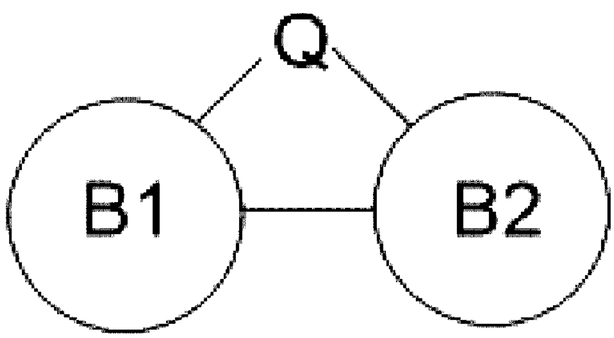

[2-1]

(in the general formula [2-1], Q denotes any one of an oxygen atom, a sulfur atom, and a nitrogen atom, a ring B1 and a ring B2 are each independently selected from a hydrocarbon aromatic ring and a heterocycle, the ring B1 and the ring B2 may have a substituent, and Q may have an aryl group or a heterocyclic group as a substituent when Q denotes a nitrogen atom, and Q, the ring B1, and the ring B2 adjacent to each other may form a ring directly or via a substituent))

2. The organic light-emitting element according to Claim 1, wherein $R_1$ in the general formulae [1-1] and [1-2] denotes a methyl group.

3. The organic light-emitting element according to Claim 2, wherein $R_3$ in the general formulae [1-1] and [1-2] is each independently selected from an aryl group and a heterocyclic group, and at least one of $R_2$ to $R_{13}$ and $R_{18}$ to $R_{21}$ denotes any one of an i-propyl group, a tert-butyl group, a fluorine group, and a fluorine-substituted alkyl group.

4. The organic light-emitting element according to any one of Claims 1 to 3, wherein the largest dihedral angle between adjacent two of $Ar_1$ to $Ar_4$ in the general formula [2] is 26 degrees or less.

5. The organic light-emitting element according to any one of Claims 1 to 4, wherein $Ar_1$ to $Ar_4$ in the general formula [2] are each independently selected from benzene, naphthalene, phenanthrene, chrysene, triphenylene, picene, and fluoranthene, each of which has no alkyl group as a substituent, and at least one of $Ar_1$ to $Ar_4$ denotes phen-

anthrene, chrysene, triphenylene, picene, or fluoranthene.

**6.** The organic light-emitting element according to any one of Claims 1 to 4, wherein at least one of $Ar_1$ to $Ar_4$ in the general formula [2] is a compound represented by the general formula [5].

**7.** The organic light-emitting element according to Claim 6, wherein at least one of $Ar_1$ to $Ar_4$ in the general formula [2] denotes any one of the following group A1.

[Chem. 8]

[Group A1]

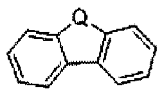
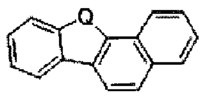
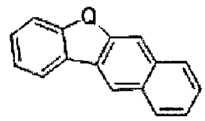
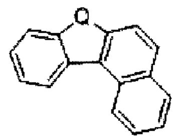
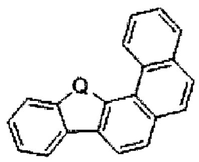
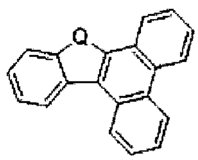
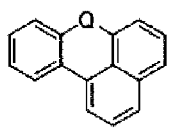
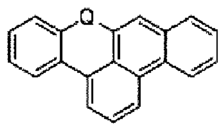
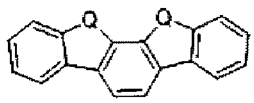
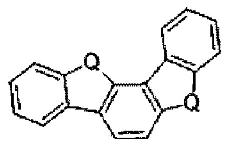
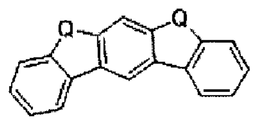
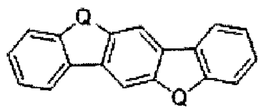
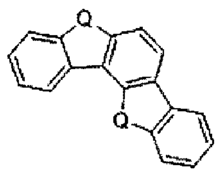
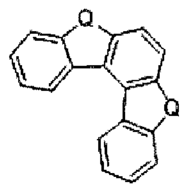
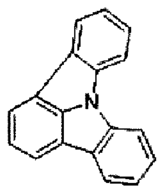
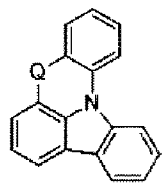
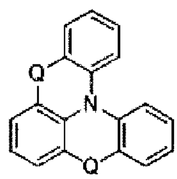
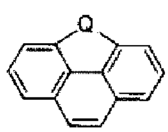
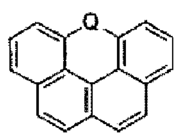

(in the group A1, Q denotes any one of an oxygen atom, a sulfur atom, and a nitrogen atom, and Q may have an aryl group or a heterocyclic group when Q denotes a nitrogen atom)

**8.** The organic light-emitting element according to Claim 6 or 7, wherein the second compound is a compound represented by any one of the following general formulae [8] to [13].

[Chem. 9]

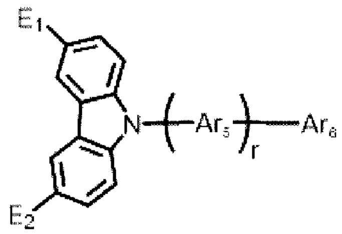
[8]

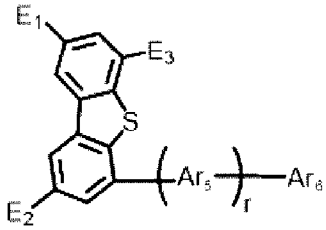
[9]

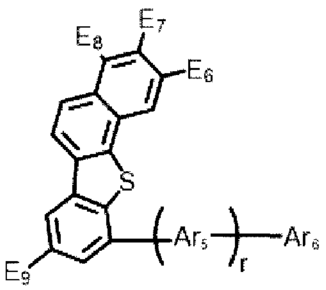
[10]

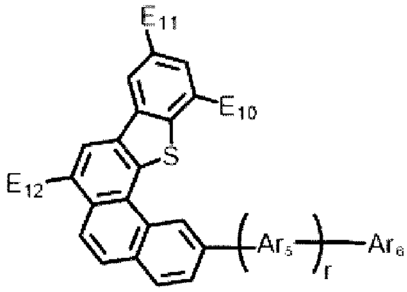
[11]

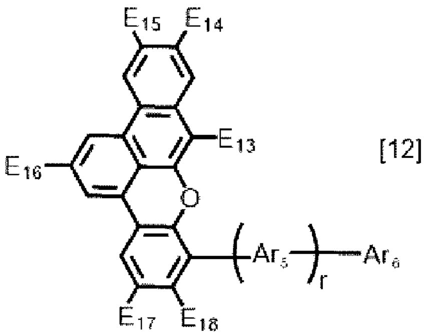
[12]

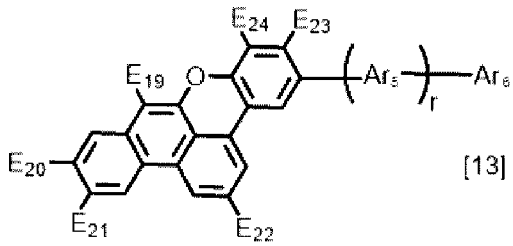
[13]

(in the general formulae [8] to [13], r is an integer in the range of 0 to 4, $Ar_5$ and $Ar_6$ are each independently selected from benzene, naphthalene, phenanthrene, chrysene, triphenylene, picene, fluoranthene, and a compound represented by the general formula [2-1], each of which has no alkyl group as a substituent, a plurality of $Ar_5$s may be the same or different when r is 2 or more, $E_1$ to $E_{24}$ are each independently selected from a hydrogen atom and a substituted or unsubstituted aromatic hydrocarbon group, and $E_1$ to $E_{24}$ have no alkyl group as a substituent)

**9.** The organic light-emitting element according to any one of Claims 1 to 8, wherein in the light-emitting layer, a weight ratio of the second compound to a group of compounds contained in the light-emitting layer is higher than a weight ratio of the first compound to the group of compounds contained in the light-emitting layer.

**10.** An organometallic complex represented by the following general formula [1].
[Chem. 10]

$IrL_mL'_n$ [1]

(in the general formula [1], Ir denotes iridium, L and L' denote different bidentate ligands, m is 1 or 2, n is 2 when m is 1, and n is 1 when m is 2, and the partial structure $Ir(L)_m$ is a partial structure represented by the

following general formula [1-5], and L' denotes a bidentate ligand represented by the following general formula [1-4]:

[Chem. 11]

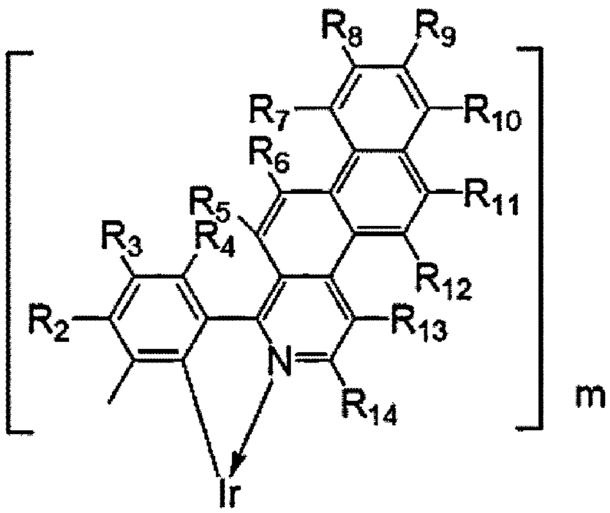

[1-5]

[Chem. 12]

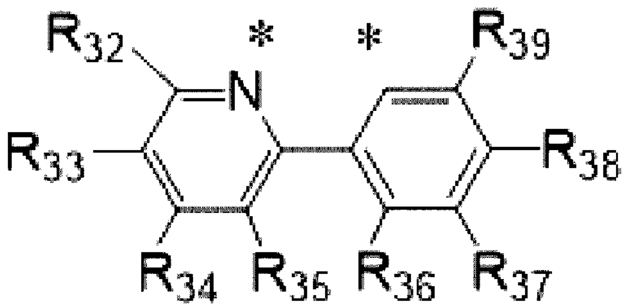

[1-4]

(in the general formula [1-5], $R_2$ to $R_{14}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_2$ to $R_4$ may form a ring, in the general formula [1-4], $R_{32}$ to $R_{39}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_{32}$ to $R_{39}$ may form a ring)

**11.** An organometallic complex represented by the following general formula [3].
[Chem. 13]

IrLL'L" [3]

(in the general formula [3], Ir denotes iridium, L, L', and L" denote different bidentate ligands, the partial structure Ir(L) is a partial structure represented by the following general formula [3-1], L' denotes a bidentate ligand represented by the following general formula [1-3], and L" denotes a bidentate ligand represented by the following general formula [1-4],

[Chem. 14]

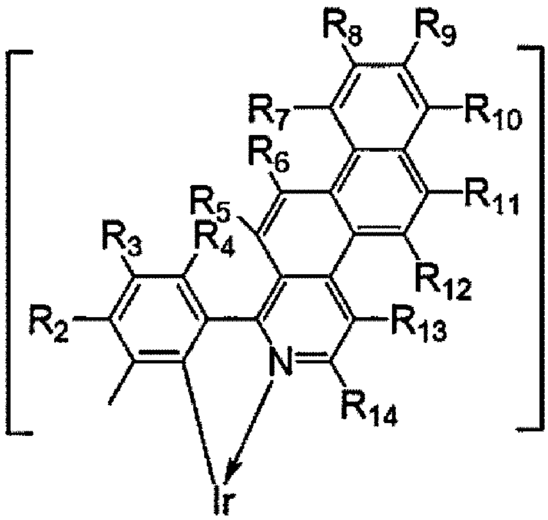

[3-1]

[Chem. 15]

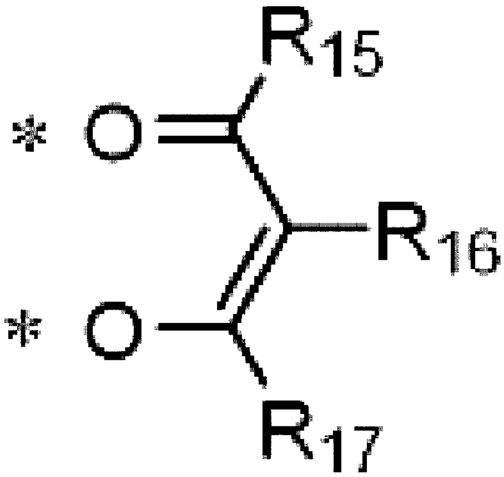

[1-3]

[Chem. 16]

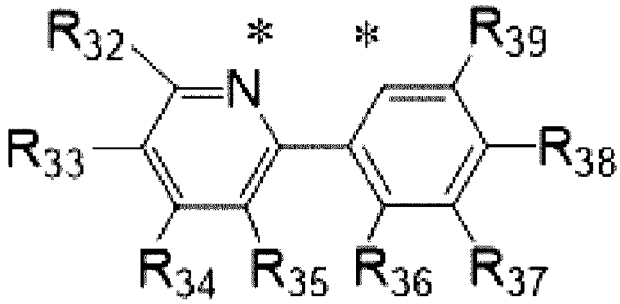

[1-4]

(in the general formula [3-1], $R_2$ to $R_{14}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_2$ to $R_4$ may form a ring, in the general formula [1-3], $R_{15}$ to $R_{17}$ are each independently selected from a hydrogen atom, a deuterium atom, a fluorine atom, a substituted or unsubstituted alkyl group, a deuterium-substituted alkyl group, an alkoxy group, a substituted amino group, a substituted or unsubstituted aryl group, and a substituted or unsubstituted heterocyclic group, in the general formula [1-4J, $R_{32}$ to $R_{39}$ are each independently selected from a hydrogen atom, a deuterium atom, a fluorine atom, a substituted or

unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_{32}$ to $R_{39}$ may form a ring))

**12.** An organometallic complex represented by the following general formula [1].
[Chem. 17]

$IrL_mL'_n$ [1]

(in the general formula [1], Ir denotes iridium, L and L' denote different bidentate ligands, m is 1 or 2, n is 2 when m is 1, and n is 1 when m is 2, and the partial structure $Ir(L)_m$ is a partial structure represented by the following general formula [1-2], and L' denotes a bidentate ligand represented by the following general formula [1-3] or [1-4]:

[Chem. 18]

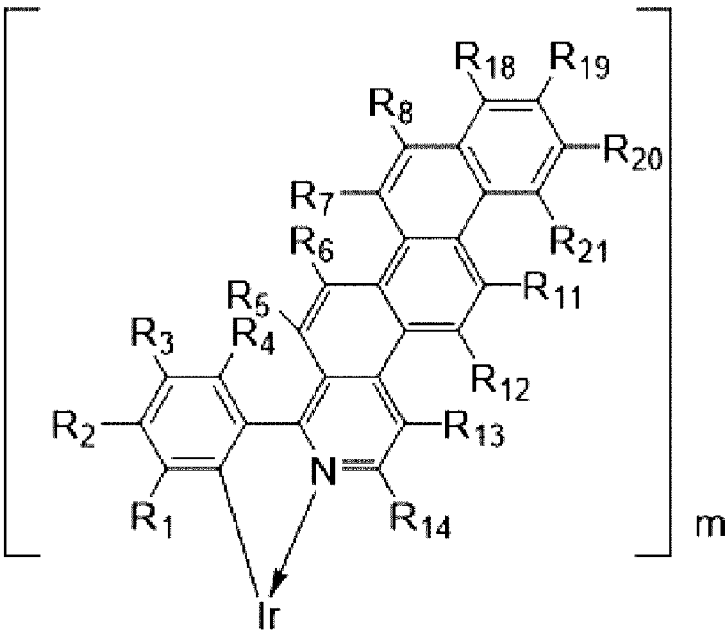

[1-2]

[Chem. 19]

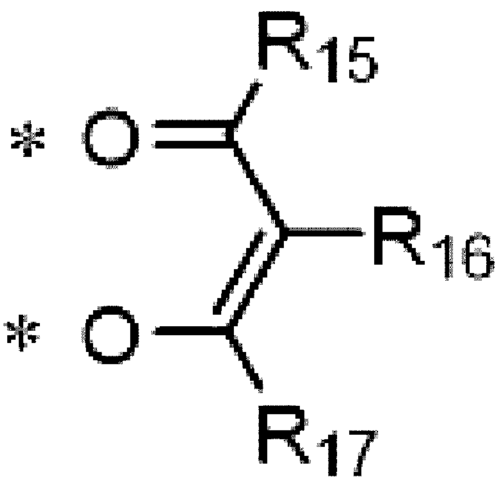

[1-3]

[Chem. 20]

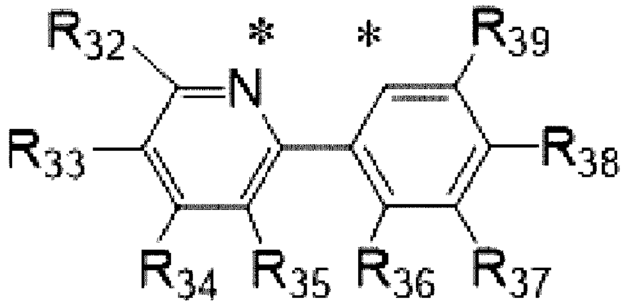

[1-4]

(in the general formula [1-2], $R_1$ is each independently selected from a fluorine atom, an alkyl group, a deuterium-substituted alkyl group, an alkoxy group, a silyl group, an aryl group, and a heterocyclic group, $R_2$ to $R_{14}$ and $R_{18}$ to $R_{21}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_1$ to $R_4$ may form a ring, in the general formula [1-3], $R_{15}$ to $R_{17}$ are each independently selected from a hydrogen atom, a deuterium atom, a substituted or unsubstituted alkyl group, an alkoxy group, a substituted amino group, a substituted or unsubstituted aryl group, and a substituted or unsubstituted heterocyclic group, in the general formula [1-4], $R_{32}$ to $R_{39}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_{32}$ to $R_{39}$ may form a ring))

**13.** An organometallic complex represented by the following general formula [3].
[Chem. 21]

IrLLL" [3]

(in the general formula [3], Ir denotes iridium, L, L', and L" denote different bidentate ligands, the partial structure Ir(L) is a partial structure represented by the following general formula [3-2], L' denotes a bidentate ligand represented by the following general formula [1-3], and L" denotes a bidentate ligand represented by the following general formula [1-4],

[Chem. 22]

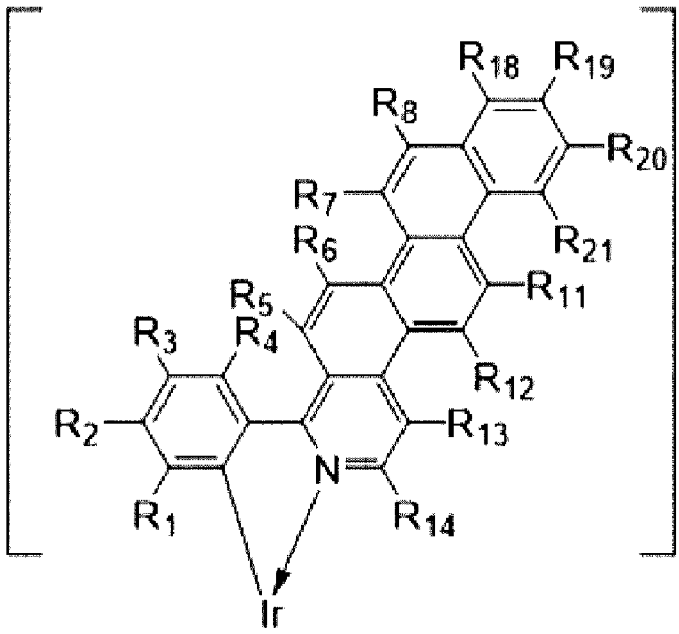

[3-2]

[Chem. 23]

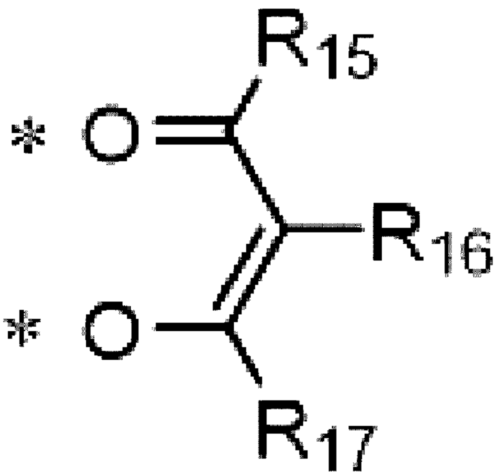

[1-3]

[Chem. 24]

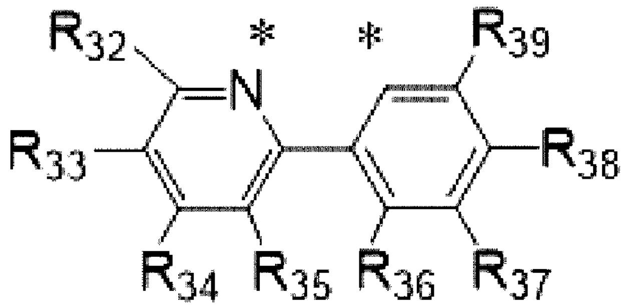

[1-4]

(in the general formula [3-2], $R_1$ is each independently selected from a fluorine atom, an alkyl group, a deuterium-substituted alkyl group, an alkoxy group, a silyl group, an aryl group, and a heterocyclic group, $R_2$ to $R_{14}$ and $R_{18}$ to $R_{21}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_1$ to $R_4$ may form a ring, in the general formula [1-3], $R_{15}$ to $R_{17}$ are each independently selected from a hydrogen atom, a deuterium atom, a substituted or unsubstituted alkyl group, a deuterium-substituted alkyl group, an alkoxy group, a substituted amino group, a substituted or unsubstituted aryl group, and a substituted or unsubstituted heterocyclic group,

in the general formula [1-4J, $R_{32}$ to $R_{39}$ are each independently selected from a hydrogen atom, a deuterium atom, a fluorine atom, a substituted or unsubstituted alkyl group, a deuterium-substituted alkyl group, an alkoxy group, a silyl group, a substituted amino group, a substituted or unsubstituted aryl group, and a substituted or unsubstituted heterocyclic group, and adjacent $R_{32}$ to $R_{39}$ may form a ring))

**14.** An organic light-emitting element comprising: a positive electrode; a negative electrode; and a light-emitting layer between the positive electrode and the negative electrode, wherein
the light-emitting layer contains the organometallic complex according to any one of Claims 10 to 13.

**15.** The organic light-emitting element according to any one of Claims 1 to 9 and 14, wherein the organic light-emitting element emits red light.

**16.** The organic light-emitting element according to any one of Claims 1 to 9 and 14, wherein

the light-emitting layer is a first light-emitting layer,
a second light-emitting layer different from the first light-emitting layer is further provided between the first light-emitting layer and the positive electrode or between the first light-emitting layer and the negative electrode, and the second light-emitting layer emits light of a different color from light emitted by the first light-emitting layer.

**17.** The organic light-emitting element according to Claim 16, wherein the organic light-emitting element emits white light.

**18.** A display apparatus comprising

a plurality of pixels,
wherein at least one of the plurality of pixels includes the organic light-emitting element according to any one of Claims 1 to 9 and 14 to 17 and an active element coupled to the organic light-emitting element.

**19.** The display apparatus according to Claim 18, further comprising a color filter.

**20.** A photoelectric conversion apparatus comprising:

an optical unit including a plurality of lenses; an imaging element configured to receive light passing through the optical unit; and a display unit configured to display an image taken by the imaging element,
wherein the display unit includes the organic light-emitting element according to any one of Claims 1 to 9 and 14 to 17.

**21.** Electronic equipment comprising:

a housing; a communication unit configured to communicate with the outside; and a display unit,
wherein the display unit includes the organic light-emitting element according to any one of Claims 1 to 9 and 14 to 17.

**22.** A lighting apparatus comprising:

a light source; and a light-diffusing unit or an optical filter,
wherein the light source includes the organic light-emitting element according to any one of Claims 1 to 9 and 14 to 17.

**23.** A lighting apparatus comprising: a light source including the organic light-emitting element according to any one of Claims 1 to 9 and 14 to 17; and a light-diffusing unit or an optical filter configured to transmit light emitted by the

light source.

**24.** The lighting apparatus according to Claim 23, further comprising a color filter.

**25.** A moving body comprising:

a body; and a lamp provided on the body,
wherein the lamp includes the organic light-emitting element according to any one of Claims 1 to 9 and 14 to 17.

**26.** An exposure light source for an electrophotographic image-forming apparatus, comprising the organic light-emitting element according to any one of Claims 1 to 9 and 14 to 17.

# FIG. 1

| | HALF-LIFE [h] | MOLECULAR STRUCTURE | STATE OF INTERACTION |
|---|---|---|---|
| COMPARATIVE EXAMPLE 2 | 300 | 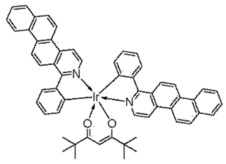 KK-28 (COMPOUND 1-a) 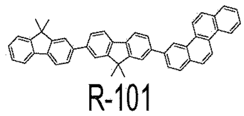 R-101 | 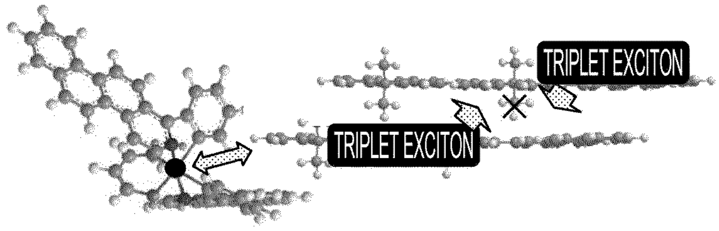  |
| COMPARATIVE EXAMPLE 3 | 300 | 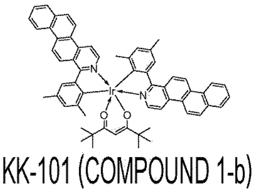 KK-101 (COMPOUND 1-b) 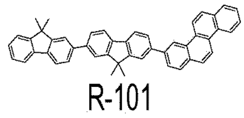 R-101 | 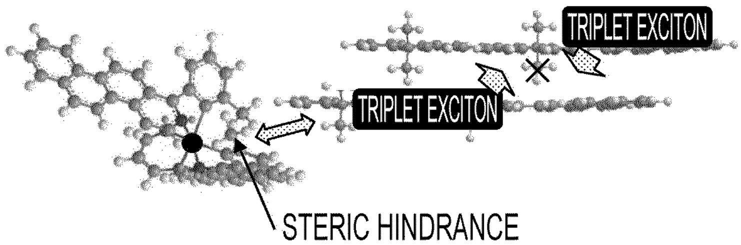  |
| COMPARATIVE EXAMPLE 4 | 700 | 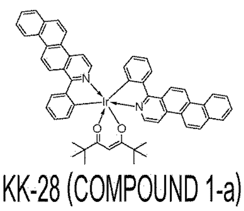 KK-28 (COMPOUND 1-a) 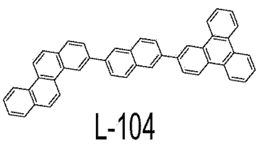 L-104 | 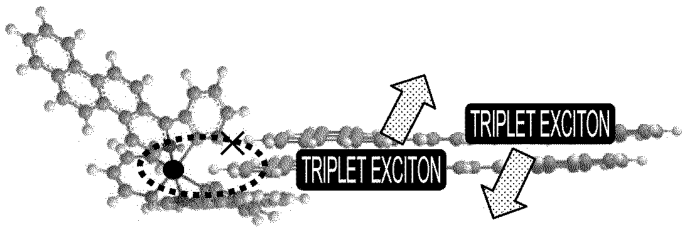  |
| EXEMPLARY EMBODIMENT 2 | 910 | 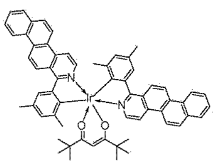 KK-101 (COMPOUND 1-b) 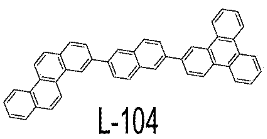 L-104 | 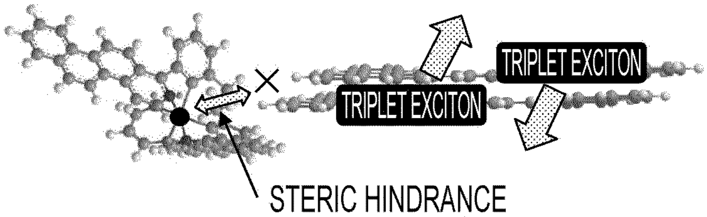  |

FIG. 2A

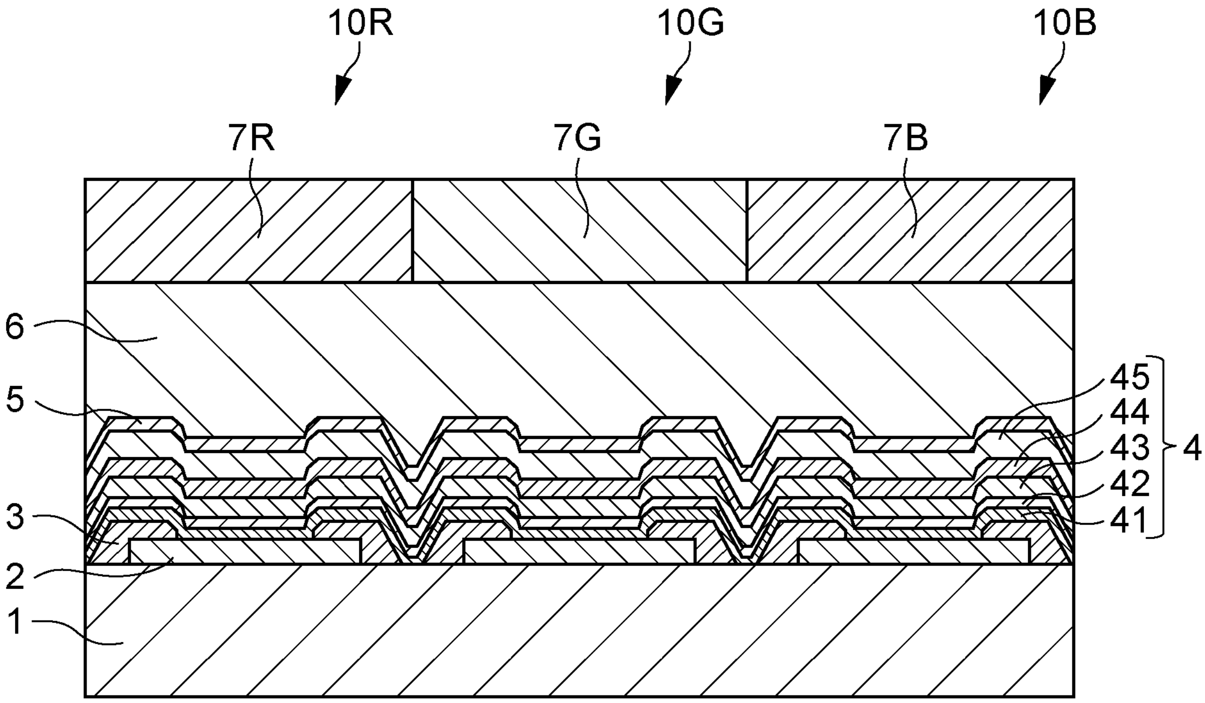
10R
10G
10B
7R
7G
7B
6
5
3
2
1
45
44
43
42
41
4

FIG. 2B

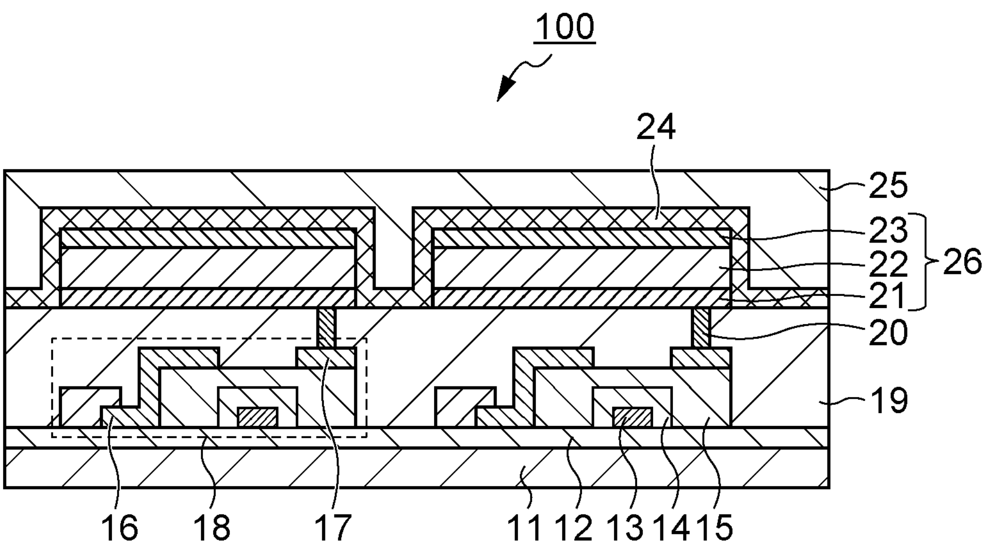
100
24
25
23
22
21
26
20
19
16
18
17
11
12
13
14
15

FIG. 3

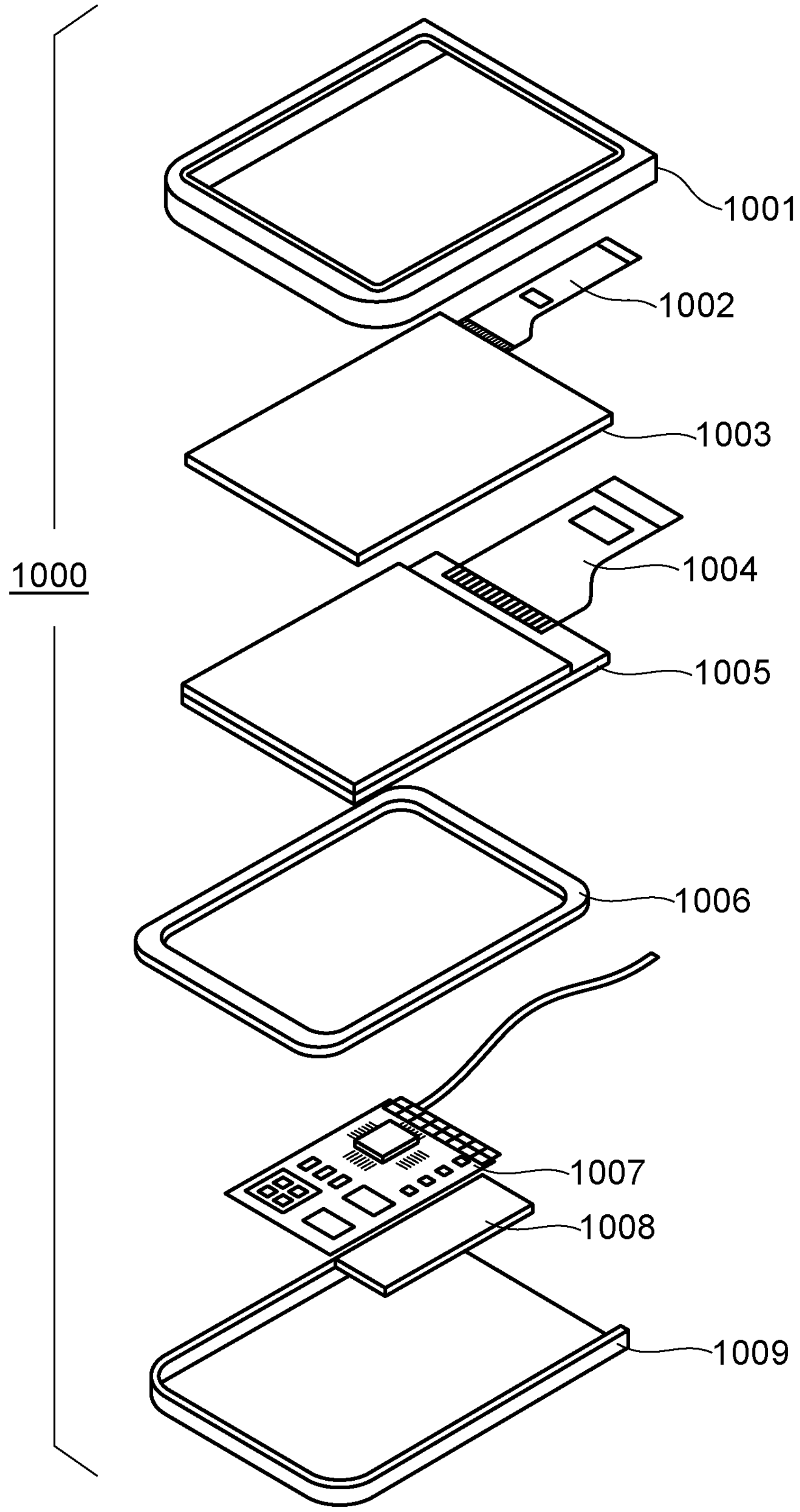

FIG. 4A

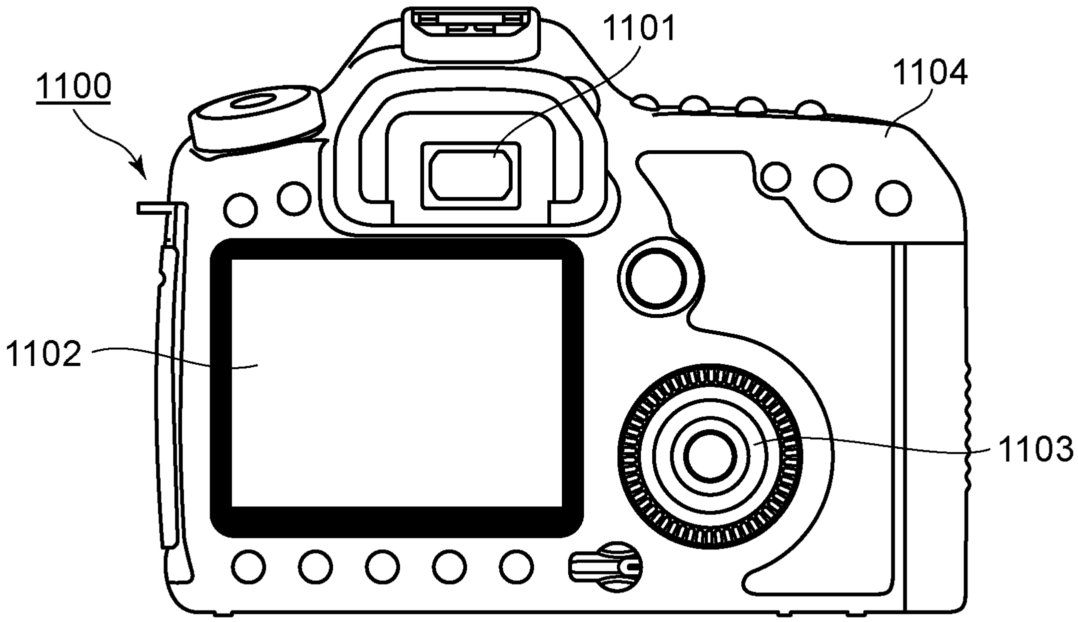


FIG. 4B

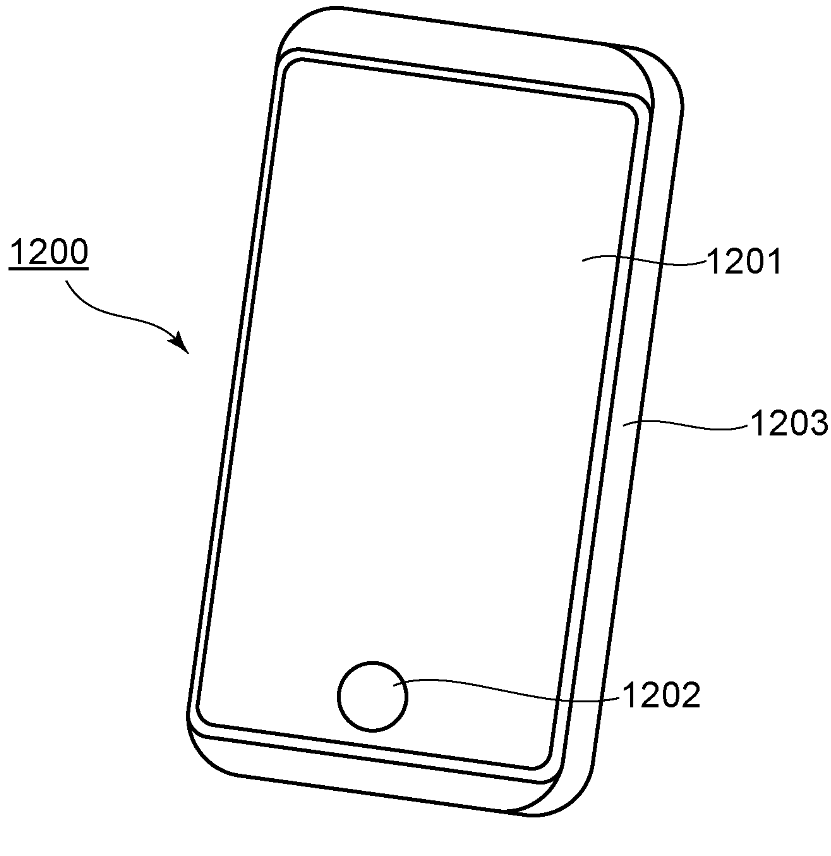

FIG. 5A

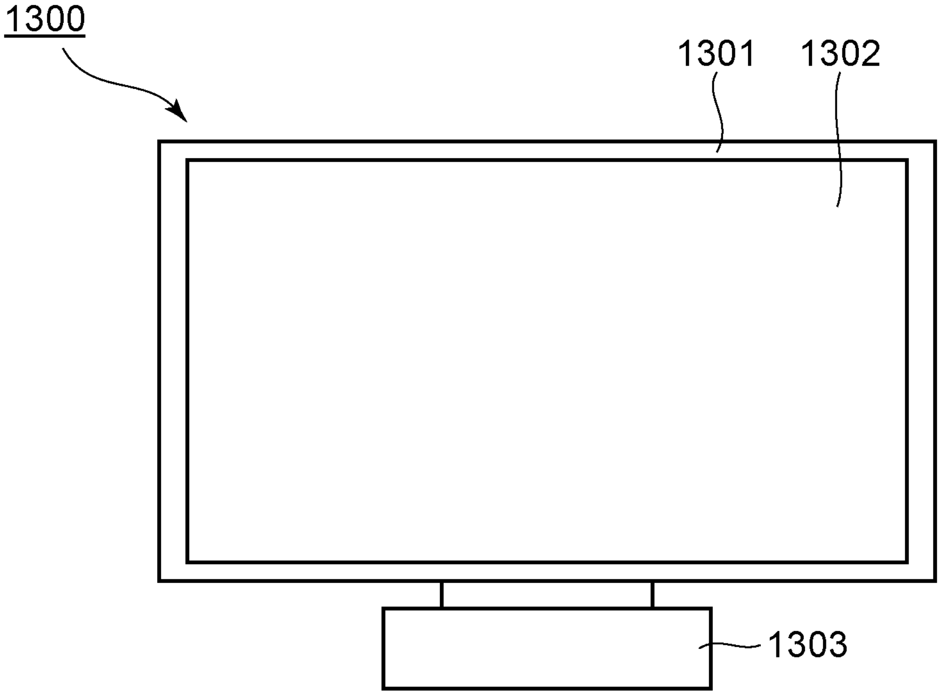


FIG. 5B

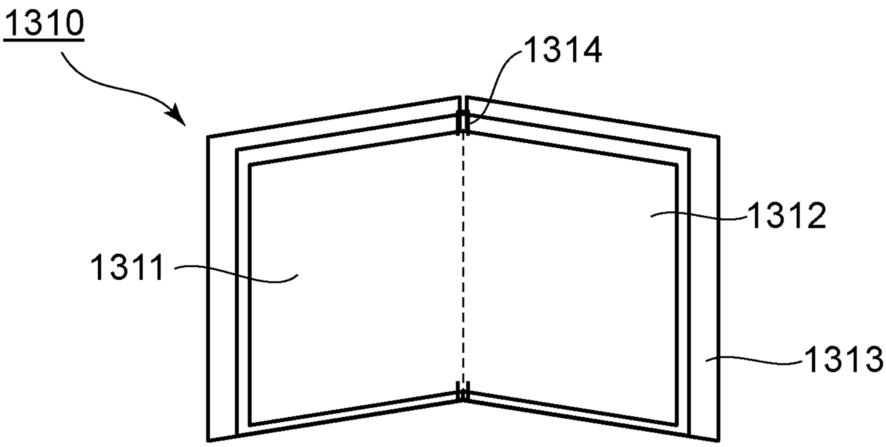

FIG. 6A

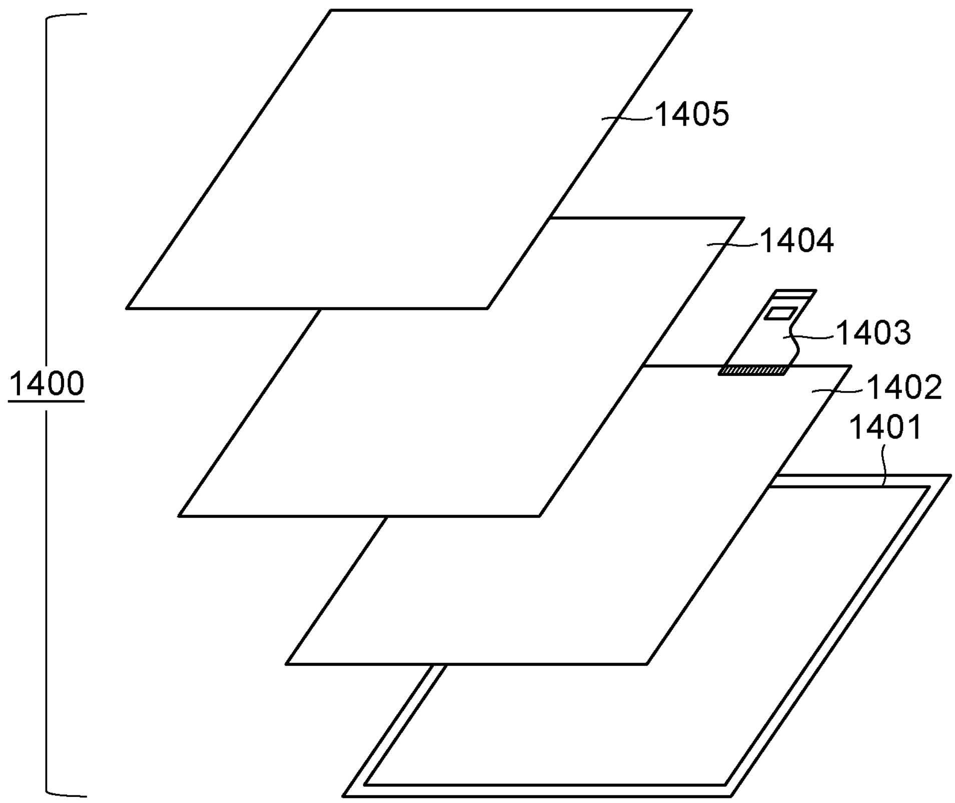


FIG. 6B

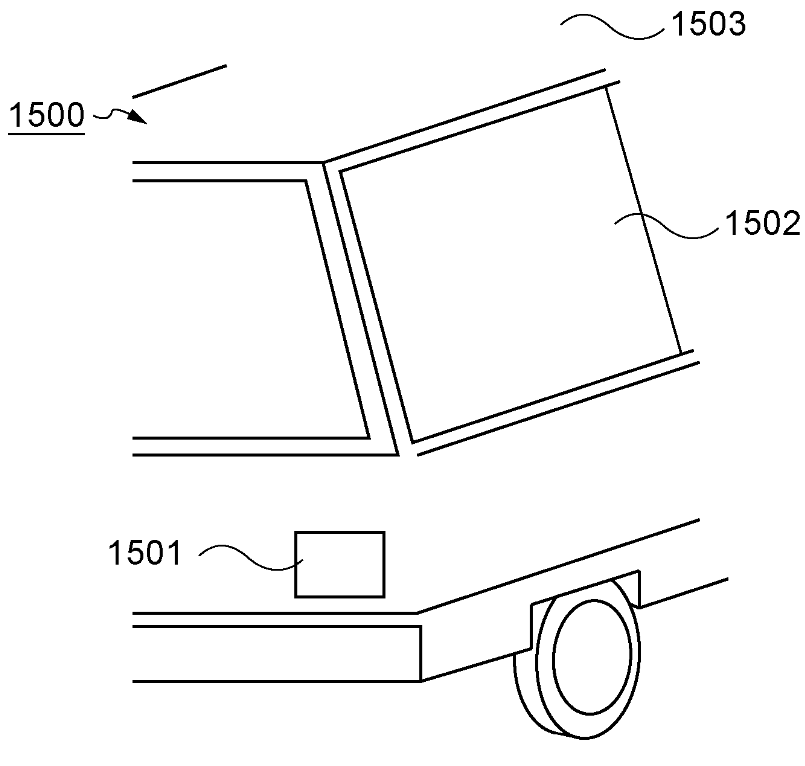

FIG. 7A

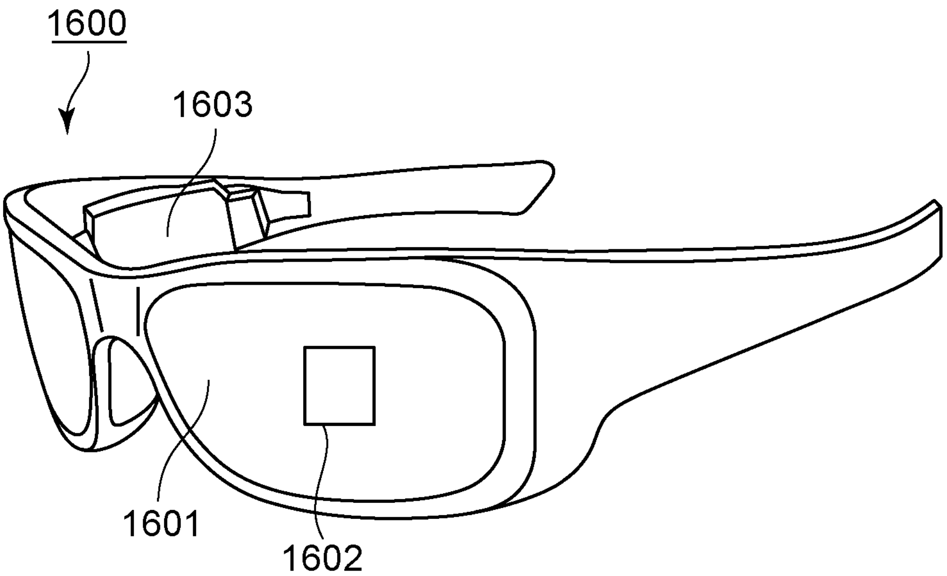


FIG. 7B

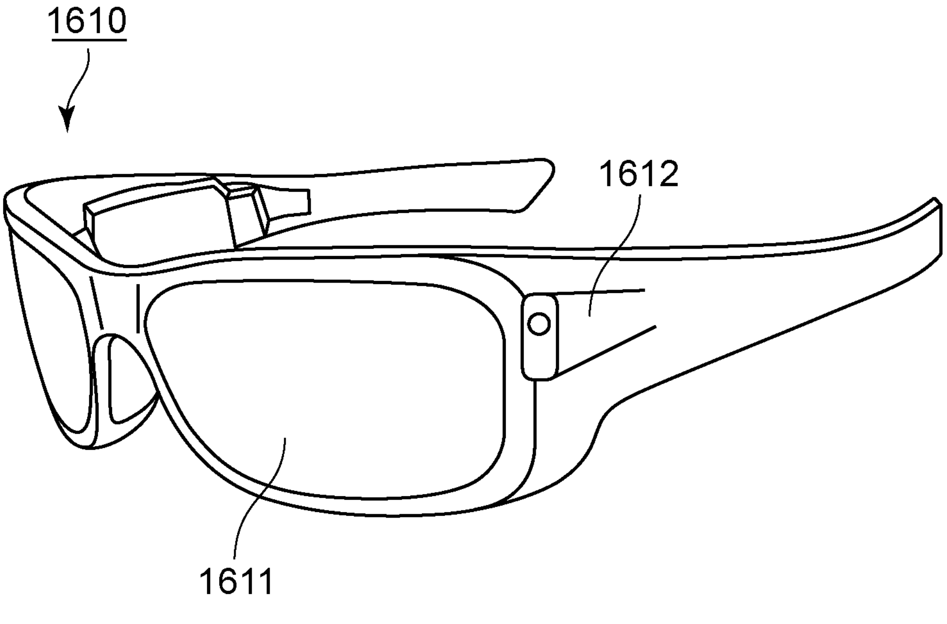

FIG. 8

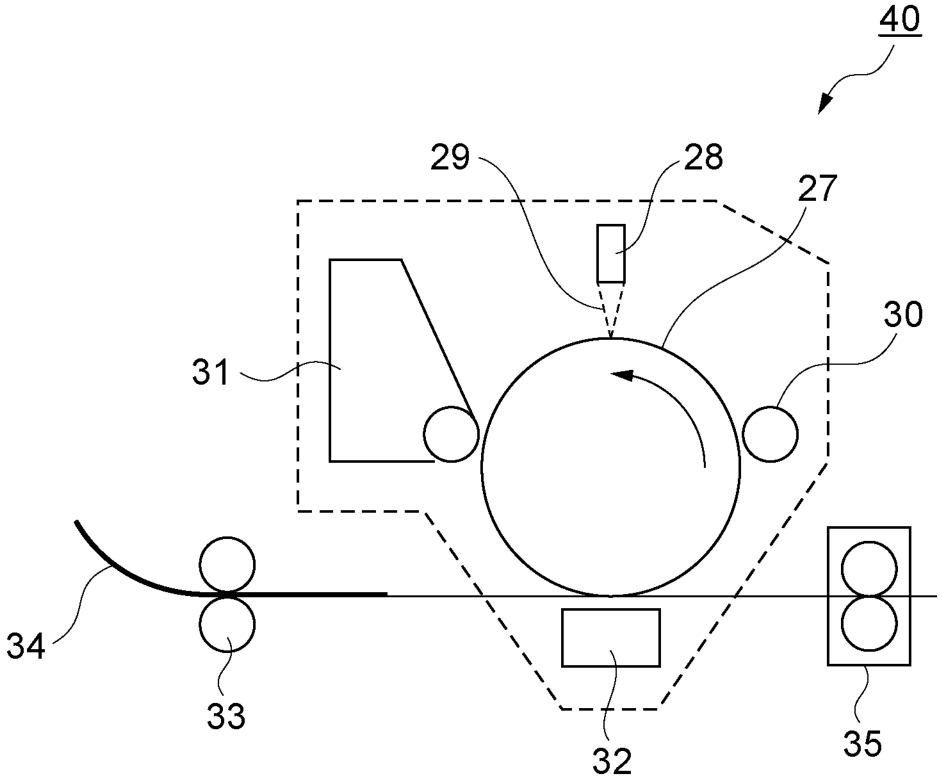

FIG. 9

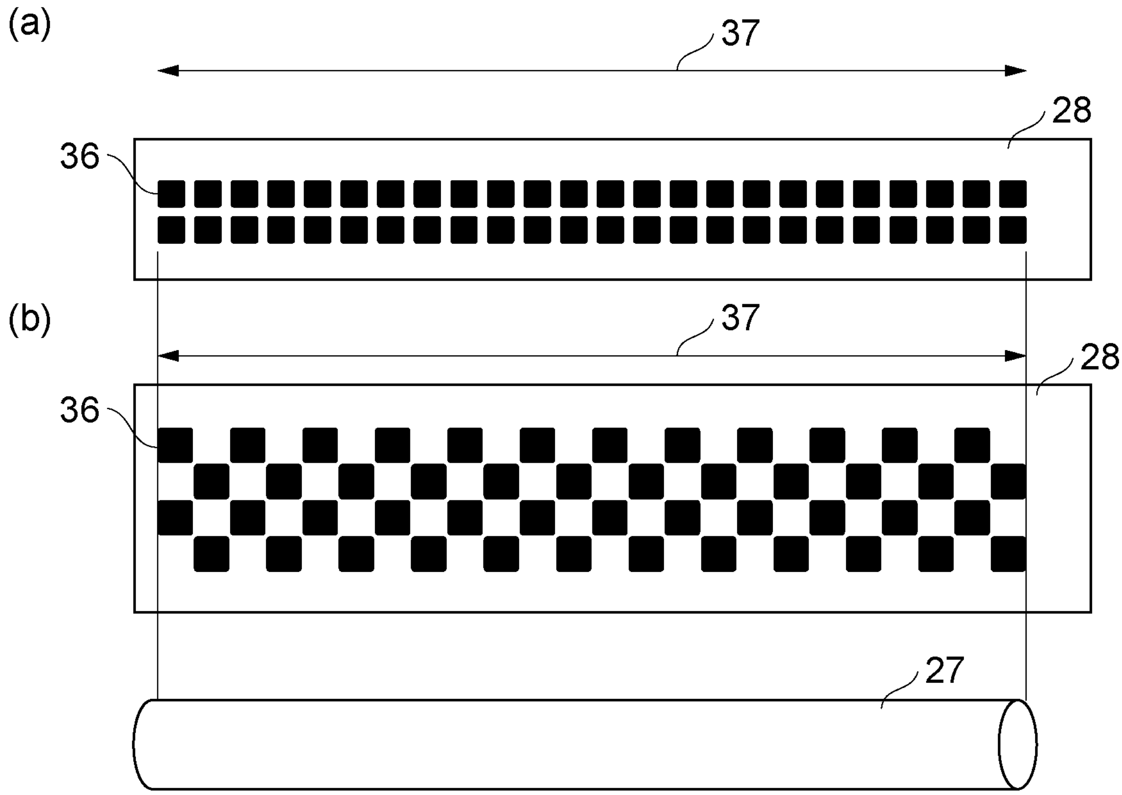

**INTERNATIONAL SEARCH REPORT**

International application No. **PCT/JP2022/020561**

**A. CLASSIFICATION OF SUBJECT MATTER**

***H01L 51/50***(2006.01)i; ***C07D 213/16***(2006.01)i; ***C07D 221/10***(2006.01)i; ***C07D 221/18***(2006.01)i; ***C09K 11/06***(2006.01)i; ***G02B 5/20***(2006.01)i; ***G02B 5/22***(2006.01)i; ***G09F 9/30***(2006.01)i; ***H01L 27/32***(2006.01)i; ***H05B 33/02***(2006.01)i; ***H05B 33/12***(2006.01)i

FI: H05B33/14 B; H05B33/12 C; H01L27/32; H05B33/12 E; H05B33/02; G02B5/20 101; G02B5/22; C09K11/06 660; C09K11/06 690; C07D221/18; C07D221/10; C07D213/16; G09F9/30 365; G09F9/30 349A

According to International Patent Classification (IPC) or to both national classification and IPC

**B. FIELDS SEARCHED**

Minimum documentation searched (classification system followed by classification symbols)

H01L51/50; C07D213/16; C07D221/10; C07D221/18; C09K11/06; G02B5/20; G02B5/22; G09F9/30; H01L27/32; H05B33/02; H05B33/12

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| A | JP 2014-154615 A (CANON INC) 25 August 2014 (2014-08-25) paragraphs [0011]-[0013], [0112], [0127], [0129], [0132], [0155]-[0167], [0199]-[0218], [0342] | 1-26 |
| A | WO 2018/061446 A1 (NIPPON STEEL & SUMIKIN CHEMICAL CO., LTD.) 05 April 2018 (2018-04-05) paragraphs [0009]-[0011], [0026]-[0029], [0033]-[0035], [0054]-[0055] | 1-26 |
| A | JP 2021-40142 A (NIPPON STEEL CHEMICAL & MAT CO LTD) 11 March 2021 (2021-03-11) paragraphs [0010]-[0011], [0034]-[0038], [0053]-[0054] | 1-26 |
| A | JP 2017-155040 A (SEMICONDUCTOR ENERGY LAB CO LTD) 07 September 2017 (2017-09-07) paragraphs [0016]-[0033], [0075]-[0092], [0113] | 1-26 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 June 2022** | **12 July 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/020561**

| Patent document cited in search report | Publication date (day/month/year) | Patent family member(s) | Publication date (day/month/year) |
|---|---|---|---|
| JP 2014-154615 A | 25 August 2014 | US 2015/0372244 A1<br>paragraphs [0046]-[0048], [0121], [0140], [0159], [0456]<br>WO 2014/123238 A1<br>EP 2954571 A1 | |
| WO 2018/061446 A1 | 05 April 2018 | US 2021/0083195 A1<br>paragraphs [0021]-[0022], [0044], [0050], [0072]<br>EP 3522246 A1<br>CN 109791997 A<br>KR 10-2019-0055122 A<br>TW 201829729 A | |
| JP 2021-40142 A | 11 March 2021 | US 2017/0263869 A1<br>paragraphs [0017]-[0018], [0046], [0067]<br>WO 2016/042997 A1<br>EP 3196954 A1<br>TW 201614896 A<br>KR 10-2017-0059985 A<br>CN 107078221 A | |
| JP 2017-155040 A | 07 September 2017 | US 2017/0250346 A1<br>paragraphs [0017]-[0029], [0130], [0149]<br>CN 107129459 A<br>KR 10-2017-0101128 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014141425 A
- JP 2014154615 A
- JP 2014154614 A
- JP 2021086666 A